(19) Europäisches Patentamt / European Patent Office / Office européen des brevets

(11) **EP 4 564 685 A1**

(12) **EUROPEAN PATENT APPLICATION**
published in accordance with Art. 153(4) EPC

(43) Date of publication:
**04.06.2025 Bulletin 2025/23**

(21) Application number: **22955414.2**

(22) Date of filing: **19.08.2022**

(51) International Patent Classification (IPC):
**H03M 13/11** (2006.01)

(52) Cooperative Patent Classification (CPC):
**H03M 13/11**

(86) International application number:
**PCT/CN2022/113749**

(87) International publication number:
**WO 2024/036634 (22.02.2024 Gazette 2024/08)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Huawei Technologies Co., Ltd.
Shenzhen, Guangdong 518129 (CN)**

(72) Inventors:
 • **LIN, Wei
  Shenzhen, Guangdong 518129 (CN)**
 • **LI, Jiahui
  Shenzhen, Guangdong 518129 (CN)**
 • **MA, Mengyao
  Shenzhen, Guangdong 518129 (CN)**
 • **TANG, Zihan
  Shenzhen, Guangdong 518129 (CN)**
 • **GU, Jiaqi
  Shenzhen, Guangdong 518129 (CN)**
 • **DU, Yinggang
  Shenzhen, Guangdong 518129 (CN)**

(74) Representative: **Thun, Clemens
  Mitscherlich PartmbB
  Patent- und Rechtsanwälte
  Karlstraße 7
  80333 München (DE)**

(54) **ENCODING METHOD AND APPARATUS, AND DECODING METHOD AND APPARATUS**

(57)    An encoding method, a decoding method, and an apparatus are provided. The method includes: A transmitter obtains a first bit sequence, and then performs LDPC encoding on the first bit sequence based on a check matrix, to obtain a second bit sequence. Correspondingly, a receiver receives the second bit sequence, and then performs LDPC decoding on the second bit sequence based on the check matrix, to obtain K information bits. The first bit sequence includes the K information bits, the second bit sequence includes M check bits, and both K and M are positive integers. The check matrix is obtained based on a first base matrix, the first base matrix corresponds to a second base matrix, the second base matrix includes the following elements: 0, 1, and 2, an element 1 in a $2^{nd}$ column of a check part in the second base matrix and an element 2 in a $1^{st}$ column of the check part are located in a same row, and a quantity of elements 1 in the $2^{nd}$ column is less than or equal to a quantity of elements 2 in the $1^{st}$ column. A new LDPC code is introduced into a scenario with a biased source, so that decoding performance can be effectively improved.

FIG. 5

EP 4 564 685 A1

## Description

### TECHNICAL FIELD

This application relates to the field of communication technologies, and in particular, to an encoding method, a decoding method, and an apparatus.

### BACKGROUND

With development of information technologies and progress of society, people have increasing requirements for information and put forward higher requirements for enjoying comprehensive services such as voice, data, image, and video services, and different types of multimedia services anytime and anywhere. Therefore, multimedia communication has become a focus of people's attention. A coding and transmission technology for original data such as a wireless video also becomes a research focus in an existing multimedia communication field. Coding is mainly classified into source coding and channel coding. A main indicator of the source coding is coding efficiency. A main objective of the channel coding is to improve reliability of information transmission.

Communication systems such as a cellular network communication system or a Wi-Fi communication system may use a separate source-channel coding (separate source-channel coding, SSCC) scheme. In this scheme, the source coding is usually completed at an application layer, and the channel coding is usually completed at a physical layer. Conventional source coding (for example, compression of sources such as images, videos, voices, and texts) does not have an error tolerance capability. Therefore, through source-channel coding, channel coding may be performed at the physical layer in combination with a retransmission mechanism or the like, to enable a receiver to implement error-free recovery of bits transmitted at the physical layer. To further improve transmission performance, the communication system may alternatively use a joint source-channel coding (joint source-channel coding, JSCC) scheme. This scheme can implement both source compression and channel protection. For example, the JSCC scheme may be implemented based on a low-density parity-check (low-density parity-check, LDPC) code.

However, performance of the JSCC scheme can be further improved.

### SUMMARY

Embodiments of this application provide an encoding method, a decoding method, and an apparatus, to effectively improve decoding performance.

According to a first aspect, an embodiment of this application provides an encoding method. The method includes: obtaining a first bit sequence, where the first bit sequence includes K information bits, and K is a positive integer; performing LDPC encoding on the first bit sequence based on a check matrix, to obtain a second bit sequence, where the check matrix is obtained based on a first base matrix, the first base matrix corresponds to a second base matrix, the second base matrix includes the following elements: 0, 1, and 2, an element 1 in a 2nd column of a check part in the second base matrix and an element 2 in a 1st column of the check part are located in a same row, and a quantity of elements 1 in the 2nd column is less than or equal to a quantity of elements 2 in the 1st column, and the second bit sequence includes M check bits, and M is a positive integer; and sending the second bit sequence.

According to a second aspect, an embodiment of this application provides a decoding method. The method includes: obtaining a second bit sequence, where the second bit sequence includes M check bits; and performing LDPC decoding on the second bit sequence based on a check matrix, to obtain K information bits, where the check matrix is obtained based on a first base matrix, the first base matrix corresponds to a second base matrix, the second base matrix includes the following elements: 0, 1, and 2, an element 1 in a 2nd column of a check part in the second base matrix and an element 2 in a 1st column of the check part are located in a same row, and a quantity of elements 1 in the 2nd column is less than or equal to a quantity of elements 2 in the 1st column.

In this embodiment of this application, the element 2 in the 1st column of the check part in the second base matrix and the element 1 in the 2nd column are located in the same row, and the quantity of elements 1 in the 2nd column is less than or equal to the quantity of elements 2 in the 1st column. A combination of the two columns can effectively improve decoding performance and reduce a decoding threshold. LDPC encoding and LDPC decoding are performed by using the check matrix provided in this embodiment of this application, so that the decoding performance in a scenario with a biased source can be effectively improved.

With reference to the first aspect or the second aspect, in a possible implementation, a quantity of rows of the first base matrix is equal to n times a quantity of rows of the second base matrix, and n is an integer greater than or equal to 2.

In this embodiment of this application, the quantity of rows of the second base matrix is less than the quantity of rows of the first base matrix, and the second base matrix may cover more first base matrices. Optionally, two communication parties store the second base matrix, so that storage space can be effectively saved.

With reference to the first aspect or the second aspect, in a possible implementation, a quantity of columns of the first base matrix is equal to n times a quantity of columns of the second base matrix, and n is an integer greater than or equal to 2.

In this embodiment of this application, the quantity of columns of the second base matrix is less than the quantity of columns of the first base matrix, and the second base matrix may cover more first base matrices. Optionally, two communication parties store the second base matrix, so that storage space can be effectively saved.

With reference to the first aspect or the second aspect, in a possible implementation, that the first base matrix corresponds to a second base matrix includes: The element 1 in the second base matrix is expanded to an n*n identity matrix or an n*n antisymmetric square matrix, and the element 2 in the second base matrix is expanded to an n*n all-1 matrix.

In this embodiment of this application, based on a relationship between the second base matrix and the first base matrix, one second base matrix may correspond to a plurality of first base matrices, so that two communication parties can select an appropriate first base matrix with reference to a code length requirement or a code rate requirement, to optimize decoding performance.

With reference to the first aspect or the second aspect, in a possible implementation, a sparsity of the first bit sequence is related to an encoding code rate. For example, a smaller value of the sparsity of the first bit sequence (indicating a sparser first bit sequence) indicates a larger encoding code rate.

In this embodiment of this application, a smaller sparsity of the first bit sequence indicates a smaller quantity of check bits sent by a transmitter, so that the encoding code rate is increased. Therefore, fewer channel transmission resources are occupied, transmission efficiency is higher, and decoding performance of a receiver is further effectively ensured.

With reference to the first aspect or the second aspect, in a possible implementation, at least one of the following is determined based on the sparsity of the first bit sequence: the quantity of rows of the second base matrix, the quantity of columns of the second base matrix, and a quantity of columns of an information part in the check matrix.

With reference to the first aspect or the second aspect, in a possible implementation, the 1st column of the check part in the second base matrix is a punctured column.

In this embodiment of this application, because a transmitter may transmit only the check bits, or transmit the check bits and some information bits, decoding performance can be effectively improved by setting a state column in the check part.

With reference to the first aspect or the second aspect, in a possible implementation, the first n columns of the check part in the first base matrix are punctured columns.

With reference to the first aspect or the second aspect, in a possible implementation, the second base matrix satisfies at least one of the following: the 1st column of the check part in the second base matrix is any one of the following: $[1\ 2\ 1\ 2]^T$, $[2\ 1\ 2\ 1]^T$, $[1\ 1\ 1\ 2\ 2]^T$, and $[2\ 1\ 1\ 1\ 2]^T$; and a column weight of the 2nd column of the check part in the second base matrix is 1.

With reference to the first aspect or the second aspect, in a possible implementation, the sparsity of the first bit sequence is less than or equal to a first threshold.

With reference to the first aspect or the second aspect, in a possible implementation, the second base matrix includes:

$$
\begin{matrix}
1 & 0 & x & x & x & x & x \\
1 & 0 & x & x & x & x & x \\
1 & 0 & x & x & x & x & x \\
2 & 0 & x & x & x & x & x \\
2 & 1 & 0 & 0 & 0 & 0 & 0
\end{matrix}
$$

where x represents any one of the following: 0, 1, and 2, the first five columns of the second base matrix are the check part in the second base matrix, and a 6th column and a 7th column of the second base matrix are an information part in the second base matrix.

Alternatively, the second base matrix includes:

$$\begin{matrix} x & x & 1 & 0 & x & x & x \\ x & x & 1 & 0 & x & x & x \\ x & x & 1 & 0 & x & x & x \\ x & x & 2 & 0 & x & x & x \\ 0 & 0 & 2 & 1 & 0 & 0 & 0 \end{matrix}$$

where x represents any one of the following: 0, 1, and 2, the first two columns of the second base matrix are an information part in the second base matrix, and a 3$^{rd}$ column to a 7$^{th}$ column of the second base matrix are the check part in the second base matrix.

With reference to the first aspect or the second aspect, in a possible implementation, the second base matrix includes:

$$\begin{matrix} 1 & 0 & 1 & 1 & 0 & 1 & 0 \\ 1 & 0 & 0 & 0 & 0 & 2 & 0 \\ 1 & 0 & 2 & 1 & 2 & 0 & 1 \\ 2 & 0 & 0 & 0 & 1 & 1 & 1 \\ 2 & 1 & 0 & 0 & 0 & 0 & 0. \end{matrix}$$

With reference to the first aspect or the second aspect, in a possible implementation, the second base matrix includes:

$$\begin{matrix} 1 & 0 & x & x & x & x & x \\ 2 & 0 & x & x & x & x & x \\ 1 & 0 & x & x & x & x & x \\ 2 & 1 & x & x & x & x & x \end{matrix}$$

where x represents any one of the following: 0, 1, and 2, the first four columns of the second base matrix are the check part in the second base matrix, and a 5$^{th}$ column to a 7$^{th}$ column of the second base matrix are an information part in the second base matrix.

Alternatively, the second base matrix includes:

$$\begin{matrix} x & x & x & 1 & 0 & x & x \\ x & x & x & 2 & 0 & x & x \\ x & x & x & 1 & 0 & x & x \\ x & x & x & 2 & 1 & x & x \end{matrix}$$

where x represents any one of the following: 0, 1, and 2, the first three columns of the second base matrix are an information part in the second base matrix, and a 4$^{th}$ column to a 7$^{th}$ column of the second base matrix are the check part in the second base matrix.

With reference to the first aspect or the second aspect, in a possible implementation, the second base matrix includes:

$$\begin{matrix} 1 & 0 & 0 & 0 & 2 & 2 & 1 \\ 2 & 0 & 1 & 2 & 0 & 0 & 0 \\ 1 & 0 & 1 & 1 & 2 & 0 & 1 \\ 2 & 1 & 0 & 1 & 0 & 0 & 0. \end{matrix}$$

With reference to the first aspect or the second aspect, in a possible implementation, the second base matrix includes:

$$
\begin{array}{ccccccccc}
1 & 0 & x & x & x & x & x & x & x \\
2 & 0 & x & x & x & x & x & x & x \\
1 & 0 & x & x & x & x & x & x & x \\
2 & 1 & x & x & x & x & x & x & x
\end{array}
$$

where x represents any one of the following: 0, 1, and 2, the first four columns of the second base matrix are the check part in the second base matrix, and a 5th column to a 9th column of the second base matrix are an information part in the second base matrix.

Alternatively, the second base matrix includes:

$$
\begin{array}{ccccccccc}
x & x & x & x & x & 1 & 0 & x & x \\
x & x & x & x & x & 2 & 0 & x & x \\
x & x & x & x & x & 1 & 0 & x & x \\
x & x & x & x & x & 2 & 1 & x & x
\end{array}
$$

where x represents any one of the following: 0, 1, and 2, the first five columns of the second base matrix are an information part in the second base matrix, and a 6th column to a 9th column of the second base matrix are the check part in the second base matrix.

With reference to the first aspect or the second aspect, in a possible implementation, the second base matrix includes:

$$
\begin{array}{ccccccccc}
1 & 0 & 1 & 0 & 2 & 2 & 0 & 1 & 0 \\
2 & 0 & 0 & 1 & 1 & 0 & 1 & 0 & 2 \\
1 & 0 & 2 & 1 & 0 & 1 & 1 & 1 & 0 \\
2 & 1 & 0 & 1 & 0 & 0 & 0 & 1 & 0.
\end{array}
$$

Alternatively, the second base matrix includes:

$$
\begin{array}{ccccccccc}
1 & 0 & 0 & 0 & 0 & 2 & 1 & 1 & 2 \\
2 & 0 & 2 & 1 & 2 & 1 & 1 & 1 & 1 \\
1 & 0 & 1 & 1 & 0 & 2 & 0 & 1 & 2 \\
2 & 1 & 0 & 0 & 0 & 0 & 0 & 0 & 0.
\end{array}
$$

With reference to the first aspect or the second aspect, in a possible implementation, the check matrix includes:

$$
\begin{array}{cccccccccccccccccc}
-1 & 21 & -1 & -1 & -1 & 27 & -1 & -1 & 39 & 15 & 26 & 30 & -1 & -1 & 6 & -1 & -1 & -1 \\
9 & -1 & -1 & -1 & 19 & -1 & -1 & -1 & 32 & 27 & 24 & 40 & -1 & -1 & -1 & 1 & -1 & -1 \\
35 & 38 & -1 & -1 & -1 & -1 & 39 & -1 & -1 & 14 & -1 & -1 & -1 & 16 & -1 & -1 & 20 & 6 \\
39 & 31 & -1 & -1 & -1 & -1 & -1 & 19 & 6 & -1 & -1 & -1 & 18 & -1 & -1 & -1 & 25 & 3 \\
13 & -1 & -1 & -1 & 31 & 26 & 35 & -1 & -1 & -1 & 35 & -1 & 2 & -1 & 23 & -1 & -1 & -1 \\
-1 & 12 & -1 & -1 & 39 & 37 & -1 & 10 & -1 & -1 & -1 & 39 & -1 & 33 & -1 & 27 & -1 & -1 \\
16 & 17 & 29 & -1 & -1 & -1 & -1 & 4 & -1 & -1 & -1 & -1 & -1 & -1 & 3 & -1 & -1 & -1 \\
10 & 38 & -1 & 21 & -1 & -1 & 38 & -1 & -1 & -1 & -1 & -1 & -1 & -1 & -1 & 18 & -1 & -1.
\end{array}
$$

Alternatively, the check matrix includes:

$$
\begin{array}{cccccccccccccccccc}
-1 & 11 & -1 & -1 & -1 & -1 & -1 & -1 & -1 & -1 & 37 & 37 & -1 & 18 & 0 & -1 & 38 & 15 \\
39 & -1 & -1 & -1 & -1 & -1 & -1 & -1 & -1 & -1 & 1 & 0 & 33 & -1 & -1 & 14 & 4 & 9 \\
11 & 7 & -1 & -1 & 18 & 31 & 3 & -1 & 30 & 13 & 25 & -1 & 30 & -1 & 0 & -1 & -1 & 10 \\
1 & 31 & -1 & -1 & 26 & 22 & -1 & 34 & 5 & 11 & -1 & 13 & -1 & 27 & -1 & 16 & 12 & -1 \\
-1 & 11 & -1 & -1 & -1 & 41 & 40 & -1 & -1 & -1 & 21 & 40 & -1 & -1 & 22 & -1 & 12 & 0 \\
15 & -1 & -1 & -1 & 10 & -1 & -1 & 4 & -1 & -1 & 10 & 4 & -1 & -1 & -1 & 31 & 15 & 28 \\
31 & 29 & 15 & -1 & -1 & -1 & -1 & -1 & -1 & -1 & -1 & -1 & -1 & -1 & -1 & -1 & -1 & -1 \\
1 & 36 & -1 & 18 & -1 & -1 & -1 & -1 & -1 & -1 & -1 & -1 & -1 & -1 & -1 & -1 & -1 & -1 \\
\end{array}
$$

where -1 represents a Z*Z all-zero matrix, 0 represents a Z*Z identity matrix, a non-zero element represents a Z*Z circulant permutation matrix (circulant permutation matrix, CPM), Z represents a lifting factor used when the first base matrix is expanded to obtain the check matrix, and Z=42.

It may be understood that the check matrix shown above is a matrix with eight rows and 18 columns. Although the check matrix is shown by using eight rows and 18 columns as an example, during actual application, the check matrix may alternatively be expanded to a matrix with more rows and more columns.

With reference to the first aspect or the second aspect, in a possible implementation, when the sparsity of the first bit sequence is greater than the first threshold, the second base matrix is shown as follows:

$$
\begin{bmatrix} A & B \\ C & D \end{bmatrix}
$$

where A represents an information part in the second base matrix, B represents the check part in the second base matrix, C is a matrix determined based on the code rate and the sparsity of the first bit sequence, a $1^{st}$ column in D is a punctured column, and a remaining part other than the $1^{st}$ column in D is obtained based on the identity matrix.

With reference to the first aspect or the second aspect, in a possible implementation, the $1^{st}$ column in D is either of the following:

$[1\ 2\ 1\ 2\ ...]^T$ and $[1\ 1\ 1\ 1\ ...]^T$.

According to a third aspect, an embodiment of this application provides a communication apparatus, configured to perform the method according to any one of the first aspect or the possible implementations of the first aspect. The communication apparatus includes units that perform the method according to any one of the first aspect or the possible implementations of the first aspect. For example, the communication apparatus may include a processing unit and a transceiver unit.

According to a fourth aspect, an embodiment of this application provides a communication apparatus, configured to perform the method according to any one of the second aspect or the possible implementations of the second aspect. The communication apparatus includes units that perform the method according to any one of the second aspect or the possible implementations of the second aspect. For example, the communication apparatus may include a processing unit and a transceiver unit.

According to a fifth aspect, an embodiment of this application provides a communication apparatus. The communication apparatus includes a processor, configured to perform the method according to any one of the first aspect or the possible implementations of the first aspect. Alternatively, the processor is configured to execute a program stored in a memory. When the program is executed, the method according to any one of the first aspect or the possible implementations of the first aspect is performed.

In a possible implementation, the memory is located outside the communication apparatus.

In a possible implementation, the memory is located inside the communication apparatus.

In this embodiment of this application, the processor and the memory may alternatively be integrated into one component. In other words, the processor and the memory may alternatively be integrated together.

In a possible implementation, the communication apparatus further includes a transceiver. The transceiver is configured to receive a signal and/or send a signal.

According to a sixth aspect, an embodiment of this application provides a communication apparatus. The communication apparatus includes a processor, configured to perform the method according to any one of the second aspect or the possible implementations of the second aspect. Alternatively, the processor is configured to execute a program stored in a memory. When the program is executed, the method according to any one of the second aspect or the possible implementations of the second aspect is performed.

In a possible implementation, the memory is located outside the communication apparatus.

In a possible implementation, the memory is located inside the communication apparatus.

In this embodiment of this application, the processor and the memory may alternatively be integrated into one component. In other words, the processor and the memory may alternatively be integrated together.

In a possible implementation, the communication apparatus further includes a transceiver. The transceiver is configured to receive a signal and/or send a signal.

According to a seventh aspect, an embodiment of this application provides a chip. A communication apparatus includes a logic circuit and an interface. The logic circuit is coupled to the interface. The interface is configured to input a first bit sequence. The logic circuit is configured to perform LDPC encoding on the first bit sequence based on a check matrix, to obtain a second bit sequence. The interface is further configured to output the second bit sequence.

It may be understood that the communication apparatus shown in this embodiment of this application may be referred to as a chip, an encoder, an apparatus having an encoding function, or the like. This is not limited in embodiments of this application.

According to an eighth aspect, an embodiment of this application provides a chip. A communication apparatus includes a logic circuit and an interface. The logic circuit is coupled to the interface. The interface is configured to input a second bit sequence. The logic circuit is configured to perform LDPC decoding on the second bit sequence based on a check matrix.

It may be understood that the communication apparatus shown in this embodiment of this application may be referred to as a chip, a decoder, an apparatus having a decoding function, or the like. This is not limited in embodiments of this application.

According to a ninth aspect, an embodiment of this application provides a computer-readable storage medium. The computer-readable storage medium is configured to store a computer program. When the computer program is run on a computer, the method according to any one of the first aspect or the possible implementations of the first aspect is performed.

According to a tenth aspect, an embodiment of this application provides a computer-readable storage medium. The computer-readable storage medium is configured to store a computer program. When the computer program is run on a computer, the method according to any one of the second aspect or the possible implementations of the second aspect is performed.

According to an eleventh aspect, an embodiment of this application provides a computer program product. The computer program product includes a computer program or computer code (which may also be referred to as instructions). When the computer program or the computer code is run on a computer, the method according to any one of the first aspect or the possible implementations of the first aspect is performed.

According to a twelfth aspect, an embodiment of this application provides a computer program product. The computer program product includes a computer program or computer code (which may also be referred to as instructions). When the computer program or the computer code is run on a computer, the method according to any one of the second aspect or the possible implementations of the second aspect is performed.

According to a thirteenth aspect, an embodiment of this application provides a computer program. When the computer program is run on a computer, the method according to any one of the first aspect or the possible implementations of the first aspect is performed.

According to a fourteenth aspect, an embodiment of this application provides a computer program. When the computer program is run on a computer, the method according to any one of the second aspect or the possible implementations of the second aspect is performed.

According to a fifteenth aspect, an embodiment of this application provides a communication system. The communication system includes a transmitter and a receiver. The transmitter is configured to perform the method according to any one of the first aspect or the possible implementations of the first aspect, and the receiver is configured to perform the method according to any one of the second aspect or the possible implementations of the second aspect.

## BRIEF DESCRIPTION OF DRAWINGS

FIG. 1 is a diagram of an architecture of a communication system according to an embodiment of this application;
FIG. 2 is a diagram of an architecture of a communication system according to an embodiment of this application;
FIG. 3a is a diagram of principle analysis of an optimized JSCC extrinsic information transfer (extrinsic information transfer, EXIT) chart according to an embodiment of this application;
FIG. 3b is a diagram of principle analysis of an optimized JSCC-EXIT chart according to an embodiment of this application;
FIG. 4a is a schematic flowchart of differential evolution iteration according to an embodiment of this application;
FIG. 4b is a diagram of a location of a state node according to an embodiment of this application;
FIG. 4c is a diagram of determining a full rank of a check part according to an embodiment of this application;

FIG. 4d is a diagram of a protograph according to an embodiment of this application;

FIG. 4e is a diagram of a protograph according to an embodiment of this application;

FIG. 5 is a schematic flowchart of an encoding method and a decoding method according to an embodiment of this application;

FIG. 6a is a diagram of a base matrix group A according to an embodiment of this application;

FIG. 6b is a diagram of a base matrix group B according to an embodiment of this application;

FIG. 6c is a diagram of a check matrix according to an embodiment of this application;

FIG. 6d is a diagram of a check matrix according to an embodiment of this application;

FIG. 6e shows a similar expansion manner of a base matrix group A according to an embodiment of this application;

FIG. 6f shows a similar expansion manner of a base matrix group B according to an embodiment of this application;

FIG. 7a is a diagram of a base matrix group A according to an embodiment of this application;

FIG. 7b is a diagram of a base matrix group B according to an embodiment of this application;

FIG. 7c is a diagram of a check matrix according to an embodiment of this application;

FIG. 7d is a diagram of a check matrix according to an embodiment of this application;

FIG. 7e shows a similar expansion manner of a base matrix group A according to an embodiment of this application;

FIG. 7f shows a similar expansion manner of a base matrix group B according to an embodiment of this application;

FIG. 8a is a diagram of a base matrix group C according to an embodiment of this application;

FIG. 8b is a diagram of a check matrix according to an embodiment of this application;

FIG. 8c is a diagram of a check matrix according to an embodiment of this application;

FIG. 8d shows a similar expansion manner of a base matrix group C according to an embodiment of this application;

FIG. 9a is a diagram of simulation when a source sparsity is equal to 0.05 according to an embodiment of this application;

FIG. 9b is a diagram of simulation when a source sparsity is equal to 0.11 according to an embodiment of this application;

FIG. 9c is a diagram of simulation when a source sparsity is equal to 0.3 according to an embodiment of this application;

FIG. 10 is a diagram of a structure of a communication apparatus according to an embodiment of this application;

FIG. 11 is a diagram of a structure of a communication apparatus according to an embodiment of this application; and

FIG. 12 is a diagram of a structure of a communication apparatus according to an embodiment of this application.

## DESCRIPTION OF EMBODIMENTS

To make the objectives, technical solutions, and advantages of this application clearer, the following further describes this application with reference to the accompanying drawings.

Terms "first", "second", and the like in the specification, the claims, and the accompanying drawings of this application are merely used for distinguishing between different objects, and are not used for describing a specific order. In addition, terms such as "include" and "have" and any other variants thereof are intended to cover a non-exclusive inclusion. For example, processes, methods, systems, products, devices, or the like that include a series of steps or units are not limited to listed steps or units, but instead, optionally further include steps, units, or the like that are not listed, or optionally further include other steps or units inherent to these processes, methods, products, devices, or the like.

An "embodiment" mentioned in this specification means that a particular feature, structure, or characteristic described with reference to the embodiment may be included in at least one embodiment of this application. The phrase shown in various locations in the specification may not necessarily refer to a same embodiment, and is not an independent or optional embodiment exclusive from another embodiment. It may be understood explicitly and implicitly by a person skilled in the art that embodiments described in this specification may be combined with other embodiments.

In this application, "at least one (item)" means one or more, "a plurality of" means two or more, and "at least two (items)" means two or three or more. "And/or" is used for describing an association relationship between associated objects, and indicates that three relationships may exist. For example, "A and/or B" may represent three cases: Only A exists, only B exists, and both A and B exist, where A and B may be singular or plural. The character "/" generally indicates an "or" relationship between the associated objects. "At least one of the following" or a similar expression thereof means any combination of these items. For example, at least one of a, b, or c may indicate: a, b, c, "a and b", "a and c", "b and c", or "a and b and c".

The technical solutions provided in embodiments of this application may be applied to various communication systems, for example, an internet of things (internet of things, IoT) system, a narrowband internet of things (narrowband internet of things, NB-IoT) system, a long term evolution (long term evolution, LTE) system, a 5th generation (5th generation, 5G) communication system, a new radio (new radio, NR) system, and a new communication system that emerges in future communication development.

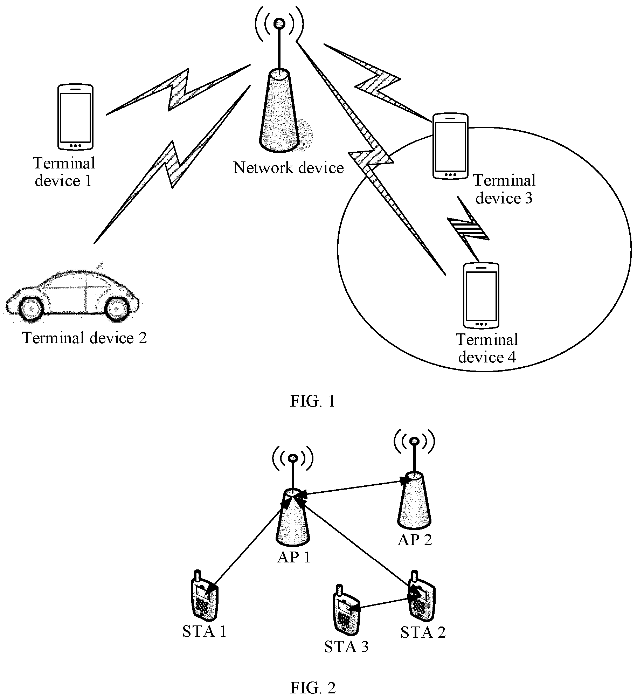

The technical solutions provided in embodiments of this application may also be applied to non-terrestrial network (non-terrestrial network, NTN) communication (which may also be referred to as non-terrestrial network communication), machine type communication (machine type communication, MTC), a long term evolution-machine (long term evolution-machine, LTE-M) technology, a device-to-device (device-to-device, D2D) network, a machine-to-machine (machine-to-machine, M2M) network, an internet of things (internet of things, IoT) network, an industrial internet, or another network. The IoT network may include, for example, an internet of vehicles. Communication modes in an internet of vehicles system are collectively referred to as vehicle-to-everything (vehicle-to-everything, V2X, where X can stand for anything). For example, the V2X may include vehicle-to-vehicle (vehicle-to-vehicle, V2V) communication, vehicle-to-infrastructure (vehicle-to-infrastructure, V2I) communication, vehicle-to-pedestrian (vehicle-to-pedestrian, V2P) communication, vehicle-to-network (vehicle-to-network, V2N) communication, or the like. For example, in FIG. 1 shown below, terminal devices may communicate with each other by using a D2D technology, an M2M technology, a V2X technology, or the like.

The technical solutions provided in embodiments of this application may also be applied to a wireless local area network (wireless local area network, WLAN) system, for example, Wi-Fi. For example, methods provided in embodiments of this application are applicable to the Institute of Electrical and Electronics Engineers (institute of electrical and electronics engineers, IEEE) 802.11 series protocols, such as the 802.11a/b/g protocol, the 802.11n protocol, the 802.11ac protocol, the 802.11 ax protocol, the 802.11be protocol, and a next generation protocol. Other applicable protocols are not listed one by one herein. For another example, the methods are also applicable to a wireless personal area network (wireless personal area network, WPAN) based on an ultra wideband (ultra wideband, UWB) technology, such as the 802.15.4a protocol, the 802.15.4z protocol, and the 802.15.4ab protocol in the IEEE 802.15 series protocols, and a future generation of UWB WPAN protocol. Other applicable protocols are not listed one by one herein. A person skilled in the art easily understands that, various aspects in embodiments of this application may be extended to other networks using various standards or protocols, for example, Bluetooth (Bluetooth), a high performance radio LAN (high performance radio LAN, HIPERLAN) (which is a wireless standard similar to the IEEE 802.11 standard, and is mainly used in Europe), a wide area network (WAN), or other networks known or developed in the future. Therefore, regardless of a coverage area and a wireless access protocol that are used, the technical solutions provided in embodiments of this application are applicable to any suitable wireless network.

In a possible implementation, FIG. 1 is a diagram of an architecture of a communication system according to an embodiment of this application. As shown in FIG. 1, the communication system may include at least one network device and at least one terminal device, for example, a terminal device 1 to a terminal device 4 in FIG. 1. For example, a terminal device 3 and the terminal device 4 shown in FIG. 1 may directly communicate with each other. For example, direct communication between the terminal devices may be implemented by using a D2D technology. For example, the terminal device 1 to the terminal device 4 may separately communicate with the network device. For example, the terminal device 3 and the terminal device 4 may directly communicate with the network device, or may indirectly communicate with the network device, for example, communicate with the network device via another terminal device (not shown in FIG. 1). It should be understood that FIG. 1 shows an example of one network device, four terminal devices, and communication links between communication devices. Optionally, the communication system may include a plurality of network devices, and another quantity of terminal devices, for example, more or fewer terminal devices, may be included in a coverage area of each network device. This is not limited in embodiments of this application. The following describes the terminal device and the network device in detail.

The terminal device is an apparatus having a wireless transceiver function. The terminal device may communicate with an access network device (or may be referred to as an access device) in a radio access network (radio access network, RAN). The terminal device may also be referred to as user equipment (user equipment, UE), an access terminal, a terminal (terminal), a subscriber unit (subscriber unit), a subscriber station, a mobile station, a remote station, a remote terminal, a mobile device, a user terminal, a user agent, a user apparatus, or the like. In a possible implementation, the terminal device may be deployed on land, including an indoor, outdoor, handheld, or vehicle-mounted device; may be deployed on the water (for example, a ship), or the like. In a possible implementation, the terminal device may be a handheld device having a wireless communication function, a vehicle-mounted device, a wearable device, a sensor, a terminal in an internet of things, a terminal in an internet of vehicles, an unmanned aerial vehicle, a terminal device in any form in a 5G network or a future network, or the like. This is not limited in embodiments of this application. It may be understood that the terminal device shown in this embodiment of this application may not only include a vehicle (for example, a car) in the internet of vehicles, but also may include a vehicle-mounted device, a vehicle-mounted terminal, or the like in the internet of vehicles. A specific form of the terminal device used in the internet of vehicles is not limited in embodiments of this application. It may be understood that the terminal devices shown in this embodiment of this application may further communicate with each other by using a technology such as D2D, V2X, or M2M. A communication method between the terminal devices is not limited in embodiments of this application.

The network device may be an apparatus that is deployed in the radio access network and that provides a wireless communication service for the terminal device. The network device may also be referred to as an access network device, an access device, a RAN device, or the like. For example, the network device may be a next generation NodeB (next generation NodeB, gNB), a next generation evolved NodeB (next generation evolved NodeB, ng-eNB), a network device in 6G communication, or the like. The network device may be any device having a wireless transceiver function, and includes but is not limited to the base station shown above (including a base station deployed on a satellite). Alternatively, the network device may be an apparatus that has a base station function in 6G. Optionally, the network device may be an access node, a wireless relay node, a wireless backhaul node, or the like in a Wi-Fi system. Optionally, the network device may be a radio controller in a cloud radio access network (cloud radio access network, CRAN) scenario. Optionally, the network device may be a wearable device, a vehicle-mounted device, or the like. Optionally, the network device may be a small cell, a transmission reception point (transmission reception point, TRP) (or may be referred to as a transmission point), or the like.

It may be understood that the network device may alternatively be a base station, a satellite, or the like in a future evolved public land mobile network (public land mobile network, PLMN). The network device may alternatively be a communication apparatus or the like functioning as a base station in a non-terrestrial communication system, D2D, V2X, or M2M. A specific type of the network device is not limited in embodiments of this application. In systems using different radio access technologies, names of communication apparatuses having functions of network devices may be different, and are not listed one by one in this embodiment of this application. Optionally, in some deployments of the network device, the network device may include a central unit (central unit, CU), a distributed unit (distributed unit, DU), and the like. In some other deployments of the network device, the CU may be further divided into a CU-control plane (control plane, CP), a CU-user plane (user plane, UP), and the like. In still some other deployments of the network device, the network device may alternatively be an open radio access network (open radio access network, ORAN) architecture or the like. A specific deployment manner of the network device is not limited in embodiments of this application.

In another possible implementation, FIG. 2 is a diagram of an architecture of a communication system according to an embodiment of this application. The communication system may include one or more APs and one or more STAs. FIG. 2 shows two access points such as an AP 1 and an AP 2, and three stations such as a STA 1, a STA 2, and a STA 3. The one or more APs may communicate with the one or more STAs. It is clear that APs may communicate with each other, and STAs may communicate with each other. For example, simultaneous communication between one AP and a plurality of STAs may include: downlink transmission in which the one AP sends a signal to the plurality of STAs simultaneously, or uplink transmission in which the plurality of STAs simultaneously send a signal to the one AP. In addition, the technical solutions provided in embodiments of this application can also be applied to a similar non-standard transmission system.

It may be understood that, in FIG. 2, an example in which the STA is a mobile phone and the AP is a router is used. This does not mean that types of the AP and the STA in embodiments of this application are limited. Moreover, FIG. 2 shows only two APs and three STAs as examples. However, there may be more or fewer APs or STAs. This is not limited in embodiments of this application. The following describes the access point and the station in detail.

The access point is an apparatus having a wireless communication function, supports communication or sensing by using a WLAN protocol, has a function of communicating with or sensing another device (for example, a station or another access point) in a WLAN network, and certainly may also have a function of communicating with or sensing another device. Alternatively, the access point is equivalent to a bridge that connects a wired network and a wireless network. A main function of the access point is to connect various wireless network clients together and then connect the wireless network to the Ethernet. In a WLAN system, the access point may be referred to as an access point station (AP STA). The apparatus having the wireless communication function may be an entire device, or may be a chip, a processing system, or the like installed in the entire device. The device in which the chip or the processing system is installed may implement the method, the function, and the like in embodiments of this application under control of the chip or the processing system. The AP in embodiments of this application is an apparatus that provides a service for the STA, and may support the 802.11 series protocols, subsequent protocols, or the like. For example, the access point may be an access point for a terminal (for example, a mobile phone) to access a wired (or wireless) network, and is mainly deployed at home, and inside a building and a campus. A typical coverage radius is tens to hundreds of meters. It is clear that the access point may alternatively be deployed outdoors. For another example, the AP may be a communication entity, for example, a communication server, a router, a switch, or a bridge, or the AP may include various forms of macro base stations, micro base stations, relay stations, and the like. It is clear that the AP may alternatively be a chip or a processing system in these devices in various forms, to implement the method and the function in embodiments of this application. For descriptions of the access point, refer to the descriptions of the network device in FIG. 1. Details are not described herein again.

The station is an apparatus having a wireless communication function, supports communication or sensing by using the WLAN protocol, and has a capability of communicating or sensing with another station or the access point in the WLAN network. In the WLAN system, the station may be referred to as a non-access point station (non-access point station, non-AP STA). For example, the STA is any user communication device that allows a user to communicate with or sense the AP and then communicate with the WLAN. The apparatus having the wireless communication function may be an entire device, or may be a chip, a processing system, or the like installed in the entire device. The device in which the chip or the processing system is installed may implement the method and the function in embodiments of this application under control of the chip or the processing system. For example, the station may be a wireless communication chip, a wireless sensor, a wireless communication terminal, or the like, and may also be referred to as a user. For another example, the station may be a mobile phone, a tablet computer, a set-top box, a smart television, a smart wearable device, a vehicle-mounted communication device, a computer, or the like supporting a Wi-Fi communication function. For descriptions of the station, refer to the descriptions of the terminal device in FIG. 1. Details are not described herein again.

A network architecture and a service scenario that are described in embodiments of this application are intended to describe the technical solutions in embodiments of this application more clearly, but do not constitute any limitation on the technical solutions provided in embodiments of this application. A person of ordinary skill in the art can know that, as a network architecture evolves and a new service scenario emerges, the technical solutions provided in embodiments of this application are also applicable to similar technical issues.

An NR LDPC code has been used as a channel coding scheme of a data channel for a 5G data channel, and the NR LDPC code is specially designed for a channel coding scenario. Therefore, if the NR LDPC code is directly used for data transmission for a biased source in a JSCC scenario, performance is greatly affected.

In view of this, embodiments of this application provide an encoding method, a decoding method, and an apparatus, to provide a set of JSCC-LDPC codes for the biased source in the JSCC scenario. The JSCC-LDPC code provided in embodiments of this application can effectively improve decoding performance, so that the performance is greatly improved in a scenario with the biased source. For example, the JSCC-LDPC code provided in embodiments of this application may be referred to as a combined-compression-correction protograph LDPC (combined-compression-correction protograph LDPC, 3C-P-LDPC) code or an LDPC code applicable to the biased source. A specific name of the JSCC-LDPC code provided in embodiments of this application is not limited in embodiments of this application. The 3C-P-LDPC code provided in embodiments of this application has a higher degree of design freedom, and can achieve excellent performance in a case of at least two different source sparsities, especially in a low error probability region. Optionally, a check matrix of the 3C-P-LDPC code provided in embodiments of this application may be used as a kernel matrix and expanded by using a structure similar to NR LDPC. Therefore, a check matrix set that supports more different source sparsities and code rates is obtained (as shown in a similar expansion manner below). The 3C-P-LDPC code provided in embodiments of this application is applicable to sources with different sparsities, and has good decoding performance. Therefore, the 3C-P-LDPC code has a wide application prospect for a next generation wireless communication system.

Before the encoding method and the decoding method provided in embodiments of this application are described, the following first describes in detail a design principle of the check matrix provided in embodiments of this application.

**1. Principle of a JSCC extrinsic information transfer (extrinsic information transfer, EXIT) chart**

Generally, the JSCC-EXIT chart is used for decoding threshold analysis, and a JSCC-EXIT chart analysis method may be used as a core step of designing the 3C-P-LDPC code (also referred to as a 1st step of designing the 3C-P-LDPC code). As a basis for analyzing a theoretical decoding threshold of a base matrix, theoretical limit decoding performance of a given protograph may be learned of by analyzing the JSCC-EXIT chart.

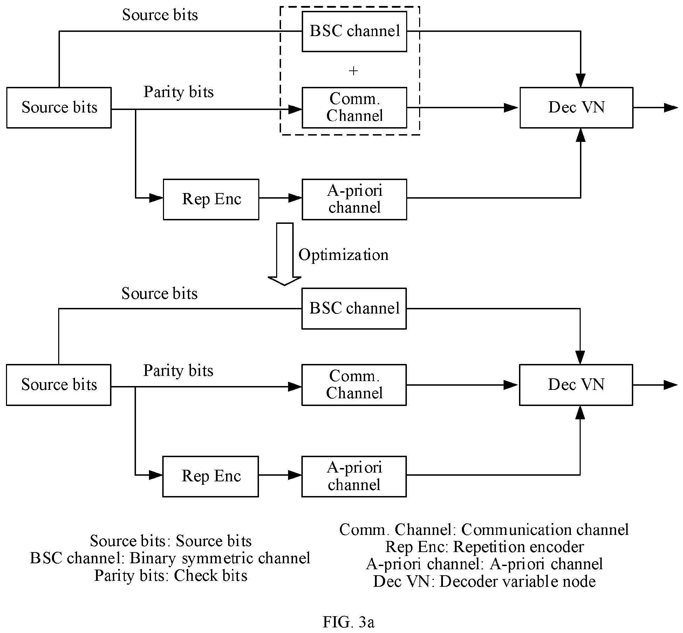

FIG. 3a is a diagram of principle analysis of an optimized JSCC-EXIT chart according to an embodiment of this application. As shown in FIG. 3a, in conventional JSCC-EXIT analysis, a biased source and a communication channel are approximated to a single additive white Gaussian noise (additive white Gaussian noise, AWGN) channel. As a result, mutual information calculation accuracy of the JSCC-EXIT chart is not high. A dashed line part shown in FIG. 3a indicates that a binary symmetric channel (binary symmetric channel, BSC) and a communication channel (comm. channel) are approximated to a single AWGN channel. In the optimized JSCC-EXIT chart, the BSC channel and the communication channel equivalent to a biased source part are separately processed, so that mutual information in an iterative decoding process can be tracked more accurately, and a decoding threshold can be obtained more accurately. The decoding threshold of the protograph may be understood as a minimum signal-to-noise ratio (signal-to-noise ratio, SNR) or $Eb/N_{oise}$ required for successful decoding of an LDPC code set corresponding to the protograph when a code length is infinite, where Eb represents a transmitted wanted signal, and $N_{oise}$ indicates transmission noise. A smaller decoding threshold indicates that the LDPC code set corresponding to the protograph is closer to a channel capacity (which may also be referred to as better performance) when the code length tends to be infinite.

As shown in FIG. 3a, check bits (parity bits) may be obtained based on source bits (source bits) (namely, information bits). Then, the source bits may be approximately transmitted through a BSC channel, and the check bits may be approximately transmitted through a communication channel. The check bits are approximately transmitted through an A-priori channel (A-priori channel) by using a repetition encoder (rep-encoder). Correspondingly, decoding may be performed by using a decoder variable node (decoder variable node, Dec VN).

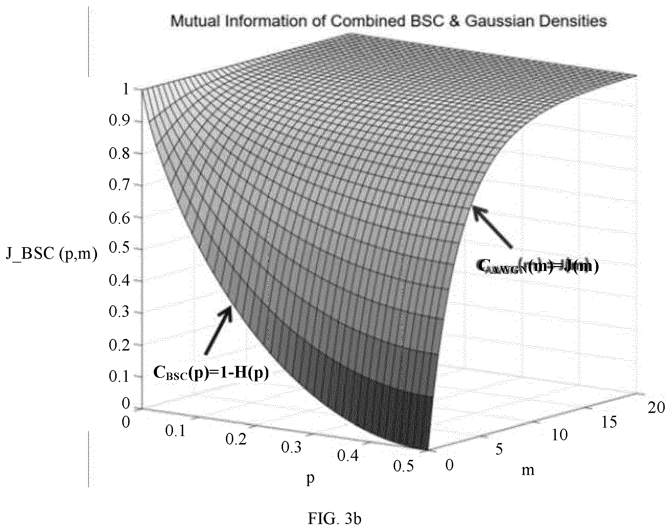

FIG. 3a may be understood as a basis of theoretical analysis. Based on the theoretical analysis, mutual information combining the BSC and a Gaussian density may be obtained, and a dimension of a source sparsity is added to the mutual information. FIG. 3b is a diagram of principle analysis of an optimized JSCC-EXIT chart according to an embodiment of this application. As shown in FIG. 3b, in JSCC-EXIT analysis, a calculated input of mutual information include a source sparsity and an average value of log likelihood ratios (log likelihood ratios, LLRs) of bits transmitted on a channel. That is, the mutual information depends on both the source sparsity and a signal-to-noise ratio of the channel. In FIG. 3b, a z-axis represents the mutual information, an x-axis represents the average value (represented by m in FIG. 3b) of the LLRs of the bits transmitted on the channel, and a y-axis represents the source sparsity (represented by p in FIG. 3b). The source sparsity may be used for measuring a proportion of 1s or 0s in a source. For example, the source sparsity may also be referred to as source priori information or a source priori probability. This is not limited in embodiments of this application. For example, when the source sparsity is used for measuring the proportion of 1s in the source, the source sparsity may be represented by p1. When the source sparsity is used for measuring the proportion of 0s in the source, the source sparsity may be represented by p0. It can be learned from FIG. 3b that, when the average value m of the LLRs of the bits transmitted on the channel is equal to 0, a curve is equivalent to a channel capacity of a BSC channel whose channel transition probability is p; or when the source sparsity p is equal to 0.5, a curve is equivalent to a channel capacity of an AWGN channel with an average value m of LLRs of bits transmitted on the channel.

Generally, the protograph is in one-to-one correspondence with the base matrix. The decoding threshold of the protograph shown in this embodiment of this application may alternatively be equivalent to a decoding threshold of a second base matrix or a decoding threshold of a first base matrix shown below.

## 2. Differential evolution iteration

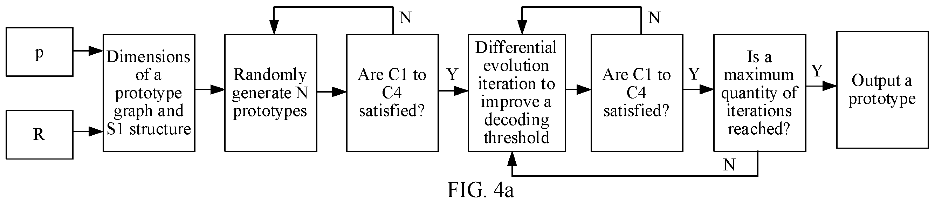

FIG. 4a is a schematic flowchart of differential evolution iteration according to an embodiment of this application. According to a method shown in FIG. 4a, a protograph having an optimal decoding threshold may be obtained through iterative optimization, and the protograph may satisfy at least one of four constraint conditions and one basic structure in embodiments of this application. The four constraint conditions may be respectively represented by C1 to C4, and the basic structure may be represented by S1. The representation manners shown herein are merely examples. Representation manners of the constraint conditions and the basic structure are not limited in embodiments of this application.

As shown in FIG. 4a, a source sparsity p and a target code rate (target rate) R are input, and then N protographs are randomly generated (random generate N protographs) based on dimensions (for example, a quantity of variable nodes and a quantity of check nodes in the protograph, or a quantity of rows and a quantity of columns of a base matrix) and an S1 structure of the protograph (dimension and S1 structure of protograph). After the N protographs are generated, whether each protograph satisfies C1 to C4 (whether all protographs satisfy C1 to C4) is determined. If C1 to C4 are satisfied, differential evolution iteration is performed; or if C1 to C4 are not satisfied, N protographs are regenerated. A decoding threshold may be continuously improved through differential evolution iteration. During the differential evolution iteration, the decoding threshold may be determined by using the mutual information shown in FIG. 3b. In this embodiment of this application, the decoding threshold of the protograph can be accurately calculated by using the mutual information shown in FIG. 3b. Therefore, the protograph having the optimal decoding threshold can be optimized through continuous iteration. After differential evolution iteration is performed, a protograph may be output, and then it is determined again whether the protograph obtained through the differential evolution iteration satisfies C1 to C4. If the protograph satisfies C1 to C4, whether a maximum quantity of iterations is reached is determined (or whether the protograph is converged or whether the maximum quantity of iterations is exceeded is determined); or if the protograph does not satisfy C1 to C4, differential evolution iteration is performed again. If the maximum quantity of iterations is reached (or the protograph is converged), the protograph is output; or if the maximum quantity of iterations is not reached (or the protograph is not converged), differential evolution iteration may be performed again. Therefore, a protograph having a lowest decoding threshold may be obtained, in a differential evolution iteration manner, for S1 and C1 to C4.

It may be understood that whether C1 to C4 are satisfied is merely an example. For example, whether C1 to C4 are satisfied may be replaced with whether at least one of C1 to C4 is satisfied. The foregoing differential evolution iteration manner is merely an example. For example, a manner of optimizing an additional factor or a non-differential evolution manner may be used. This is not limited in embodiments of this application.

FIG. 4a may be understood as follows: After a framework (for example, the dimension and the S1 structure of the protograph) of the 3C-P-LDPC protograph is obtained, the protograph having the optimal decoding threshold is output by using an algorithm similar to differential evolution or the like based on the foregoing framework and constraint. It should be noted that elements in the base matrix corresponding to the protograph in FIG. 4a may include 0, 1, and 2, and a non-zero element may be understood as a quantity of 1s included in each row or each column after the base matrix is expanded. For descriptions of the non-zero element in the base matrix, refer to a second base matrix shown below. For example, when the base matrix is expanded, a two-step expansion manner may be used for obtaining a check matrix. Therefore, for ease of description, the base matrix is divided into a first base matrix and a second base matrix below. Elements in the second base matrix include 0, 1, and 2, and elements in the first base matrix include 0 and 1.

It should be noted that FIG. 4a may be understood as a diagram of a generation principle of at least one of the second base matrix, the first base matrix, and the check matrix in the following embodiments of this application. However, it does not indicate that two communication parties need to generate the check matrix based on FIG. 4a each time when using the check matrix. For example, at least one of the second base matrix, the first base matrix, and the check matrix shown below may be predefined in a standard. When at least one of the first base matrix, the second base matrix, and the check matrix is defined in the standard, the matrix may be set in a terminal device during factory setting of the terminal device. In other words, during actual application, the two communication parties may interact with each other by storing at least one of the first base matrix, the second base matrix, and the check matrix shown below, and do not necessarily need to generate the first base matrix, the second base matrix, or the check matrix in the manner shown in FIG. 4a.

### 3. S1 Structure and constraint conditions C1 to C4

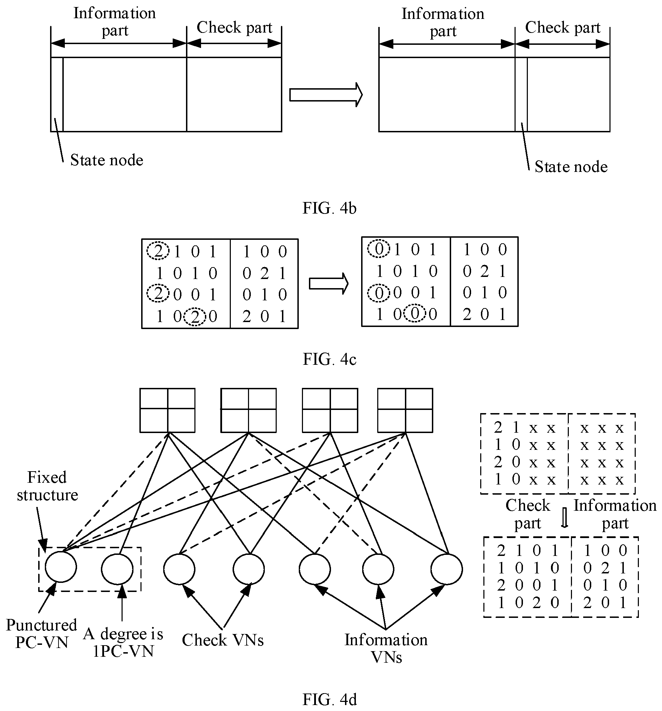

For an NR LDPC code, except a bit corresponding to a state node, all other encoded bits need to be transmitted through a channel. In addition, because a structure of the NR LDPC code for a check part is fixed, optimization of a protograph (or a base matrix) of the NR LDPC code is almost optimization of an information part. The state node shown herein may be understood as a variable node corresponding to a punctured information bit in a channel coding scenario. As shown on the left of FIG. 4b, the state node may be understood as the first two columns of the information part of the NR LDPC code, or may be understood as punctured columns. In other words, bits obtained through encoding based on the two columns need to be punctured. Introduction of the state node may further improve a decoding threshold, and a combination of the state node and a node whose degree is 1 may better adapt to a hybrid automatic repeat request (hybrid automatic repeat request, HARQ).

However, in embodiments of this application, not all bits obtained through LDPC encoding need to be transmitted through the channel. Therefore, embodiments of this application provide a 3C-P-LDPC code. For example, in embodiments of this application, a check bit may be transmitted through the channel, and each information bit is punctured before transmission. For another example, in embodiments of this application, the check bit and some information bits may be transmitted through the channel. If the NR LDPC code is still used, a receiver cannot provide, for the information bits based on the transmitted check bit (including a core check bit and an expanded check bit), more information by using an optimized graph connection structure. Consequently, it is difficult to restore all or some of punctured information bits. However, according to the 3C-P-LDPC code provided in embodiments of this application, the information bits can be effectively restored based on the transmitted check bit. A structure of the 3C-P-LDPC code for a check part is not fixed, and a structure of the 3C-P-LDPC code for an information part may not be fixed. In other words, both optimization of the information part and optimization of the check part are included. In comparison with the NR LDPC code, the 3C-P-LDPC code has a higher degree of freedom and better decoding performance in a scenario with a biased source.

S1: Introduction of a state node into a check part in a base matrix may improve a decoding threshold of JSCC and actual performance of JSCC-LDPC. The actual performance shown herein is relative to extreme performance shown for the decoding threshold. In other words, the actual performance may be understood as actual performance when encoding and decoding are performed based on a required code length and code rate. As shown on the right of FIG. 4b, a location of the state node is in a check part, and is different from a location of the state node in the NR LDPC code shown on the left of FIG. 4b. If the state node is still placed in an information part, because a source is a biased source, determining, by a receiver, whether the source is the biased signal source is adversely affected. Therefore, in embodiments of this application, the state node is placed in the check part. A column weight of the state node is heavier than a column weight of another column. Therefore, to avoid a sharp decrease in all decoding performance caused by a decoding error of this part, encoded bits corresponding to the state node are punctured. Therefore, the state node is placed in the check part, and the encoded bits corresponding to the state node are punctured, so that decoding convergence can be effectively ensured and decoding performance can be improved.

C1: A check part square matrix obtained by expanding the base matrix is full-rank, so that it can be ensured that a source bit is encoded without a code rate loss. For example, whether a check matrix is full-rank may be determined in the following manner: In a protograph, an even item is set to 0, and an odd item is set to 1; or in a protograph, an even item is set to 1, and an odd item is set to 0. If a binary square matrix obtained in the foregoing manner is full-rank in a binary operation, a check part in the check matrix obtained by expanding the base matrix is also full-rank. The binary square matrix is. FIG. 4c is a diagram of determining a full rank of a check part according to an embodiment of this application. As shown in FIG. 4c, an even item 2 of a check part in a base matrix shown on the left is permuted into 0. Because an even item 0 is still 0 after permutation, and an odd item 1 is still 1 after permutation, the even item 0 and the odd item 1 of the check part in the base matrix may not be permuted. Through permutation, the check part in the base matrix shown on the left of FIG. 4c may be permuted into a check part (a 4*4 square matrix) of a base matrix shown on the right of FIG. 4c. If the check part shown on the right of FIG. 4c is full-rank, an expanded check part is also a full-rank square matrix.

C2: A maximum row weight and a maximum column weight in the base matrix are controlled to control a density of 1s in the matrix, so that performance of the base matrix can be effectively improved in a case of a medium or small code length. A quantity of columns whose weights are 1 and a quantity of rows whose weights are 1 in the base matrix are limited.

C3: A quantity of variable nodes whose degrees are 2 is controlled, to ensure that a minimum distance of a constructed code can increase linearly as a code length increases, and performance of an error floor is better controlled. The quantity of variable nodes whose degrees are 2 may be understood as a column including two 1s in the base matrix. As shown on the left of FIG. 4c, a 4th column and a 7th column of the base matrix may be understood as columns whose degrees are 2.

C4: A plurality of protographs with a good decoding threshold are stored for further optimization. In embodiments of this application, a plurality of first base matrices may be obtained by optimizing one second base matrix. Therefore, two communication parties may select one first base matrix from the plurality of first base matrices based on an actual requirement, to optimize decoding performance. For example, to better select a protograph with excellent performance in a case of a medium or small code length, the plurality of protographs with the good threshold may be stored for further optimization. For example, for a short code, the decoding threshold cannot completely determine final performance of an actual code, because a complex subgraph structure in a factor graph of the short code severely affects decoding performance. Therefore, the plurality of protographs are stored, so that the two communication parties can have more choices.

Based on the foregoing S1 structure and the constraint conditions C1 to C4, in comparison with a conventional channel coding LDPC code, the 3C-P-LDPC code for the joint source-channel coding provided in embodiments of this application needs to satisfy more structural characteristics and constraint conditions. Therefore, matrices corresponding to the information part and the check part each can be optimized. In a specific design process of the protograph, in each design step, it needs to be ensured that a temporary or final check matrix designed or generated by using an evolutionary algorithm satisfies the basic architecture shown on the right (namely, S1) of FIG. 4b, and also needs to satisfy the foregoing constraint conditions C1 to C4.

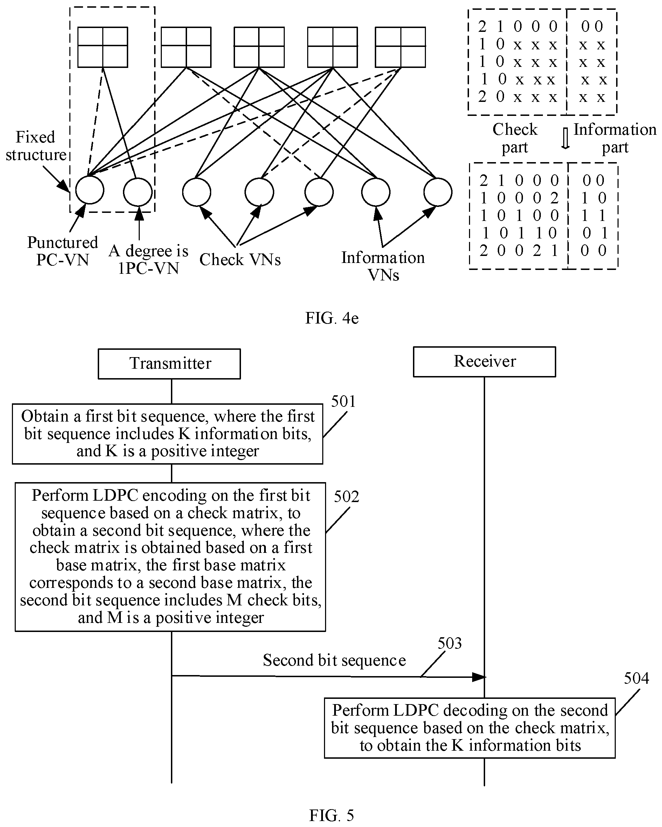

FIG. 4d and FIG. 4e each are a diagram of a protograph according to an embodiment of this application. x represents a to-be-designed part, a value of x may be 0, 1, or 2, and all other parts except x are fixed, including a 1st punctured column and a 2nd column whose column weight is 1. In FIG. 4d, a punctured column (a 1st column shown in FIG. 4d) and a column whose degree is 1 (a 2nd column shown on the right of FIG. 4d) are fixed, that is, the columns are fixed structures (fixed structures). In FIG. 4e, a punctured column (a 1st column shown on the right of FIG. 4e), a column whose degree is 1 (a 2nd column shown on the right of FIG. 4e), and a 1st row are fixed, that is, the columns are fixed structures. Base matrices including x shown in FIG. 4d and FIG. 4e may be continuously optimized by using the method shown in FIG. 4a, to obtain specific matrices. Details are not described herein again. The first four columns in FIG. 4d are a check part (namely, a square matrix) in the base matrix, and the last three columns in FIG. 4d are a check part in the base matrix. The first five columns in FIG. 4e are a check part in the base matrix, and the last two columns in FIG. 4e are a check part in the base matrix. In FIG. 4d and FIG. 4e, all encoded bits in the check part need to be punctured. In FIG. 4d and FIG. 4e, a box represents a check node, a circle represents a variable node, a solid line connecting the variable node and the check node represents 1 in the base matrix, and a dashed line connecting the variable node and the check node represents 2 in the base matrix. Based on structures of the check part and an information part, a 1st circle may be understood as a punctured column (a punctured PC-VN shown in the figure), a 2nd circle may be understood as a column whose column weight is 1 (a PC-VN whose degree is 1 shown in the figure), and other circles are columns (check VNs shown in the figure) other than the 1st column and the 2nd column of the check part and the information part (information VNs shown in the figure). It may be understood that a PC-VN in FIG. 4d and FIG. 4e represents a variable node of a check part in a 0-base matrix.

Based on the foregoing principle, embodiments of this application provide a plurality of base matrices and check matrices. The following describes the method in embodiments of this application.

FIG. 5 is a schematic flowchart of an encoding method and a decoding method according to an embodiment of this application. The method may be applied to a transmitter and a receiver. The transmitter may be understood as an end that sends information, and the receiver may be understood as an end that receives information. Alternatively, the transmitter may be understood as an encoding side, and the receiver may be understood as a decoding side. For example, the transmitter may be a network device (for example, a base station), and the receiver may be a terminal device; the transmitter may be an AP, and the receiver may be a STA; or both the transmitter and the receiver may be terminal devices (or STAs). This is not limited in embodiments of this application. For a communication system to which this embodiment of this application is applied, refer to FIG. 1 and FIG. 2. Details are not described herein again. As shown in FIG. 5, the method includes the following steps.

501: The transmitter obtains a first bit sequence, where the first bit sequence includes K information bits, and K is a positive integer.

The first bit sequence may be understood as a to-be-sent bit sequence obtained by the transmitter. For example, the first bit sequence may be understood as a bit sequence including information content or a bit sequence that needs to be transmitted. Optionally, the first bit sequence may be understood as including the K information bits. The K information bits shown above may include a cyclic redundancy check (cyclic redundancy check, CRC). Alternatively, the K information bits may not include a CRC. In this case, the transmitter may not add the CRC or may add the CRC in a subsequent process of processing the first bit sequence. This is not limited in embodiments of this application. The first bit sequence may be a bit sequence on which source compression is not performed. Alternatively, the first bit sequence may be a bit sequence on which source compression is performed.

502: The transmitter performs LDPC encoding on the first bit sequence based on a check matrix, to obtain a second bit sequence, where the check matrix is obtained based on a first base matrix, the first base matrix corresponds to a second base matrix, the second bit sequence includes M check bits, and M is a positive integer.

The M check bits included in the second bit sequence may be directly obtained through LDPC encoding. Alternatively, the second bit sequence may be obtained through rate matching performed, by the transmitter, on a sequence that is obtained through LDPC encoding. For example, the transmitter obtains the second bit sequence by puncturing the sequence that is obtained through LDPC encoding. In an example, the second bit sequence may include the M check bits. In other words, only the check bits may be transmitted through a channel. In another example, the second bit sequence may include the M check bits and N information bits, where N is less than K. In other words, in addition to the check bits transmitted through a channel, a small quantity of information bits may be transmitted through the channel. A value relationship between K and M is not limited in embodiments of this application.

The second base matrix includes the following elements: 0, 1, and 2, and the second base matrix may satisfy at least one of the following conditions:

Condition 1: An element 1 in a 2nd column of a check part in the second base matrix and an element 2 in a 1st column of the check part are located in a same row, and a quantity of elements 1 in the 2nd column is less than or equal to a quantity of elements 2 in the 1st column.

The element 1 in the 2nd column and the element 2 in the 1st column of the second base matrix are located in the same row, so that decoding performance of the receiver can be ensured, a low decoding threshold can be ensured, and encoding and decoding complexity is low. In this embodiment of this application, decoding performance of the second base matrix when the quantity of elements 1 in the 2nd column is less than the quantity of elements 2 in the 1st column is better than decoding performance of the second base matrix when the quantity of elements 1 in the 2nd column is equal to the quantity of elements 2 in the 1st column.

Condition 2: A 1st column of a check part in the second base matrix is a punctured column.

The 1st column of the second base matrix may also be referred to as a state column. Because the transmitter may transmit only the check bits, or transmit the check bits and some information bits, decoding performance can be effectively improved by setting the state column in the check part.

It may be understood that the 1st column of the check part in the second base matrix may be referred to as the punctured column, may be referred to as the state column, or may be referred to as a state node. This is not limited in embodiments of this application. For descriptions of the state node, refer to FIG. 4b. Details are not described herein again.

Condition 3: A quantity of rows of the second base matrix is determined based on a sparsity of the first bit sequence.

At least one of a quantity of rows of a check part in the second base matrix and a quantity of rows of an information part in the second base matrix may be determined based on the sparsity of the first bit sequence. Generally, a smaller sparsity of a source indicates a sparser source. Therefore, the receiver can effectively restore the information bits by using only the check bits. Therefore, a sparser source indicates a larger code rate, that is, a smaller quantity of check bits transmitted by the transmitter. For example, a sparser source indicates a smaller quantity of rows of the check part, and correspondingly, a smaller quantity of rows of the information part.

A quantity of rows of the second base matrix is determined based on the sparsity of the first bit sequence, so that the transmitter can select, based on different first bit sequences, a second base matrix that matches the sparsity, to better match the first bit sequence. In this way, decoding performance is optimized.

Condition 4: A quantity of columns of the second base matrix is determined based on a sparsity of the first bit sequence.

At least one of a quantity of columns of a check part in the second base matrix and a quantity of columns of the information part in the second base matrix is determined based on the sparsity of the first bit sequence. Generally, the check part in the base matrix is a square matrix. Therefore, when a source is sparser, the quantity of columns of the check part in the second base matrix may be smaller. If the source is less sparse, the receiver may fail to restore a large quantity of information bits by using the check bits. Therefore, the quantity of columns of the information part in the second base matrix may be smaller.

Different second base matrices are designed based on the sparsity of the first bit sequence, so that a degree of design freedom of the base matrix can be effectively improved.

Condition 5: A 1st column of a check part in the second base matrix is any one of the following: $[1\ 2\ 1\ 2]^T$; $[1\ 1\ 2\ 2]^T$; $[2\ 2\ 1\ 1]^T$, $[2\ 1\ 2\ 1]^T$, $[1\ 1\ 1\ 2\ 2]^T$; $[1\ 1\ 2\ 2\ 1]^T$, $[1\ 2\ 2\ 1\ 1]^T$, $[2\ 2\ 1\ 1\ 1]^T$, $[1\ 2\ 1\ 2\ 1]^T$, $[2\ 1\ 1\ 1\ 2]^T$; and $[2\ 1\ 2\ 1\ 1]^T$.

The 1st column of the check part in the second base matrix is a result obtained based on a compromise between a decoding threshold and a trapping set.

It may be understood that the 1st column of the check part in the second base matrix shown herein is merely an example. A matrix obtained through column permutation (or column transformation) or row permutation (or row transformation) performed on the second base matrix, the first base matrix, or the check matrix shown in this embodiment of this application also falls within the protection scope of embodiments of this application. In other words, a matrix obtained through column permutation performed on the second base matrix shown below also belongs to the second base matrix, and/or a matrix obtained through row permutation performed on the second base matrix shown below also belongs to the second base matrix. A matrix obtained through at least one of a column permutation operation or a row permutation operation performed on the first base matrix shown below also belongs to the first base matrix. A matrix obtained through at least one of a column permutation operation or a row permutation operation performed on the check matrix shown below also belongs to the check matrix.

Condition 6: A column weight of a 2nd column of a check part in the second base matrix is 1.

That the column weight of the 2nd column of the check part in the second base matrix is 1 may also be understood as that a degree of the 2nd column is 1. A combination of the condition 6 and the condition 1 can effectively improve decoding performance of the receiver and reduce encoding and decoding complexity.

Based on at least one of the foregoing condition 2 to condition 6 and the condition 1, a base matrix having a low decoding threshold may be obtained through differential evolution iteration of information by using the method shown in FIG. 4a, as shown in Implementation 1 to Implementation 3 below.

A relationship between the first base matrix and the second base matrix may satisfy at least one of the following: Condition 7: A quantity of rows of the first base matrix is equal to n times the quantity of rows of the second base matrix, where n is an integer greater than or equal to 2.

For example, n=2, n=3, or n=4. Examples are not listed one by one herein.

Condition 8: A quantity of columns of the first base matrix is equal to n times the quantity of columns of the second base matrix, where n is an integer greater than or equal to 2.

For the condition 7 and the condition 8, it may also be understood that the first base matrix may be obtained based on the second base matrix by using a lifting factor n.

Condition 9: The element 1 in the second base matrix is expanded to an n*n identity matrix or an n*n antisymmetric square matrix, and the element 2 in the second base matrix is expanded to an n*n all-1 matrix, where n is an integer greater than or equal to 2.

For example, the element 1 in the second base matrix may be expanded to a formula (1) or a formula (2), and the element 2 may be expanded to a formula (3).

$$\begin{bmatrix} 1 & 0 \\ 0 & 1 \end{bmatrix} \quad (1)$$

$$\begin{bmatrix} 0 & 1 \\ 1 & 0 \end{bmatrix} \quad (2)$$

$$\begin{bmatrix} 1 & 1 \\ 1 & 1 \end{bmatrix} \quad (3)$$

It may be understood that each element 1 in the second base matrix may be expanded to the formula (1) or the formula (2), or a first quantity of elements 1 in the second base matrix may be expanded to the formula (1), and a second quantity of elements 1 may be expanded to the formula (2). A value relationship between the first quantity and the second quantity is not limited in embodiments of this application.

It may be understood that, based on the relationship between the first base matrix and the second base matrix, at least one of the condition 2, the condition 3, the condition 4, and the condition 6 that the second base matrix satisfies is also applicable to the first base matrix. For example, the first n columns of the first base matrix may be punctured columns. For another example, at least one of the quantity of rows or the quantity of columns of the first base matrix is determined based on the sparsity of the first bit sequence. For another example, column weights of a $(n+1)^{th}$ column to a $(2n)^{th}$ column of the first base matrix may be 1. Based on a relationship between the second base matrix and the check matrix, the foregoing condition that the second base matrix satisfies is also applicable to the check matrix. For example, at least one of a quantity of rows or a quantity of columns of the check matrix is determined based on the sparsity of the first bit sequence. For another example, a quantity of columns of an information part in the check matrix is inversely correlated with the sparsity of the first bit sequence. For another example, at least one of the quantity of rows and the quantity of columns of the check part in the check matrix is positively correlated with the sparsity of the first bit sequence. Descriptions of the first base matrix and the check matrix are not listed one by one.

At least one of the condition 1 to the condition 6 shown above may be combined with at least one of the condition 7 to the condition 9. Examples are not listed one by one herein. For descriptions of the first base matrix, the second base matrix, and the check matrix, refer to FIG. 3a, FIG. 3b, and FIG. 4a to FIG. 4e. Details are not described herein again.

It should be noted that, in view of a relationship between the second base matrix, the first base matrix, and the check matrix, during actual application, two communication parties may perform encoding and decoding by storing the second base matrix, the two communication parties may perform encoding and decoding by storing the first base matrix, or two communication parties may perform encoding and decoding by storing the check matrix. In other words, although the relationship between the second base matrix and the first base matrix is described above, it does not indicate that during actual application, the two communication parties definitely store the second base matrix. Generally, the two communication parties store the first base matrix.

503: The transmitter sends the second bit sequence, and correspondingly, the receiver receives the second bit sequence.

It may be understood that after the second bit sequence is obtained, the transmitter may not actually send the second bit sequence, but a symbol sequence obtained through operations such as rate matching, modulation, and frequency conversion performed on the second bit sequence. Correspondingly, the receiver may not receive the second bit sequence through a wired channel or a wireless channel, but a sequence obtained by transmitting the symbol sequence through the channel. Then, the receiver can obtain the second bit sequence only after performing operations corresponding to the operations performed by the transmitter. For brevity, the descriptions of step 503 are used in this embodiment of this application, but should not be construed as any limitation on embodiments of this application. In addition, that the transmitter sends the second bit sequence is used as an example to describe FIG. 5 in the accompanying drawings, but should not be construed as any limitation on embodiments of this application.

504: The receiver performs LDPC decoding on the second bit sequence based on the check matrix, to obtain the K information bits.

For example, a decoding method may include any one of hard decision decoding, soft decision decoding, and hybrid decoding. This is not limited in embodiments of this application. For example, after obtaining the second bit sequence, the receiver may perform LDPC decoding on the second bit sequence. If a decoding error occurs or a specific threshold is not reached, LDPC decoding is performed again, and the K information bits are output until decoding is performed correctly or the specific threshold is reached. A condition for performing LDPC decoding again may include at least one of the following: failing to reach a quantity of decoding iterations and failing to succeed in verification of the check matrix. Optionally, if the receiver has a decoding error (or fails to perform decoding), the receiver sends retransmission indication information to the transmitter, to request the transmitter to perform retransmission. In addition, if failing to perform decoding, the receiver may store an initially transmitted sequence, to perform combined decoding on the initially transmitted sequence and a retransmitted sequence that is subsequently received.

It may be understood that, in addition to the check matrix, a code rate (which may also be referred to as an encoding code rate, a target code rate, or the like) may be further used in an encoding and decoding process. For example, the transmitter may perform LDPC encoding on the first bit sequence based on the check matrix and the code rate, and correspondingly, the receiver may perform LDPC decoding on the second bit sequence based on the check matrix and the code rate. For example, the code rate may be dynamically or statically configured by a network device for a terminal device. For example, the network device may send, to the terminal device by using radio resource control (radio resource control, RRC) signaling, information including the encoding code rate. For another example, the network device may send, to the terminal device by using downlink control information (downlink control information, DCI), information including the encoding code rate; or the network device may deliver, to the terminal device in a broadcast manner, information including the encoding code rate. This is not limited in embodiments of this application.

In this embodiment of this application, the element 2 in the $1^{st}$ column of the check part in the second base matrix and the element 1 in the $2^{nd}$ column are located in the same row, and the quantity of elements 1 in the $2^{nd}$ column is less than or equal to the quantity of elements 2 in the $1^{st}$ column. A combination of the two columns can effectively improve decoding performance and reduce a decoding threshold. LDPC encoding and LDPC decoding are performed by using the check matrix provided in this embodiment of this application, so that decoding performance in a scenario with a biased source can be effectively improved.

The following describes the second base matrix, the first base matrix, and the check matrix in this embodiment of this application.

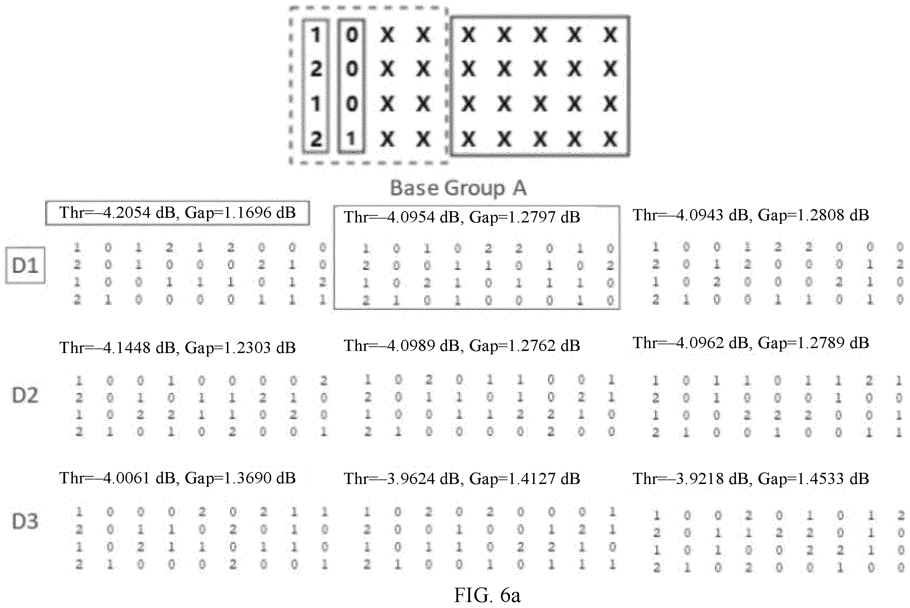

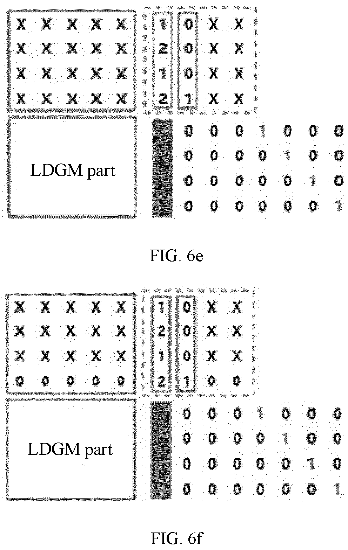

In a possible implementation of this application, the second base matrix may be in two forms. One form corresponds to a case in which the sparsity of the first bit sequence is less than or equal to a first threshold, as shown in FIG. 6a to FIG. 6d, FIG. 7a to FIG. 7d, or FIG. 8a to FIG. 8c below. The other form may correspond to a case in which the sparsity of the first bit sequence is greater than a first threshold, as shown in FIG. 6e, FIG. 6f, FIG. 7e, FIG. 7f, and FIG. 8d below. In this embodiment of this application, a sparser source indicates a larger code rate, and the first threshold is determined based on a relationship between the source sparsity and the code rate. For example, the first threshold may be equal to 0.05, the first threshold may be equal to 0.11, or the first threshold may be equal to 0.3. It is clear that the first threshold listed herein is merely an example. For example, the first threshold may alternatively be a value floating around 0.05, for example, 0.06 or 0.04. For another example, the first threshold may alternatively be a value floating around 0.11, for example, 0.10 or 0.12. For another example, the first threshold may alternatively be a value floating around 0.3, for example, 0.31, 0.29, or 0.32. For example, when the first threshold is equal to 0.05, it indicates that a code rate change is minor when the sparsity of the first bit sequence is less than or equal to 0.05. Alternatively, there is a large difference between a code rate obtained when the sparsity of the first bit sequence is less than or equal to 0.05 and a code rate obtained when the sparsity of the first bit sequence is greater than 0.05. 0.05, 0.11, and 0.3 listed above may also be understood as three sparsities corresponding to three typical code rates in a change interval of the code rate.

Implementation 1 shown below may be understood as a second base matrix, a first base matrix, and a check matrix that are shown when the first threshold is equal to 0.05, Implementation 2 may be understood as a second base matrix, a first base matrix, and a check matrix that are shown when the first threshold is equal to 0.11, and Implementation 3 may be understood as a second base matrix, a first base matrix, and a check matrix that are shown when the first threshold is equal to 0.3.

Implementation 1:

In this embodiment of this application, an example in which the $1^{st}$ column of the check part in the second base matrix is $[1\ 2\ 1\ 2]^T$ is used. The $1^{st}$ column is specifically selected by eliminating the compromise between the decoding threshold and the trapping set (which may also be referred to as a loop trapping set). In addition, $[1\ 2\ 1\ 2]^T$ is compared with the following two columns: $[1\ 2\ 2\ 2]^T$ and $[1\ 1\ 1\ 2]^T$. It is found through comparison that the second base matrix used when the $1^{st}$ column of the check part is $[1\ 2\ 1\ 2]^T$ can be used to eliminate the compromise between the decoding performance and the trapping set. The column weight of the $2^{nd}$ column of the check part in the second base matrix is 1. For example, the $2^{nd}$ column may be $[0\ 0\ 0\ 1]^T$. A combination of the $2^{nd}$ column. and the $1^{st}$ column. can achieve an extremely low decoding threshold, and the encoding and decoding complexity can be greatly reduced.

It should be noted that 1 in the $2^{nd}$ column may be located at any location in the column, but a row in which 1 in the $1^{st}$ column is located and 2 in the $1^{st}$ column are located in the same row. Alternatively, this may be understood as that 1 in the column whose degree is 1 needs to be connected to 2 in the state column or located in a same row as 2 in the state column. It may be understood that, with reference to the descriptions of the condition 5 in FIG. 5, because column permutation or row permutation performed on the second base matrix does not affect the decoding performance, the $1^{st}$ column and the $2^{nd}$ column are merely examples, and should not be construed as a limitation on embodiments of this application.

In an example, when the first threshold is equal to 0.05, the following two base matrix groups are provided based on the degree of design freedom and the encoding complexity: a base matrix group A (base group A) and a base matrix group B (base group B). It may be understood that both the base matrix group A and the base matrix group B may be understood as second base matrices. The base matrix group A may be understood as that a degree of freedom is higher during design of the base matrix, and a better decoding threshold or better decoding performance can be obtained. The base matrix group B may be understood as that a degree of freedom is slightly low during design of the base matrix, but encoding and decoding complexity is low, and especially, complexity on an encoding side is lower. For example, when the base matrix group A is used for encoding, inversion needs to be performed on some 4*4 square matrices for the check part in the base matrix. When the base matrix group B is used for encoding, inversion needs to be performed on some 3 *3 square matrices for the check part in the base matrix. Then, a check bit corresponding to a column whose column weight is 1 is calculated.

According to the foregoing constraint condition C2, to optimize the decoding performance of the designed base matrix in a case of a medium or short code, a density of the base matrix is further constrained. That is, a maximum row weight and a maximum column weight are controlled. This embodiment of this application provides three independently designed density regions. A density refers to an x part in the base matrix shown below. C3R7 means that a maximum column weight of the x part in the base matrix does not exceed 3, and a maximum row weight of the x part does not exceed 7. A matrix density region is roughly divided into the following D1 to D3: D1 (C3R7, C3R6), D2 (C4R8, C4R7), and D3 (C5R9, C5R8, C5R7). It may be understood that D1, D2, and D3 may be understood as different base matrices at a same code rate.

It should be noted that the threshold (Thr) in this embodiment of this application may be understood as a decoding threshold corresponding to a corresponding code rate of the base matrix. The decoding threshold refers to minimum Eb/N0 required for successful decoding of a 3C-P-LDPC code corresponding to the base matrix when the code length is infinite. A gap (Gap) refers to a distance (represented by dB) between the decoding threshold and Eb/N0 corresponding to a channel capacity at the corresponding code rate.

In an example, the second base matrix (which may also be referred to as a base matrix group A) includes the following matrix with four rows and nine columns:

$$\begin{array}{ccccccccc} 1 & 0 & x & x & x & x & x & x & x \\ 2 & 0 & x & x & x & x & x & x & x \\ 1 & 0 & x & x & x & x & x & x & x \\ 2 & 1 & x & x & x & x & x & x & x. \end{array}$$

x represents any one of the following: 0, 1, and 2, the first four columns of the second base matrix are the check part in the second base matrix, and a 5th column to a 9th column of the second base matrix are the information part in the second base matrix. It may be understood that the first four columns of the second base matrix may also be referred to as the check part in the check matrix or the check part in the first base matrix, and the last five columns of the second base matrix are the information part in the check matrix or the information part in the first base matrix. After a value of x in the matrix is fixed, a matrix obtained through at least one of a row permutation operation or a column permutation operation performed on the base matrix group A may still be considered as the base matrix group A.

FIG. 6a is a diagram of a base matrix group A according to an embodiment of this application. FIG. 6a shows different second base matrices, and shows decoding thresholds (Thr) and gaps (Gap) that correspond to the second base matrices. It can be learned from Thr and Gap shown in FIG. 6a that a 1st second base matrix in D1 may be understood as a base matrix with an optimal decoding threshold obtained through optimization under a corresponding condition. Although the 1st second base matrix in D1 is a base matrix with a lowest decoding threshold, during actual application, the two communication parties may further select a second base matrix with reference to another factor (for example, a factor graph and an interval). It may be understood that dimensions of all the second base matrices shown in FIG. 6a are four rows and nine columns, and only one second base matrix is circled as an example in FIG. 6a.

In another example, the second base matrix (which may also be referred to as a base matrix group A) includes the following matrix with four rows and nine columns:

$$\begin{array}{ccccccccc} x & x & x & x & x & 1 & 0 & x & x \\ x & x & x & x & x & 2 & 0 & x & x \\ x & x & x & x & x & 1 & 0 & x & x \\ x & x & x & x & x & 2 & 1 & x & x. \end{array}$$

x represents any one of the following: 0, 1, and 2, the first five columns of the second base matrix are the information part in the second base matrix, and a 6th column to a 9th column of the second base matrix are the check part in the second base matrix.

It can be learned from the second base matrix shown above that an arrangement sequence of the check part and the information part is not limited in embodiments of this application. FIG. 6a shows only an example in which the check part is arranged before the information part. For an example in which the check part is arranged after the information part, refer to FIG. 6a. Details are not described herein. Descriptions of a sequence of the check part and the information part are also applicable to Implementation 2 and Implementation 3 shown below. Details are not described below again.

In still another example, the second base matrix (which may also be referred to as a base matrix group B) includes the following matrix with four rows and nine columns:

$$\begin{array}{ccccccccc} 1 & 0 & x & x & x & x & x & x & x \\ 2 & 0 & x & x & x & x & x & x & x \\ 1 & 0 & x & x & x & x & x & x & x \\ 2 & 1 & 0 & 0 & 0 & 0 & 0 & 0 & 0. \end{array}$$

x represents any one of the following: 0, 1, and 2, the first four columns of the second base matrix are the check part in the second base matrix, and a 5th column to a 9th column of the second base matrix are the information part in the second base matrix.

In still another example, the second base matrix (which may also be referred to as a base matrix group B) includes the following matrix with four rows and nine columns:

$$x \quad x \quad x \quad x \quad x \quad 1 \quad 0 \quad x \quad x$$
$$x \quad x \quad x \quad x \quad x \quad 2 \quad 0 \quad x \quad x$$
$$x \quad x \quad x \quad x \quad x \quad 1 \quad 0 \quad x \quad x$$
$$0 \quad 0 \quad 0 \quad 0 \quad 0 \quad 2 \quad 1 \quad 0 \quad 0.$$

x represents any one of the following: 0, 1, and 2, the first five columns of the second base matrix are the information part, and a 6th column to a 9th column of the second base matrix are the check part.

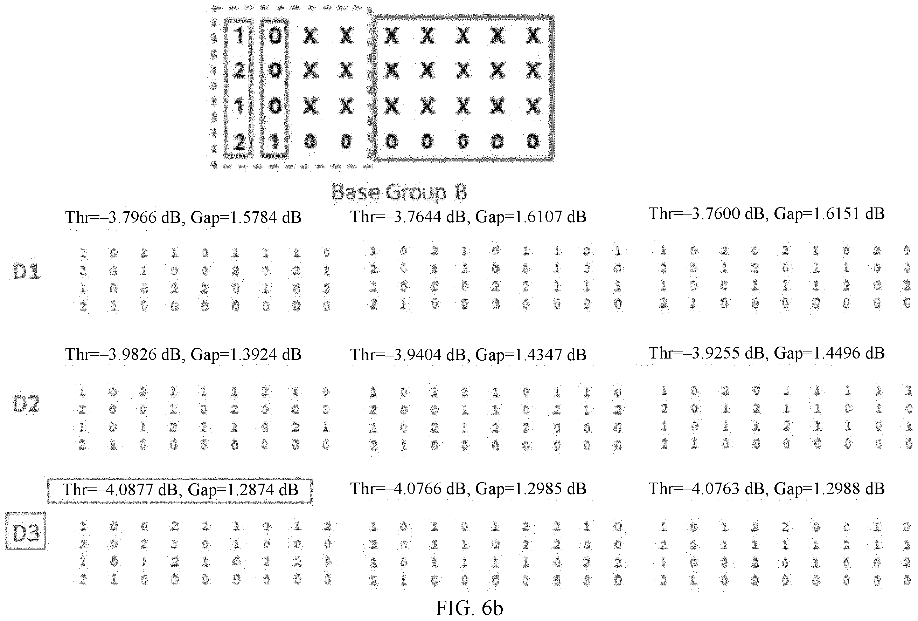

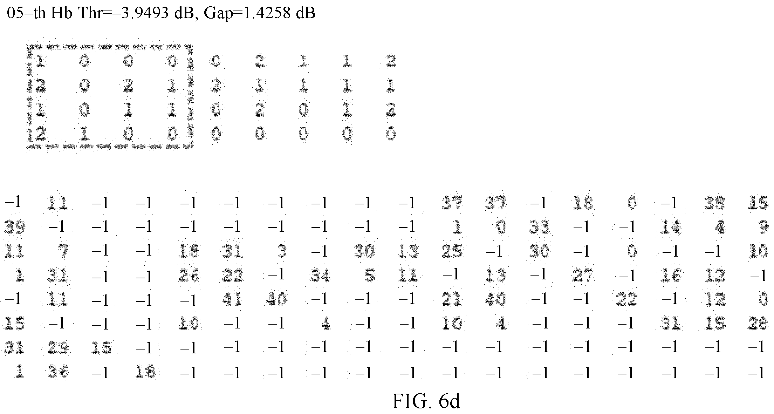

FIG. 6b is a diagram of a base matrix group B according to an embodiment of this application. FIG. 6b shows different second base matrices, and shows decoding thresholds (Thr) and gaps (Gap) that correspond to the second base matrices. It can be learned from Thr and Gap shown in FIG. 6b that a 1st second base matrix in D3 may be understood as a base matrix with an optimal decoding threshold obtained through optimization under a corresponding condition. Although the 1st second base matrix in D3 is a base matrix with a lowest decoding threshold, during actual application, the two communication parties may further select a second base matrix with reference to another factor (for example, a factor graph and an interval). In addition to the base matrix shown in FIG. 6b, the base matrix group B may further include a base matrix shown in FIG. 6d. It may be understood that dimensions of all the second base matrices shown in FIG. 6b are four rows and nine columns.

A difference between the base matrix group A and the base matrix group B lies in whether all rows in a last row, except a 1st column and a 2nd column of the check part, are 0. Values of the columns in the last row, except the 1st column and the 2nd column of the check part, are constrained, so that a base matrix obtained through optimization can achieve a tradeoff (tradeoff) between decoding performance and implementation complexity.

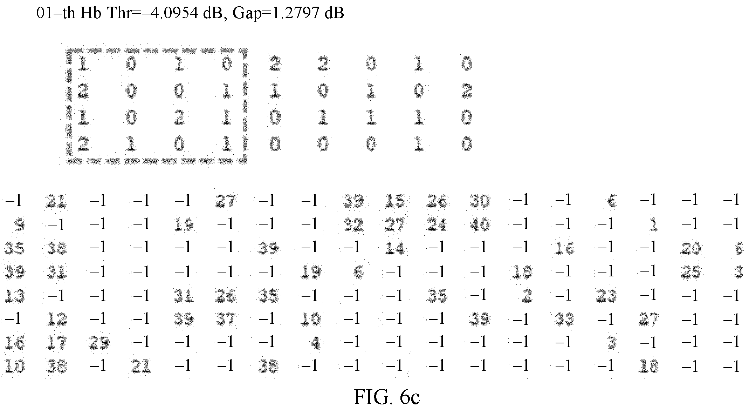

FIG. 6c is a diagram of a check matrix according to an embodiment of this application. An upper part of FIG. 6c shows a second base matrix whose dimensions are four rows and nine columns. With reference to at least one of the foregoing condition 7, condition 8, and condition 9, when n=2, based on the foregoing formula (1) and formula (3), the first base matrix may include the following matrix with eight rows and 18 columns:

$$1\,0 \quad 0\,0 \quad 1\,0 \quad 0\,0 \quad 1\,1 \quad 1\,1 \quad 0\,0 \quad 1\,0 \quad 0\,0$$
$$0\,1 \quad 0\,0 \quad 0\,1 \quad 0\,0 \quad 1\,1 \quad 1\,1 \quad 0\,0 \quad 0\,1 \quad 0\,0$$
$$1\,1 \quad 0\,0 \quad 0\,0 \quad 1\,0 \quad 1\,0 \quad 0\,0 \quad 1\,0 \quad 0\,0 \quad 1\,1$$
$$1\,1 \quad 0\,0 \quad 0\,0 \quad 0\,1 \quad 0\,1 \quad 0\,0 \quad 0\,1 \quad 0\,0 \quad 1\,1$$
$$1\,0 \quad 0\,0 \quad 1\,1 \quad 1\,0 \quad 0\,0 \quad 1\,0 \quad 1\,0 \quad 1\,0 \quad 0\,0$$
$$0\,1 \quad 0\,0 \quad 1\,1 \quad 0\,1 \quad 0\,0 \quad 0\,1 \quad 0\,1 \quad 0\,1 \quad 0\,0$$
$$1\,1 \quad 1\,0 \quad 0\,0 \quad 1\,0 \quad 0\,0 \quad 0\,0 \quad 0\,0 \quad 1\,0 \quad 0\,0$$
$$1\,1 \quad 0\,1 \quad 0\,0 \quad 0\,1 \quad 0\,0 \quad 0\,0 \quad 0\,0 \quad 0\,1 \quad 0\,0.$$

Alternatively, based on the foregoing formula (2) and formula (3), the first base matrix may include the following matrix with eight rows and 18 columns:

$$0\,1 \quad 0\,0 \quad 0\,1 \quad 0\,0 \quad 1\,1 \quad 1\,1 \quad 0\,0 \quad 0\,1 \quad 0\,0$$
$$1\,0 \quad 0\,0 \quad 1\,0 \quad 0\,0 \quad 1\,1 \quad 1\,1 \quad 0\,0 \quad 1\,0 \quad 0\,0$$
$$1\,1 \quad 0\,0 \quad 0\,0 \quad 0\,1 \quad 0\,1 \quad 0\,0 \quad 0\,1 \quad 0\,0 \quad 1\,1$$
$$1\,1 \quad 0\,0 \quad 0\,0 \quad 1\,0 \quad 1\,0 \quad 0\,0 \quad 1\,0 \quad 0\,0 \quad 1\,1$$
$$0\,1 \quad 0\,0 \quad 1\,1 \quad 0\,1 \quad 0\,0 \quad 0\,1 \quad 0\,1 \quad 0\,1 \quad 0\,0$$
$$1\,0 \quad 0\,0 \quad 1\,1 \quad 1\,0 \quad 0\,0 \quad 1\,0 \quad 1\,0 \quad 1\,0 \quad 0\,0$$
$$1\,1 \quad 0\,1 \quad 0\,0 \quad 0\,1 \quad 0\,0 \quad 0\,0 \quad 0\,0 \quad 0\,1 \quad 0\,0$$
$$1\,1 \quad 1\,0 \quad 0\,0 \quad 1\,0 \quad 0\,0 \quad 0\,0 \quad 0\,0 \quad 1\,0 \quad 0\,0.$$

When expansion is performed by using the foregoing formula (1) and formula (3), or by using the foregoing formula (2) and formula (3), an expansion manner is simple.

It may be understood that the first base matrix shown above is merely an example. Alternatively, some elements 1 in the second base matrix may be expanded to the formula (1), and the other elements 1 may be expanded to the formula (2). For example, the first base matrix may alternatively include the following matrix with eight rows and 18 columns:

$$
\begin{array}{ccccccccc}
01 & 00 & 01 & 00 & 11 & 11 & 00 & 10 & 00 \\
10 & 00 & 10 & 00 & 11 & 11 & 00 & 01 & 00 \\
11 & 00 & 00 & 10 & 01 & 00 & 01 & 00 & 11 \\
11 & 00 & 00 & 01 & 10 & 00 & 10 & 00 & 11 \\
10 & 00 & 11 & 10 & 00 & 10 & 10 & 10 & 00 \\
01 & 00 & 11 & 01 & 00 & 01 & 01 & 01 & 00 \\
11 & 10 & 00 & 01 & 00 & 00 & 00 & 10 & 00 \\
11 & 01 & 00 & 10 & 00 & 00 & 00 & 01 & 00.
\end{array}
$$

In a combination manner, some elements 1 in the second base matrix are expanded to the formula (1), and the other elements 1 are expanded to the formula (2), so that a structure of the first base matrix obtained through expansion is more stable, and performance is better.

It may be understood that the foregoing first base matrix is shown by using n=2 as an example, and cases in which n=3, n=4, n=5, and the like are not shown one by one. n=2 should not be construed as a limitation on embodiments of this application. First base matrices obtained by expanding the second base matrix shown in FIG. 6c are not listed one by one.

A lower part of FIG. 6c shows a check matrix. In the check matrix, -1 represents a Z*Z all-zero matrix, 0 represents a Z*Z identity matrix, a non-zero element represents a Z*Z CPM, and Z represents a lifting factor used when the first base matrix is expanded to obtain the check matrix. FIG. 6c is shown by using an example in which Z=42, but the example should not be construed as a limitation on embodiments of this application. A value of the lifting factor may be determined based on a code length, and specific values of the lifting factor are not listed one by one herein. It may be understood that FIG. 6c is shown by using an example in which dimensions of the check matrix are eight rows and 18 columns. During actual application, the check matrix may alternatively be expanded to a matrix with more rows and more columns. During actual application, a check matrix corresponding to a trapping set that has little impact on performance may be selected as a check matrix for performing LDPC encoding or decoding. That is, the check matrix may be selected based on impact of the trapping set. The descriptions are also applicable to FIG. 6d.

FIG. 6d is a diagram of a check matrix according to an embodiment of this application. For example, the first base matrix may include the following matrix with eight rows and 18 columns:

$$
\begin{array}{ccccccccc}
10 & 00 & 00 & 00 & 00 & 11 & 10 & 10 & 11 \\
01 & 00 & 00 & 00 & 00 & 11 & 01 & 01 & 11 \\
11 & 00 & 11 & 10 & 11 & 10 & 10 & 10 & 10 \\
11 & 00 & 11 & 01 & 11 & 01 & 01 & 01 & 01 \\
10 & 00 & 10 & 10 & 00 & 11 & 00 & 10 & 11 \\
01 & 00 & 01 & 01 & 00 & 11 & 00 & 01 & 11 \\
11 & 10 & 00 & 00 & 00 & 00 & 00 & 00 & 00 \\
11 & 01 & 00 & 00 & 00 & 00 & 00 & 00 & 00.
\end{array}
$$

Alternatively, the first base matrix may include the following matrix with eight rows and 18 columns:

$$01 \quad 00 \quad 00 \quad 00 \quad 00 \quad 11 \quad 01 \quad 01 \quad 11$$
$$10 \quad 00 \quad 00 \quad 00 \quad 00 \quad 11 \quad 10 \quad 10 \quad 11$$
$$11 \quad 00 \quad 11 \quad 01 \quad 11 \quad 01 \quad 01 \quad 01 \quad 01$$
$$11 \quad 00 \quad 11 \quad 10 \quad 11 \quad 10 \quad 10 \quad 10 \quad 10$$
$$01 \quad 00 \quad 01 \quad 01 \quad 00 \quad 11 \quad 00 \quad 01 \quad 11$$
$$10 \quad 00 \quad 10 \quad 10 \quad 00 \quad 11 \quad 00 \quad 10 \quad 11$$
$$11 \quad 01 \quad 00 \quad 00 \quad 00 \quad 00 \quad 00 \quad 00 \quad 00$$
$$11 \quad 10 \quad 00 \quad 00 \quad 00 \quad 00 \quad 00 \quad 00 \quad 00.$$

Alternatively, the first base matrix may include the following matrix with eight rows and 18 columns:

$$01 \quad 00 \quad 00 \quad 00 \quad 00 \quad 11 \quad 01 \quad 10 \quad 11$$
$$10 \quad 00 \quad 00 \quad 00 \quad 00 \quad 11 \quad 10 \quad 01 \quad 11$$
$$11 \quad 00 \quad 11 \quad 10 \quad 11 \quad 10 \quad 10 \quad 10 \quad 01$$
$$11 \quad 00 \quad 11 \quad 01 \quad 11 \quad 01 \quad 01 \quad 01 \quad 10$$
$$01 \quad 00 \quad 01 \quad 10 \quad 00 \quad 11 \quad 00 \quad 10 \quad 11$$
$$10 \quad 00 \quad 10 \quad 01 \quad 00 \quad 11 \quad 00 \quad 01 \quad 11$$
$$11 \quad 10 \quad 00 \quad 00 \quad 00 \quad 00 \quad 00 \quad 00 \quad 00$$
$$11 \quad 01 \quad 00 \quad 00 \quad 00 \quad 00 \quad 00 \quad 00 \quad 00.$$

First base matrices obtained by expanding the second base matrix shown in FIG. 6d are not listed one by one. For specific descriptions of an expansion manner, refer to the descriptions of FIG. 6c. Details are not described herein again.

A lower part of FIG. 6d shows a check matrix. In the check matrix, -1 represents a Z*Z all-zero matrix, 0 represents a Z*Z identity matrix, a non-zero element represents a Z*Z CPM, and Z represents a lifting factor used when the first base matrix is expanded to obtain the check matrix. FIG. 6d is shown by using an example in which Z=42, but the example should not be construed as a limitation on embodiments of this application. A value of the lifting factor may be determined based on a code length, and specific values of the lifting factor are not listed one by one herein.

It may be understood that, for a manner of obtaining the first base matrix based on the second base matrix shown by an upper part of FIG. 6d, refer to FIG. 5 or FIG. 6c. Details are not described herein again.

FIG. 6a to FIG. 6d are shown when the sparsity of the first bit sequence is less than or equal to 0.05. To be specific, both the base matrix group A and the base matrix group B are applicable to a case in which the source sparsity is less than or equal to 0.05, and all information bits may be punctured, or some information bits are punctured.

In a possible implementation, to enable the base matrix group A and the base matrix group B to adapt to a wider range of source sparsities, the following expansion design is further performed in this embodiment of this application, and the second base matrix is shown as follows:

$$\begin{bmatrix} A & B \\ C & D \end{bmatrix}.$$

A represents an information part in the second base matrix, B represents a check part in the second base matrix, C is a matrix determined based on the code rate and the sparsity of the first bit sequence, a 1st column in D is a punctured column, and a remaining part other than the 1st column in D is obtained based on an identity matrix. For example, for A, refer to the information part shown in FIG. 6a to FIG. 6d, and for B, refer to the check part shown in FIG. 6a to FIG. 6d. C may be a low-density generator matrix (low-density generator matrix, LDGM) determined based on the code rate and the source sparsity. Elements in a 2nd column to a 4th column in D may all be 0, and a part other than the first four columns in D may be an identity matrix. FIG. 6e shows a similar expansion manner of a base matrix group A according to an embodiment of this application, and FIG. 6f shows a similar expansion manner of a base matrix group B according to an embodiment of this application. FIG. 6e may be understood as a raptor (raptor)-like expansion of the base matrix group A, and FIG. 6f may be understood as a raptor-like expansion of the base matrix group B. For a specific value of an x part in FIG. 6e, refer to related descriptions in FIG. 6a and FIG. 6c. For a specific value of an x part in FIG. 6f, refer to related descriptions in FIG. 6b and FIG. 6d. LDGM parts in FIG. 6e and FIG. 6f may be designed based on a required code rate and source sparsity. This is not limited in embodiments of this application. Shadow parts in FIG. 6e and FIG. 6f are a 1st column in D, and correspond to a state column (or a punctured column). The 1st column in D may include the following elements: 1 and 2 (where this may also be understood as that a minimum value of an element in the 1st column in D is 1). For example, the 1st column in D may be $[1\ 2\ 1\ 2...]^T$, $[1\ 1\ 1\ 1...]^T$, or $[1\ 2\ 1\ 2...\ 1\ 1\ 1\ 1...]^T$. For example, when a quantity of rows in D is 4, the 1st column in D may be $[1\ 2\ 1\ 2]^T$; $[1\ 1\ 1\ 1]^T$, or $[1\ 2\ 1\ 1]^T$. For another example, when a quantity of rows in D is 6, the 1st column in D may be $[1\ 2\ 1\ 2\ 1\ 2]^T$; $[1\ 1\ 1\ 1\ 1\ 1]^T$, $[1\ 2\ 1\ 1\ 1\ 1]^T$, or $[1\ 2\ 1\ 2\ 1\ 1]^T$. Examples are not listed one by one herein. Four-row and four-column identity matrices shown in FIG. 6e and FIG. 6f are merely examples, and a size of the identity matrix may be determined based on the LDGM part.

It may be understood that base matrices shown in FIG. 6e and FIG. 6f are applicable to a case in which the source sparsity is greater than or equal to 0.05. For example, the source sparsity is greater than 0.05 and less than 0.11. Examples are not listed one by one herein.

It may be understood that, when the source sparsity is equal to 0.05, the two communication parties may use the second base matrix, the first base matrix, and the check matrix shown in Implementation 1, or the two communication parties may use the second base matrix, the first base matrix, and the check matrix shown in Implementation 2. A specific matrix used when the source sparsity is at a critical point is not limited in embodiments of this application. Similarly, when the source sparsity is equal to 0.11, the two communication parties may use the matrices shown in Implementation 2, or may use the matrices shown in Implementation 3.

Implementation 2:

In this embodiment of this application, the 2nd column of the check part in the second base matrix is $[1\ 2\ 1\ 2]^T$; and the 1st column of the check part is $[0\ 0\ 0\ 1]^T$. For descriptions of the 1st column and the 2nd column, refer to related descriptions in Implementation 1. Details are not described herein again.

For example, when the first threshold is equal to 0.11, the following two base matrix groups are provided based on the degree of freedom and the encoding complexity: a base matrix group A and a base matrix group B. For descriptions of the base matrix group A and the base matrix group B, refer to related descriptions in Implementation 1 (for example, refer to descriptions of the degrees of freedom, decoding thresholds, and complexity of the base matrix group A and the base matrix group B in Implementation 1; for another example, refer to descriptions of the difference between the base matrix group A and the base matrix group B in Implementation 1). Details are not described herein again.

According to the foregoing constraint condition C2, to optimize the decoding performance of the designed base matrix in a case of a medium or short code, a density of the base matrix needs to be further constrained. That is, a maximum row weight and a maximum column weight need to be controlled. This embodiment of this application provides three independently designed density regions. A density refers to an x part in the following base matrix. C3R7 means that a maximum column weight of the x part in the base matrix does not exceed 3, and a maximum row weight of the x part does not exceed 7. A matrix density region is roughly divided into the following D1 to D3: D1 (C3R5, C3R4), D2 (C4R5, C4R4), and D3 (C5R6, C5R5). For descriptions of Thr, Gap, and D1 to D3 in this embodiment of this application, refer to Implementation 1. Details are not described herein again.

In an example, the second base matrix (which may also be referred to as a base matrix group A) includes the following matrix with four rows and seven columns:

$$\begin{matrix} 1 & 0 & x & x & x & x & x \\ 2 & 0 & x & x & x & x & x \\ 1 & 0 & x & x & x & x & x \\ 2 & 1 & x & x & x & x & x. \end{matrix}$$

x represents any one of the following: 0, 1, and 2, the first four columns of the second base matrix are the check part in the second base matrix, and a 5th column to a 7th column of the second base matrix are the information part in the second base matrix. It may be understood that the first four columns of the second base matrix may also be referred to as the check part in the check matrix or the check part in the first base matrix, and the last three columns of the second base matrix are the information part in the check matrix or the information part in the first base matrix. After a value of x in the matrix is fixed, a matrix obtained through at least one of a row permutation operation or a column permutation operation performed on the base matrix group A may still be considered as the base matrix group A.

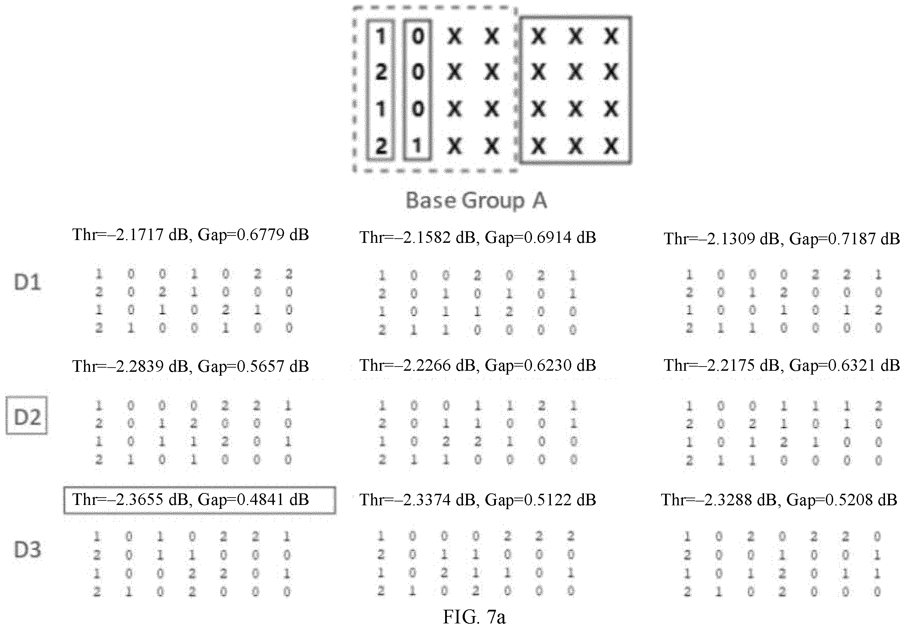

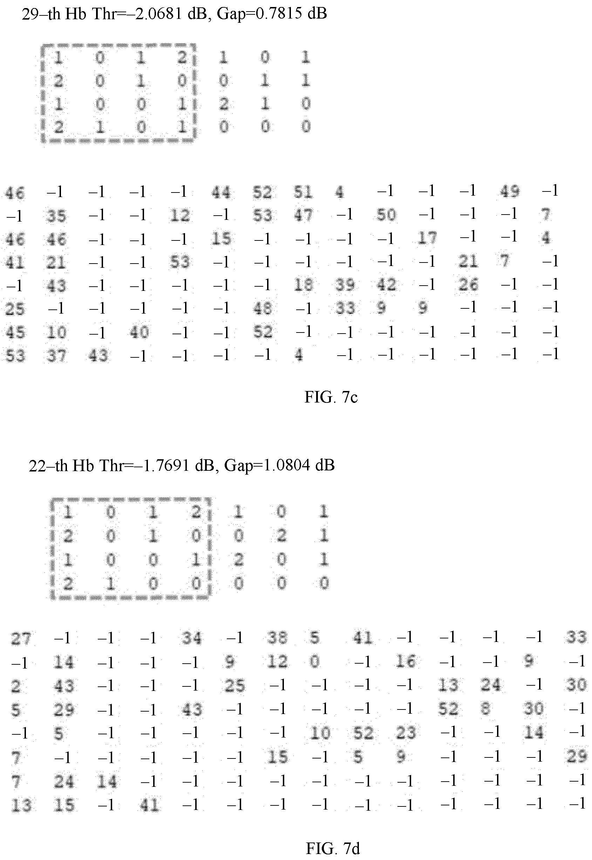

FIG. 7a is a diagram of a base matrix group A according to an embodiment of this application. FIG. 7a shows different second base matrices, and shows decoding thresholds (Thr) and gaps (Gap) that correspond to the second base matrices. It can be learned from Thr and Gap shown in FIG. 7a that a 1st second base matrix in D3 may be understood as a base matrix with an optimal decoding threshold obtained through optimization under a corresponding condition. In addition to the base matrix shown in FIG. 7a, the base matrix group A may further include a base matrix shown in FIG. 7c.

In another example, the second base matrix (which may also be referred to as a base matrix group A) includes the following matrix with four rows and seven columns:

$$
\begin{array}{ccccccc}
x & x & x & 1 & 0 & x & x \\
x & x & x & 2 & 0 & x & x \\
x & x & x & 1 & 0 & x & x \\
x & x & x & 2 & 1 & x & x.
\end{array}
$$

x represents any one of the following: 0, 1, and 2, the first three columns of the second base matrix are the information part in the second base matrix, and a $4^{th}$ column to a $7^{th}$ column of the second base matrix are the check part in the second base matrix.

In still another example, the second base matrix (which may also be referred to as a base matrix group B) includes the following matrix with four rows and seven columns:

$$
\begin{array}{ccccccc}
1 & 0 & x & x & x & x & x \\
2 & 0 & x & x & x & x & x \\
1 & 0 & x & x & x & x & x \\
2 & 1 & 0 & 0 & 0 & 0 & 0.
\end{array}
$$

x represents any one of the following: 0, 1, and 2, the first four columns of the second base matrix are the check part in the second base matrix, and a $5^{th}$ column to a $7^{th}$ column of the second base matrix are the information part in the second base matrix.

In still another example, the second base matrix (which may also be referred to as a base matrix group B) includes the following matrix with four rows and seven columns:

$$
\begin{array}{ccccccc}
x & x & x & 1 & 0 & x & x \\
x & x & x & 2 & 0 & x & x \\
x & x & x & 1 & 0 & x & x \\
0 & 0 & 0 & 2 & 1 & 0 & 0.
\end{array}
$$

x represents any one of the following: 0, 1, and 2, the first three columns of the second base matrix are the information part in the second base matrix, and a $4^{th}$ column to a $7^{th}$ column of the second base matrix are the check part in the second base matrix.

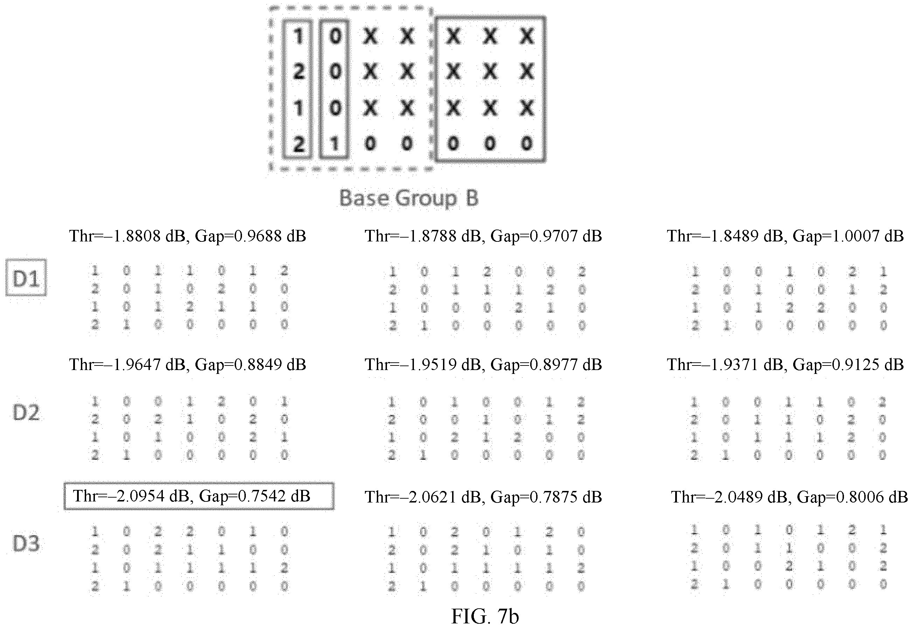

FIG. 7b is a diagram of a base matrix group B according to an embodiment of this application. FIG. 7b shows different second base matrices, and shows decoding thresholds (Thr) and gaps (Gap) that correspond to the second base matrices. It can be learned from Thr and Gap shown in FIG. 7b that a $1^{st}$ second base matrix in D3 may be understood as a base matrix with an optimal decoding threshold obtained through optimization under a corresponding condition. In addition to the base matrix shown in FIG. 7b, the base matrix group B may further include a base matrix shown in FIG. 7d.

FIG. 7c is a diagram of a check matrix according to an embodiment of this application. An upper part of FIG. 7c shows a second base matrix. With reference to at least one of the foregoing condition 7, condition 8, and condition 9, when n=2, based on the foregoing formula (1) and formula (3), the first base matrix may include the following matrix with eight rows and 14 columns:

$$10 \quad 00 \quad 10 \quad 11 \quad 10 \quad 00 \quad 10$$
$$01 \quad 00 \quad 01 \quad 11 \quad 01 \quad 00 \quad 01$$
$$11 \quad 00 \quad 10 \quad 00 \quad 00 \quad 10 \quad 10$$
$$11 \quad 00 \quad 01 \quad 00 \quad 00 \quad 01 \quad 01$$
$$10 \quad 00 \quad 00 \quad 10 \quad 11 \quad 10 \quad 00$$
$$01 \quad 00 \quad 00 \quad 01 \quad 11 \quad 01 \quad 00$$
$$11 \quad 10 \quad 00 \quad 10 \quad 00 \quad 00 \quad 00$$
$$11 \quad 01 \quad 00 \quad 01 \quad 00 \quad 00 \quad 00.$$

Alternatively, based on the foregoing formula (2) and formula (3), the first base matrix may include the following matrix with eight rows and 14 columns:

$$01 \quad 00 \quad 01 \quad 11 \quad 01 \quad 00 \quad 01$$
$$10 \quad 00 \quad 10 \quad 11 \quad 10 \quad 00 \quad 10$$
$$11 \quad 00 \quad 01 \quad 00 \quad 00 \quad 01 \quad 01$$
$$11 \quad 00 \quad 10 \quad 00 \quad 00 \quad 10 \quad 10$$
$$01 \quad 00 \quad 00 \quad 01 \quad 11 \quad 01 \quad 00$$
$$10 \quad 00 \quad 00 \quad 10 \quad 11 \quad 10 \quad 00$$
$$11 \quad 01 \quad 00 \quad 01 \quad 00 \quad 00 \quad 00$$
$$11 \quad 10 \quad 00 \quad 10 \quad 00 \quad 00 \quad 00.$$

It may be understood that the first base matrix shown above is merely an example. Alternatively, some elements 1 in the second base matrix may be expanded to the formula (1), and the other elements 1 may be expanded to the formula (2). For example, the first base matrix may further include the following matrix with eight rows and 14 columns:

$$10 \quad 00 \quad 01 \quad 11 \quad 10 \quad 00 \quad 10$$
$$01 \quad 00 \quad 10 \quad 11 \quad 01 \quad 00 \quad 01$$
$$11 \quad 00 \quad 01 \quad 00 \quad 00 \quad 10 \quad 01$$
$$11 \quad 00 \quad 10 \quad 00 \quad 00 \quad 01 \quad 10$$
$$01 \quad 00 \quad 00 \quad 01 \quad 11 \quad 01 \quad 00$$
$$10 \quad 00 \quad 00 \quad 10 \quad 11 \quad 10 \quad 00$$
$$11 \quad 01 \quad 00 \quad 10 \quad 00 \quad 00 \quad 00$$
$$11 \quad 10 \quad 00 \quad 01 \quad 00 \quad 00 \quad 00.$$

It may be understood that the foregoing first base matrix is shown by using n=2 as an example, and cases in which n=3, n=4, n=5, and the like are not shown one by one. n=2 should not be construed as a limitation on embodiments of this application. First base matrices obtained by expanding the second base matrix shown in FIG. 7c are not listed one by one.

A lower part of FIG. 7c shows a check matrix. In the check matrix, -1 represents a Z*Z all-zero matrix, 0 represents a Z*Z identity matrix, a non-zero element represents a Z*Z CPM, and Z represents a lifting factor used when the first base matrix is expanded to obtain the check matrix. FIG. 7c is shown by using an example in which Z=56, but the example should not be construed as a limitation on embodiments of this application. For a manner of obtaining the check matrix by using the first base matrix, refer to a related standard or protocol. Details are not described herein again.

FIG. 7d is a diagram of a check matrix according to an embodiment of this application. For example, the first base matrix may include the following matrix with eight rows and 14 columns:

$$10 \quad 00 \quad 10 \quad 11 \quad 10 \quad 00 \quad 10$$
$$01 \quad 00 \quad 01 \quad 11 \quad 01 \quad 00 \quad 01$$
$$11 \quad 00 \quad 10 \quad 00 \quad 00 \quad 11 \quad 10$$
$$11 \quad 00 \quad 01 \quad 00 \quad 00 \quad 11 \quad 01$$
$$10 \quad 00 \quad 00 \quad 10 \quad 11 \quad 00 \quad 10$$
$$01 \quad 00 \quad 00 \quad 01 \quad 11 \quad 00 \quad 01$$
$$11 \quad 10 \quad 00 \quad 00 \quad 00 \quad 00 \quad 00$$
$$11 \quad 01 \quad 00 \quad 00 \quad 00 \quad 00 \quad 00.$$

Alternatively, the first base matrix may include the following matrix with eight rows and 14 columns:

$$10 \quad 00 \quad 10 \quad 11 \quad 10 \quad 00 \quad 10$$
$$01 \quad 00 \quad 01 \quad 11 \quad 01 \quad 00 \quad 01$$
$$11 \quad 00 \quad 10 \quad 00 \quad 00 \quad 11 \quad 10$$
$$11 \quad 00 \quad 01 \quad 00 \quad 00 \quad 11 \quad 01$$
$$10 \quad 00 \quad 00 \quad 10 \quad 11 \quad 00 \quad 10$$
$$01 \quad 00 \quad 00 \quad 01 \quad 11 \quad 00 \quad 01$$
$$11 \quad 10 \quad 00 \quad 00 \quad 00 \quad 00 \quad 00$$
$$11 \quad 01 \quad 00 \quad 00 \quad 00 \quad 00 \quad 00.$$

Alternatively, the first base matrix may include the following matrix with eight rows and 14 columns:

$$10 \quad 00 \quad 10 \quad 11 \quad 10 \quad 00 \quad 01$$
$$01 \quad 00 \quad 01 \quad 11 \quad 01 \quad 00 \quad 10$$
$$11 \quad 00 \quad 01 \quad 00 \quad 00 \quad 11 \quad 01$$
$$11 \quad 00 \quad 10 \quad 00 \quad 00 \quad 11 \quad 10$$
$$01 \quad 00 \quad 00 \quad 01 \quad 11 \quad 00 \quad 10$$
$$10 \quad 00 \quad 00 \quad 10 \quad 11 \quad 00 \quad 01$$
$$11 \quad 10 \quad 00 \quad 00 \quad 00 \quad 00 \quad 00$$
$$11 \quad 01 \quad 00 \quad 00 \quad 00 \quad 00 \quad 00.$$

First base matrices obtained by expanding the second base matrix shown in FIG. 7d are not listed one by one.

A lower part of FIG. 7d shows a check matrix. In the check matrix, -1 represents a Z*Z all-zero matrix, 0 represents a Z*Z identity matrix, a non-zero element represents a Z*Z CPM, and Z represents a lifting factor used when the first base matrix is expanded to obtain the check matrix. FIG. 7d is shown by using an example in which Z=42, but the example should not be construed as a limitation on embodiments of this application. For a manner of obtaining the check matrix by using the first base matrix, refer to a related standard or protocol. Details are not described herein again.

It may be understood that, for a manner of obtaining the first base matrix based on the second base matrix shown by an upper part of FIG. 7d, refer to FIG. 5, or refer to FIG. 7c and FIG. 6c. Details are not described herein again.

FIG. 7a to FIG. 7d are shown when the sparsity of the first bit sequence is less than or equal to 0.11. To be specific, both the base matrix group A and the base matrix group B are applicable to a case in which the source sparsity is less than or equal to 0.11, and all information bits may be punctured, or some information bits are punctured.

In a possible implementation, to enable the base matrix group A and the base matrix group B to adapt to a wider range of source sparsities, the following expansion design is further performed in this embodiment of this application, and the second base matrix is shown as follows:

$$\begin{bmatrix} A & B \\ C & D \end{bmatrix}.$$

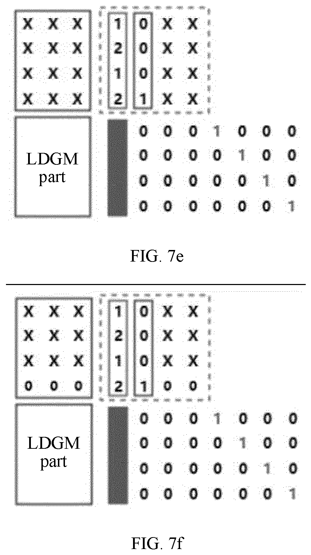

A represents an information part in the second base matrix, B represents a check part in the second base matrix, C is a matrix determined based on the code rate and the sparsity of the first bit sequence, a 1st column in D is a punctured column, and a remaining part other than the 1st column in D is obtained based on an identity matrix. For example, for A, refer to the information part shown in FIG. 7a to FIG. 7d, and for B, refer to the check part shown in FIG. 7a to FIG. 7d. C may be an LDGM determined based on the code rate and the source sparsity. Elements in a 2nd column to a 4th column in D may all be 0, and a part other than the first four columns in D may be an identity matrix. FIG. 7e shows a similar expansion manner of a base matrix group A according to an embodiment of this application, and FIG. 7f shows a similar expansion manner of a base matrix group B according to an embodiment of this application. For a specific value of an x part in FIG. 7e, refer to related descriptions in FIG. 7a and FIG. 7c. For a specific value of an x part in FIG. 7f, refer to related descriptions in FIG. 7b and FIG. 7d. LDGM parts in FIG. 7e and FIG. 7f may be designed based on a required code rate and source sparsity. This is not limited in embodiments of this application. Shadow parts in FIG. 7e and FIG. 7f are a 1st column in D, and correspond to a state column (or a punctured column). The 1st column in D may include the following elements: 1 and 2. For example, the 1st column in D may be $[1\ 2\ 1\ 2...]^T$, $[1\ 1\ 1\ 1...]^T$, or $[1\ 2\ 1\ 2...\ 1\ 1\ 1\ 1...]^T$. Four-row and four-column identity matrices shown in FIG. 7e and FIG. 7f are merely examples, and a size of the identity matrix may be determined based on the LDGM part.

It may be understood that base matrices shown in FIG. 7e and FIG. 7f are applicable to a case in which the source sparsity is greater than or equal to 0.11. For example, the source sparsity is greater than 0.11 and less than 0.3. Examples are not listed one by one herein.

Implementation 3:

In this embodiment of this application, the 1st column of the check part in the second base matrix is $[1\ 1\ 1\ 2\ 2]^T$. The 1st column is specifically selected by eliminating the compromise between the decoding threshold and the trapping set (which may also be referred to as a loop trapping set). In addition, $[1\ 1\ 1\ 2\ 2]^T$ is compared with the following two columns: $[1\ 1\ 2\ 2\ 2]^T$ and $[1\ 1\ 1\ 1\ 2]^T$. It is found through comparison that the second base matrix used when the 1st column of the check part is $[1\ 1\ 1\ 2\ 2]^T$ can be used to eliminate the compromise between the decoding performance and the trapping set. The column weight of the 2nd column of the check part in the second base matrix is 1. For example, the 2nd column may be $[0\ 0\ 0\ 0\ 1]^T$. A combination of the 2nd column and the 1st column can achieve an extremely low decoding threshold, and the encoding and decoding complexity can be greatly reduced. It may be understood that for descriptions of the 1st column and the 2nd column, refer to FIG. 5, Implementation 1, and the like. Details are not described herein again.

For example, when the first threshold is equal to 0.3, a base matrix group C is designed in this embodiment of this application. When the base matrix group C is used for encoding, inversion needs to be performed on some 5x5 square matrices for the check part in the base matrix in the base matrix group C. Then, a check bit corresponding to a column whose column weight is 1 is calculated. Complexity of the base matrix group C is low.

According to the foregoing constraint condition C2, to optimize the decoding performance of the designed base matrix in a case of a medium or short code, a density of the base matrix is further constrained. That is, a maximum row weight and a maximum column weight are controlled. This embodiment of this application provides three independently designed density regions. A density refers to an x part in the base matrix shown below. C3R7 means that a maximum column weight of the x part in the base matrix does not exceed 3, and a maximum row weight of the x part does not exceed 7. A matrix density region is roughly divided into the following D1 to D3: D1 (C3R5, C3R4, C3R3), D2 (C4R6, C4R5, C4R4), and D3 (C5R7, C5R6, C5R5). For descriptions of Thr, Gap, and D1 to D3 in this embodiment of this application, refer to Implementation 1. Details are not described herein again.

In an example, the second base matrix (which may also be referred to as a base matrix group C) includes the following matrix with five rows and seven columns:

$$\begin{matrix}
1 & 0 & x & x & x & x & x \\
1 & 0 & x & x & x & x & x \\
1 & 0 & x & x & x & x & x \\
2 & 0 & x & x & x & x & x \\
2 & 1 & 0 & 0 & 0 & 0 & 0.
\end{matrix}$$

x represents any one of the following: 0, 1, and 2, the first five columns of the second base matrix are the check part in the second base matrix, and a 6th column and a 7th column of the second base matrix are the information part in the second base matrix. After a value of x in the matrix is fixed, a matrix obtained through at least one of a row permutation operation or a column permutation operation performed on the base matrix group C may still be considered as the base matrix group C.

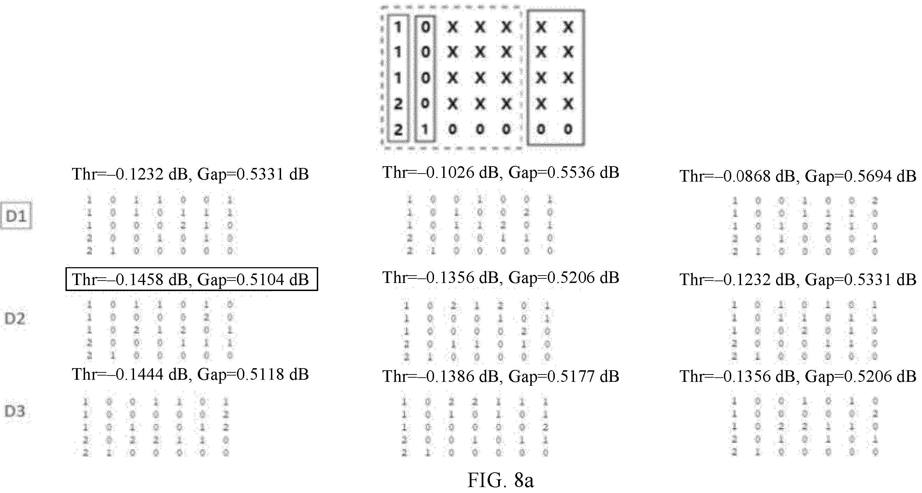

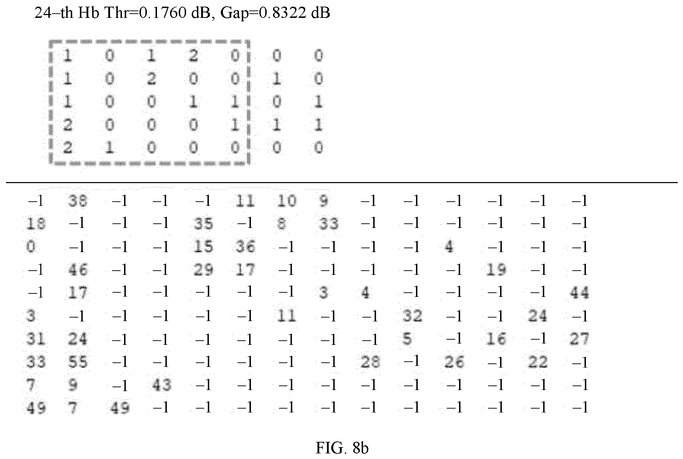

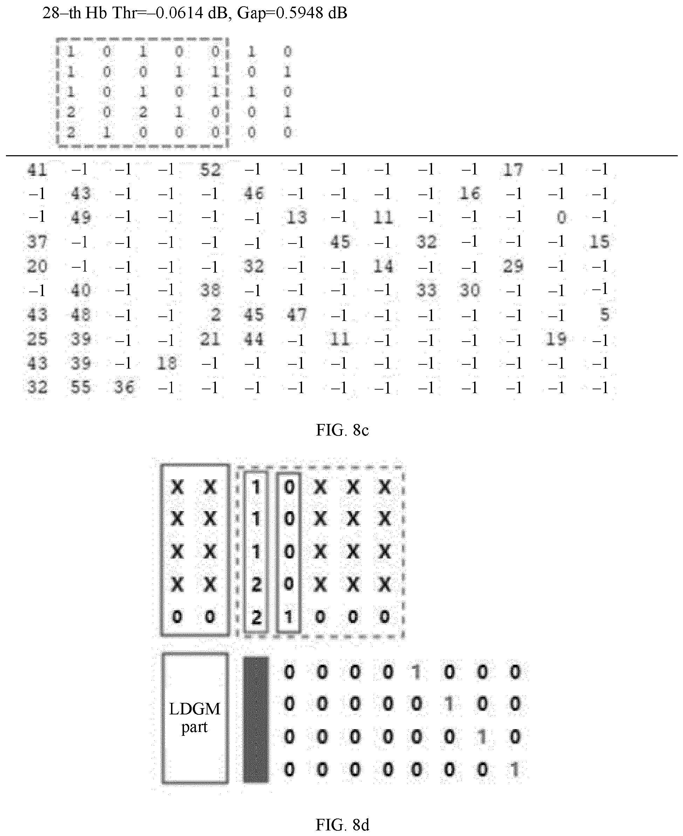

FIG. 8a is a diagram of a base matrix group C according to an embodiment of this application. FIG. 8a shows different second base matrices, and shows decoding thresholds (Thr) and gaps (Gap) that correspond to the second base matrices. It can be learned from Thr and Gap shown in FIG. 8a that a $1^{st}$ second base matrix in D2 may be understood as a base matrix with an optimal decoding threshold obtained through optimization under a corresponding condition. In addition to the base matrix shown in FIG. 8a, the base matrix group C may further include base matrices shown in FIG. 8b and FIG. 8c.

In another example, the second base matrix includes the following matrix with five rows and seven columns:

$$
\begin{array}{ccccccc}
x & x & 1 & 0 & x & x & x \\
x & x & 1 & 0 & x & x & x \\
x & x & 1 & 0 & x & x & x \\
x & x & 2 & 0 & x & x & x \\
0 & 0 & 2 & 1 & 0 & 0 & 0.
\end{array}
$$

x represents any one of the following: 0, 1, and 2, the first two columns of the second base matrix are the information part in the second base matrix, and a $3^{rd}$ column to a $7^{th}$ column of the second base matrix are the check part in the second base matrix.

FIG. 8b is a diagram of a check matrix according to an embodiment of this application. An upper part of FIG. 8b shows a second base matrix. With reference to at least one of the foregoing condition 7, condition 8, and condition 9, when n=2, based on the foregoing formula (1) and formula (3), the first base matrix may include the following matrix with 10 rows and 14 columns:

$$
\begin{array}{ccccccc}
10 & 00 & 10 & 11 & 00 & 00 & 00 \\
01 & 00 & 01 & 11 & 00 & 00 & 00 \\
10 & 00 & 11 & 00 & 00 & 10 & 00 \\
01 & 00 & 11 & 00 & 00 & 01 & 00 \\
10 & 00 & 00 & 10 & 10 & 00 & 10 \\
01 & 00 & 00 & 01 & 01 & 00 & 01 \\
11 & 00 & 00 & 00 & 10 & 10 & 10 \\
11 & 00 & 00 & 00 & 01 & 01 & 01 \\
11 & 10 & 00 & 00 & 00 & 00 & 00 \\
11 & 01 & 00 & 00 & 00 & 00 & 00.
\end{array}
$$

Alternatively, based on the foregoing formula (2) and formula (3), the first base matrix may include the following matrix with 10 rows and 14 columns:

$$
\begin{array}{ccccccc}
0\,1 & 0\,0 & 0\,1 & 1\,1 & 0\,0 & 0\,0 & 0\,0 \\
1\,0 & 0\,0 & 1\,0 & 1\,1 & 0\,0 & 0\,0 & 0\,0 \\
0\,1 & 0\,0 & 1\,1 & 0\,0 & 0\,0 & 0\,1 & 0\,0 \\
1\,0 & 0\,0 & 1\,1 & 0\,0 & 0\,0 & 1\,0 & 0\,0 \\
0\,1 & 0\,0 & 0\,0 & 0\,1 & 0\,1 & 0\,0 & 0\,1 \\
1\,0 & 0\,0 & 0\,0 & 1\,0 & 1\,0 & 0\,0 & 1\,0 \\
1\,1 & 0\,0 & 0\,0 & 0\,0 & 0\,1 & 0\,1 & 0\,1 \\
1\,1 & 0\,0 & 0\,0 & 0\,0 & 1\,0 & 1\,0 & 1\,0 \\
1\,1 & 0\,1 & 0\,0 & 0\,0 & 0\,0 & 0\,0 & 0\,0 \\
1\,1 & 1\,0 & 0\,0 & 0\,0 & 0\,0 & 0\,0 & 0\,0. \\
\end{array}
$$

It may be understood that the first base matrix shown above is merely an example. Alternatively, some elements 1 in the second base matrix may be expanded to the formula (1), and the other elements 1 may be expanded to the formula (2). For example, the first base matrix may further include the following matrix with 10 rows and 14 columns:

$$
\begin{array}{ccccccc}
0\,1 & 0\,0 & 0\,1 & 1\,1 & 0\,0 & 0\,0 & 0\,0 \\
1\,0 & 0\,0 & 1\,0 & 1\,1 & 0\,0 & 0\,0 & 0\,0 \\
1\,0 & 0\,0 & 1\,1 & 0\,0 & 0\,0 & 1\,0 & 0\,0 \\
0\,1 & 0\,0 & 1\,1 & 0\,0 & 0\,0 & 0\,1 & 0\,0 \\
0\,1 & 0\,0 & 0\,0 & 0\,1 & 1\,0 & 0\,0 & 0\,1 \\
1\,0 & 0\,0 & 0\,0 & 1\,0 & 0\,1 & 0\,0 & 1\,0 \\
1\,1 & 0\,0 & 0\,0 & 0\,0 & 0\,1 & 0\,1 & 0\,1 \\
1\,1 & 0\,0 & 0\,0 & 0\,0 & 1\,0 & 1\,0 & 1\,0 \\
1\,1 & 0\,1 & 0\,0 & 0\,0 & 0\,0 & 0\,0 & 0\,0 \\
1\,1 & 1\,0 & 0\,0 & 0\,0 & 0\,0 & 0\,0 & 0\,0. \\
\end{array}
$$

It may be understood that the foregoing first base matrix is shown by using n=2 as an example, and cases in which n=3, n=4, n=5, and the like are not shown one by one. n=2 should not be construed as a limitation on embodiments of this application. First base matrices obtained by expanding the second base matrix shown in FIG. 8b are not listed one by one.

A lower part of FIG. 8b shows a check matrix. In the check matrix, -1 represents a Z*Z all-zero matrix, 0 represents a Z*Z identity matrix, a non-zero element represents a Z*Z CPM, and Z represents a lifting factor used when the first base matrix is expanded to obtain the check matrix. FIG. 8b is shown by using an example in which Z=56, but the example should not be construed as a limitation on embodiments of this application. For a manner of obtaining the check matrix by using the first base matrix, refer to a related standard or protocol. Details are not described herein again.

FIG. 8c is a diagram of a check matrix according to an embodiment of this application. For example, the first base matrix may include the following matrix with 10 rows and 14 columns:

$$
\begin{matrix}
10 & 00 & 10 & 00 & 00 & 10 & 00 \\
01 & 00 & 01 & 00 & 00 & 01 & 00 \\
10 & 00 & 00 & 10 & 10 & 00 & 10 \\
01 & 00 & 00 & 01 & 01 & 00 & 01 \\
10 & 00 & 10 & 00 & 10 & 10 & 00 \\
01 & 00 & 01 & 00 & 01 & 01 & 00 \\
11 & 00 & 11 & 10 & 00 & 00 & 10 \\
11 & 00 & 11 & 01 & 00 & 00 & 01 \\
11 & 10 & 00 & 00 & 00 & 00 & 00 \\
11 & 01 & 00 & 00 & 00 & 00 & 00.
\end{matrix}
$$

Alternatively, the first base matrix includes the following matrix with 10 rows and 14 columns:

$$
\begin{matrix}
01 & 00 & 01 & 00 & 00 & 01 & 00 \\
10 & 00 & 10 & 00 & 00 & 10 & 00 \\
01 & 00 & 00 & 01 & 01 & 00 & 01 \\
10 & 00 & 00 & 10 & 10 & 00 & 10 \\
01 & 00 & 01 & 00 & 01 & 01 & 00 \\
10 & 00 & 10 & 00 & 10 & 10 & 00 \\
11 & 00 & 11 & 01 & 00 & 00 & 01 \\
11 & 00 & 11 & 10 & 00 & 00 & 10 \\
11 & 01 & 00 & 00 & 00 & 00 & 00 \\
11 & 10 & 00 & 00 & 00 & 00 & 00.
\end{matrix}
$$

Alternatively, the first base matrix includes the following matrix with 10 rows and 14 columns:

$$
\begin{matrix}
10 & 00 & 10 & 00 & 00 & 01 & 00 \\
01 & 00 & 01 & 00 & 00 & 10 & 00 \\
01 & 00 & 00 & 10 & 10 & 00 & 10 \\
10 & 00 & 00 & 01 & 01 & 00 & 01 \\
10 & 00 & 01 & 00 & 10 & 01 & 00 \\
01 & 00 & 10 & 00 & 01 & 10 & 00 \\
11 & 00 & 11 & 10 & 00 & 00 & 01 \\
11 & 00 & 11 & 01 & 00 & 00 & 10 \\
11 & 01 & 00 & 00 & 00 & 00 & 00 \\
11 & 10 & 00 & 00 & 00 & 00 & 00.
\end{matrix}
$$

First base matrices obtained by expanding the second base matrix shown in FIG. 8c are not listed one by one.

A lower part of FIG. 8c shows a check matrix. In the check matrix, -1 represents a Z*Z all-zero matrix, 0 represents a Z*Z identity matrix, a non-zero element represents a Z*Z CPM, and Z represents a lifting factor used when the first base matrix is expanded to obtain the check matrix. FIG. 8c is shown by using an example in which Z=56, but the example should not be construed as a limitation on embodiments of this application. For a manner of obtaining the check matrix by using the first base matrix, refer to a related standard or protocol. Details are not described herein again.

FIG. 8a to FIG. 8c are shown when the sparsity of the first bit sequence is less than or equal to 0.3. To be specific, the base matrix group C is applicable to a case in which the source sparsity is less than or equal to 0.3, and all information bits may be punctured, or some information bits are punctured.

In a possible implementation, to enable the base matrix group C to adapt to a wider range of source sparsities, the following expansion design is further performed in this embodiment of this application, and the second base matrix is shown as follows:

$$\begin{bmatrix} A & B \\ C & D \end{bmatrix}.$$

A represents an information part in the second base matrix, B represents a check part in the second base matrix, C is a matrix determined based on the code rate and the sparsity of the first bit sequence, a $1^{st}$ column in D is a punctured column, and a remaining part other than the $1^{st}$ column in D is obtained based on an identity matrix. For example, for A, refer to the information part shown in FIG. 8a to FIG. 8c, and for B, refer to the check part shown in FIG. 8a to FIG. 8c. C may be an LDGM determined based on the code rate and the source sparsity. Elements in a $2^{nd}$ column to a $5^{th}$ column in D may all be 0, and a part other than the first five columns in D may be an identity matrix. FIG. 8d shows a similar expansion manner of a base matrix group C according to an embodiment of this application. For a specific value of an x part in FIG. 8d, refer to related descriptions in FIG. 8a to FIG. 8c. An LDGM part in FIG. 8d may be designed based on a required code rate and source sparsity. This is not limited in embodiments of this application. A shadow part in FIG. 8d is a $1^{st}$ column in D, and corresponds to a state column (or a punctured column). The $1^{st}$ column in D includes the following elements: 1 and 2. For example, the $1^{st}$ column in D may be $[1\ 2\ 1\ 2...]^T$, $[1\ 1\ 1\ 1...]^T$, or $[1\ 2\ 1\ 2...\ 1\ 1\ 1\ 1...]^T$. A four-row and four-column identity matrix shown in FIG. 8d is merely an example, and a size of the identity matrix may be determined based on the LDGM part.

It may be understood that a base matrix shown in FIG. 8d is applicable to a case in which the source sparsity is greater than or equal to 0.3.

In another possible implementation of this application, based on Implementation 1 to Implementation 3 shown above, the sparsity of the first bit sequence is divided into a value less than or equal to the first threshold or a value greater than the first threshold. In addition, the sparsity of the first bit sequence may be further divided into different intervals, for example, an interval in which the sparsity of the first bit sequence is less than or equal to 0.05, an interval in which the sparsity of the first bit sequence is greater than 0.05 and less than or equal to 0.11, an interval in which the sparsity of the first bit sequence is greater than 0.11 and less than or equal to 0.3, and an interval in which the sparsity of the first bit sequence is greater than 0.3. For example, when the interval in which the sparsity of the first bit sequence is less than or equal to 0.05 is used, for descriptions of the second base matrix, refer to FIG. 6a to FIG. 6d. For another example, when the sparsity of the first bit sequence is greater than 0.05 and less than or equal to 0.11, for descriptions of the second base matrix, refer to FIG. 6e and FIG. 6f, or FIG. 7a to FIG. 7d. For another example, when the sparsity of the first bit sequence is greater than 0.11 and less than or equal to 0.3, for descriptions of the second base matrix, refer to FIG. 7e, FIG. 7d, and FIG. 8a to FIG. 8d. For another example, when the sparsity of the first bit sequence is greater than 0.3, for descriptions of the second base matrix, refer to FIG. 6e, FIG. 6f, FIG. 7e, FIG. 7f, and FIG. 8d.

It may be understood that the foregoing interval division is merely an example. For example, the sparsity of the first bit sequence may be further divided into: an interval in which the sparsity of the first bit sequence is less than or equal to 0.05, an interval in which the sparsity of the first bit sequence is greater than 0.05 and less than or equal to 0.3, or an interval in which the sparsity of the first bit sequence is greater than 0.3. Examples are not listed one by one herein.

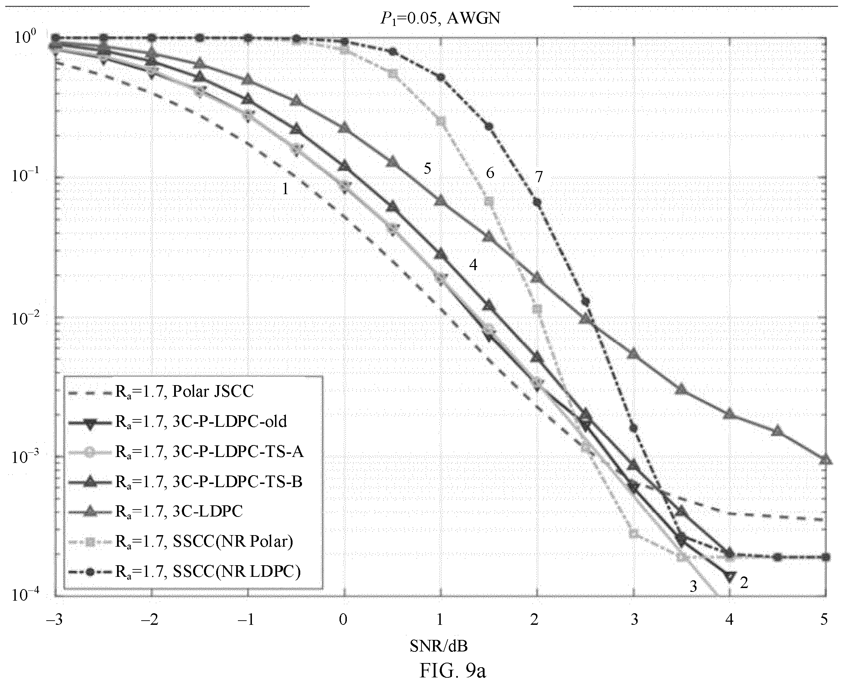

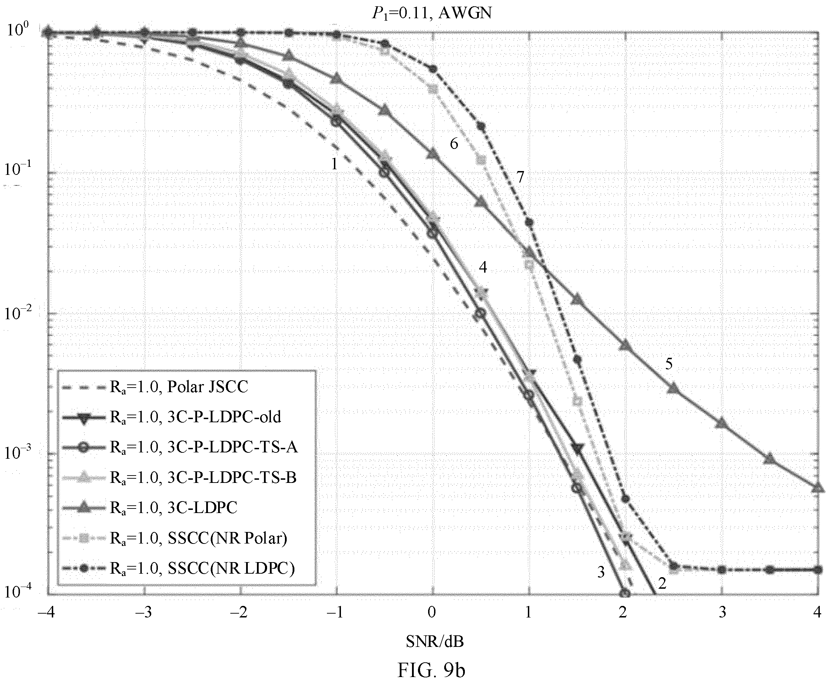

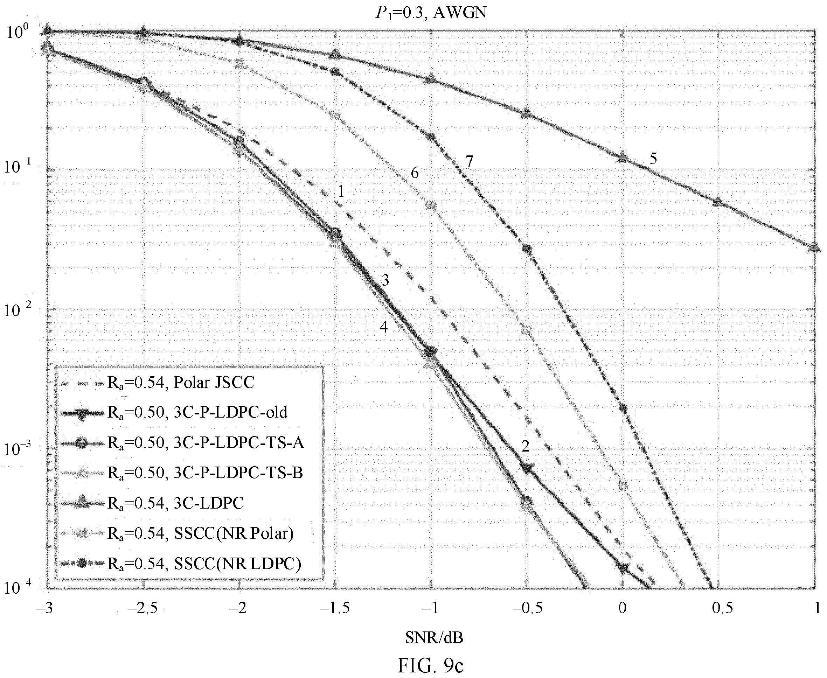

FIG. 9a is a diagram of simulation when a source sparsity is equal to 0.05 according to an embodiment of this application, FIG. 9b is a diagram of simulation when a source sparsity is equal to 0.11 according to an embodiment of this application, and FIG. 9c is a diagram of simulation when a source sparsity is equal to 0.3 according to an embodiment of this application. An SSCC scheme is a conventional scheme in which encoding and decoding of conventional source coding, and encoding and decoding of conventional channel coding are separately performed. The source coding shown herein uses classical conventional arithmetic coding for source compression, and the channel coding separately uses NR LDPC and NR polar codes in a 5G standard. The classical arithmetic coding uses fixed-length coding. To be specific, it is ensured that a BLER of a pure source coding part obtained through compression and decompression is approximately 1e-4. p1 is a probability of occurrence of 1 in a source, and a Bernoulli (Bernoulli) model is used for generating the source. To be specific, a percentage of 1s in each source block may float around p1. A longer packet length indicates slight floating.

In terms of the channel coding, a CRC8+SCL32 decoding algorithm is used for Polar (JSCC or SSCC), and a maximum quantity of iterations for LDPC simulation is set to 20.

In FIG. 9a to FIG. 9c, a horizontal coordinate represents an SNR in a unit of dB, and a vertical coordinate represents a block error rate (block error rate, BLER). Sequence numbers 1 to 7 in FIG. 9a to FIG. 9c sequentially correspond to polar JSCC, 3C-P-LDPC-old, 3C-P-LDPC-TS-A, 3C-P-LDPC-TS-B, 3C-LDPC, SSCC (NR polar) and SSCC (NR LDPC) in lower left corners in FIG. 9a to FIG. 9c.

In FIG. 9a, Polar JSCC: Ns=320 and Nc=192; JSCC (that is, 3C-P-LDPC-old, 3C-P-LDPC-TS-A, 3C-P-LDPC-TS-B, and 3C-LDPC): Ns=420 and Nc=252; and SSCC: Ns=420, 188 (SC) and Nc=252 (CC, 0.75). In FIG. 9b, Polar JSCC: Ns=256 and Nc=256; JSCC: Ns=336 and Nc=336; and SSCC: Ns=336, 228 (SC) and Nc=226 (CC, 0.68). In FIG.

9c, Polar JSCC: Ns=320 and Nc=192; JSCC: Ns=420 and Nc=252; and SSCC: Ns=420, 188 (SC) and Nc=252 (CC, 0.75). Ns represents a source bit, and Nc represents an encoded bit. For example, Ns in the JSCC may be understood as the K information bits shown above, and Nc may be understood as the M check bits shown above. For example, for FIG. 9a and FIG. 9c, LDPC encoding may be performed on 420 information bits by using 3C-P-LDPC, to obtain 252 check bits. For FIG. 9b, LDPC encoding may be performed on 336 information bits by using 3C-P-LDPC, to obtain 336 check bits. For the SSCC, the source bit needs to be first compressed to obtain a bit obtained through source compression (source coding, SC), and then a bit obtained through source compression is encoded to obtain a bit obtained through channel compression (channel coding, CC). For example, SSCC: Ns=420, 188 (SC) and Nc=252 (CC, 0.75) indicates that a source is 420 bits, 188 bits are obtained through compression, and then the 188 bits are encoded to obtain 252 encoded bits, where a code rate is approximately equal to 0.75.

3C-P-LDPC-old represents a base matrix that is not optimized by using a trapping set, 3C-P-LDPC-TS-A represents a base matrix group A, 3C-P-LDPC-TS-B represents a base matrix group B, and 3C-LDPC represents a base matrix that is not optimized by using the mutual information shown in FIG. 3b. It may be understood that 3C-P-LDPC-TS-A is a matrix obtained by optimizing 3C-P-LDPC-old by using the trapping set. It can be learned from FIG. 9a and FIG. 9b that when the BLER is low, for example, less than 1e-3 (or less than 1e-4), a BLER of a base matrix represented by 3C-P-LDPC-TS-A is lower, and performance is better. 3C-P-LDPC-TS-A and 3C-P-LDPC-TS-B change more stably as the BLER decreases. Therefore, performance is more stable. It can be learned from FIG. 9c that the performance of 3C-P-LDPC-TS-A is close to that of 3C-P-LDPC-TS-B. Therefore, when the first threshold is equal to 0.3, the base matrix group C in embodiments of this application does not specifically distinguish between base matrices. That is, a last row in the base matrix group C is 0.

Communication apparatuses provided in embodiments of this application are described below.

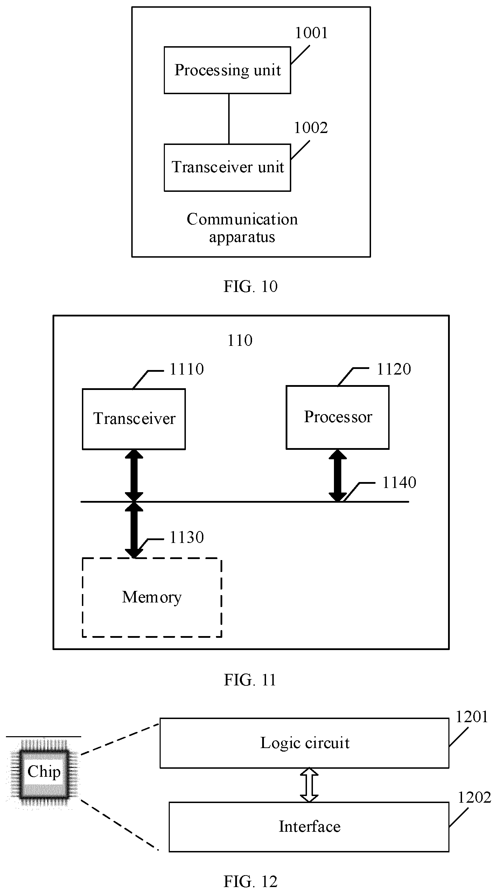

In this application, the communication apparatus is divided into functional modules based on the foregoing method embodiments. For example, each functional module may be divided to each corresponding function, or two or more functions may be integrated into one processing module. The integrated module may be implemented in a form of hardware, or may be implemented in a form of a software functional module. It should be noted that, in this application, module division is an example, and is merely a logical function division. In actual implementation, another division manner may be used. The following describes in detail the communication apparatuses in embodiments of this application with reference to FIG. 10 to FIG. 12.

FIG. 10 is a diagram of a structure of a communication apparatus according to an embodiment of this application. As shown in FIG. 10, the communication apparatus includes a processing unit 1001 and a transceiver unit 1002.

In some embodiments of this application, the communication apparatus may be the transmitter or the chip shown above, and the chip may be disposed in the transmitter. In other words, the communication apparatus may be configured to perform a step, a function, or the like performed by the transmitter in the method embodiments.

The processing unit 1001 is configured to obtain a first bit sequence.

The processing unit 1001 is further configured to perform LDPC encoding on the first bit sequence based on a check matrix, to obtain a second bit sequence.

The processing unit 1001 is configured to output the second bit sequence by using the transceiver unit 1002.

It may be understood that that the processing unit shown herein outputs the second bit sequence by using the transceiver unit may be understood as follows: The processing unit may send the second bit sequence to another component by using the transceiver unit (for example, send the second bit sequence to an apparatus for modulation, or send the second bit sequence to an apparatus for frequency conversion), or the transceiver unit sends a modulation symbol and the like of the second bit sequence to a receiver by using the transceiver unit. Examples are not listed one by one in this embodiment of this application.

Still with reference to FIG. 10, in some other embodiments of this application, the communication apparatus may be the receiver or the chip shown above, and the chip may be disposed in the receiver. In other words, the communication apparatus may be configured to perform a step, a function, or the like performed by the receiver in the method embodiments.

The processing unit 1001 is configured to obtain a second bit sequence.

The processing unit 1001 is further configured to perform decoding on the second bit sequence based on a check matrix, to obtain K information bits.

It may be understood that the transceiver unit 1002 may be configured to input a signal such as a modulation symbol transmitted through a channel, and then the processing unit may process the signal to obtain the second bit sequence.

It may be understood that specific descriptions of the transceiver unit and the processing unit shown in this embodiment of this application are merely examples. For specific functions, steps, or the like of the transceiver unit and the processing unit, refer to the foregoing method embodiments. Details are not described herein.

It may be understood that, for descriptions of the first bit sequence, the second bit sequence, the 3C-P-LDPC code, the first base matrix, the second base matrix, the check matrix, and the like, refer to the foregoing method embodiments. Details are not described herein again.

The foregoing describes the communication apparatus in this embodiment of this application. The following describes possible product forms of the communication apparatus. It should be understood that a product in any form that has a function of the communication apparatus in FIG. 10 falls within the protection scope of embodiments of this application.

In a possible implementation, in the communication apparatus shown in FIG. 10, the processing unit 1001 may be one or more processors, and the transceiver unit 1002 may be a transceiver, or the transceiver unit 1002 may be a sending unit and a receiving unit. The sending unit may be a transmitter, and the receiving unit may be a receiver. The sending unit and the receiving unit are integrated into one component, for example, a transceiver. In embodiments of this application, the processor and the transceiver may be coupled, or the like. A manner of connecting the processor and the transceiver is not limited in embodiments of this application. In a process of performing the foregoing method, a process of sending information in the foregoing method may be understood as a process of outputting the information by the processor. When outputting the information, the processor outputs the information to the transceiver, so that the transceiver transmits the information. After the information is output by the processor, other processing may further need to be performed on the information, and then processed information arrives at the transceiver. Similarly, a process of receiving information in the foregoing method may be understood as a process of receiving the input information by the processor. When the processor receives the input information, the transceiver receives the information, and inputs the information into the processor. Further, after the transceiver receives the information, other processing may need to be performed on the information, and then processed information is input into the processor.

As shown in FIG. 11, a communication apparatus 110 includes one or more processors 1120 and a transceiver 1110.

For example, when the communication apparatus is configured to perform a step, a method, or a function performed by the transmitter, the processor 1120 is configured to obtain a first bit sequence. The processor 1120 is further configured to perform LDPC encoding on the first bit sequence based on a check matrix, to obtain a second bit sequence. The processor 1120 is configured to send the second bit sequence by using the transceiver 1110. For example, the transceiver 1110 may send a signal obtained through rate matching, modulation, or the like performed on the second bit sequence.

For example, when the communication apparatus is configured to perform a step, a method, or a function performed by the receiver, the processor 1120 is configured to: obtain a second bit sequence; and perform LDPC decoding on the second bit sequence based on a check matrix, to obtain K information bits.

It may be understood that the transceiver 1110 may be configured to receive a signal such as a modulation symbol transmitted through a channel, and then the processor may process the signal to obtain the second bit sequence.

It may be understood that for specific descriptions of the processor and the transceiver, refer to descriptions of the processing unit and the transceiver unit shown in FIG. 10. Details are not described herein again. For descriptions of the first bit sequence, the second bit sequence, the 3C-P-LDPC code, the first base matrix, the second base matrix, the check matrix, and the like, refer to the foregoing method embodiments. Details are not described herein again.

In various implementations of the communication apparatus shown in FIG. 11, the transceiver may include a receiver and a transmitter, the receiver is configured to perform a receiving function (or operation), and the transmitter is configured to perform a transmitting function (or operation). In addition, the transceiver is configured to communicate with another device/apparatus through a transmission medium.

Optionally, the communication apparatus 110 may further include one or more memories 1130, configured to store program instructions, data, and/or the like. The memory 1130 is coupled to the processor 1120. The coupling in this embodiment of this application may be an indirect coupling or a communication connection between apparatuses, units, or modules in an electrical form, a mechanical form, or another form, and is used for information exchange between the apparatuses, the units, or the modules. The processor 1120 may operate in cooperation with the memory 1130. The processor 1120 may execute the program instructions stored in the memory 1130. Optionally, at least one of the one or more memories may be included in the processor. Optionally, the one or more memories may be configured to store at least one of the second base matrix, the first base matrix, and the check matrix in embodiments of this application.

A specific connection medium between the transceiver 1110, the processor 1120, and the memory 1130 is not limited in embodiments of this application. In this embodiment of this application, the memory 1130, the processor 1120, and the transceiver 1110 are connected through a bus 1140 in FIG. 11. The bus is represented by using a thick line in FIG. 11. A manner of a connection between other components is merely an example for description, and is not limited thereto. The bus may be classified into an address bus, a data bus, a control bus, and the like. For ease of representation, only one thick line is used for representing the bus in FIG. 11, but this does not mean that there is only one bus or only one type of bus.

In this embodiment of this application, the processor may be a general-purpose processor, a digital signal processor, an application-specific integrated circuit, a field programmable gate array or another programmable logic device, a discrete gate or transistor logic device, a discrete hardware component, or the like. The processor can implement or execute the methods, the steps, and the logical block diagrams disclosed in embodiments of this application. The general-purpose processor may be a microprocessor or any conventional processor or the like. The steps of the methods disclosed in combination with embodiments of this application may be directly implemented by a hardware processor, or may be implemented by using a combination of hardware and software modules in the processor, or the like.

In embodiments of this application, the memory may include but is not limited to a non-volatile memory like a hard disk drive (hard disk drive, HDD) or a solid-state drive (solid-state drive, SSD), a random access memory (Random Access Memory, RAM), an erasable programmable read-only memory (Erasable Programmable ROM, EPROM), a read-only memory (Read-Only Memory, ROM), a portable read-only memory (Compact Disc Read-Only Memory, CD-ROM), or the like. The memory is any storage medium that can be used for carrying or storing program code in a form of an instruction or a data structure and that can be read and/or written by a computer (for example, the communication apparatus shown in this application). However, this application is not limited thereto. The memory in embodiments of this application may alternatively be a circuit or any other apparatus that can implement a storage function, and is configured to store program instructions and/or data.

For example, the processor 1120 is mainly configured to: process a communication protocol and communication data, control the entire communication apparatus, execute a software program, and process data of the software program. The memory 1130 is mainly configured to store the software program and data. The transceiver 1110 may include a control circuit and an antenna. The control circuit is mainly configured to: perform conversion between a baseband signal and a radio frequency signal and process the radio frequency signal. The antenna is mainly configured to receive and send a radio frequency signal in a form of an electromagnetic wave. The input/output apparatus, such as a touchscreen, a display, or a keyboard, is mainly configured to: receive data input by a user and output data to the user.

After the communication apparatus is powered on, the processor 1120 may read the software program in the memory 1130, interpret and execute instructions of the software program, and process data of the software program. When data needs to be sent in a wireless manner, the processor 1120 performs baseband processing on the to-be-sent data, and then outputs a baseband signal to a radio frequency circuit, and the radio frequency circuit performs radio frequency processing on the baseband signal, and then sends a radio frequency signal to the outside in a form of an electromagnetic wave through the antenna. When data is sent to the communication apparatus, a radio frequency circuit receives a radio frequency signal through the antenna, converts the radio frequency signal into a baseband signal, and outputs the baseband signal to the processor 1120. The processor 1120 converts the baseband signal into data and processes the data.

In another implementation, the radio frequency circuit and the antenna may be disposed independent of the processor that performs baseband processing. For example, in a distributed scenario, the radio frequency circuit and the antenna may be remotely disposed independent of the communication apparatus.

It may be understood that the communication apparatus shown in this embodiment of this application may alternatively include more components than those shown in FIG. 11, or the like. This is not limited in embodiments of this application. The foregoing methods performed by the processor and the transceiver are merely examples. For specific steps performed by the processor and the transceiver, refer to the methods described above.

In another possible implementation, in the communication apparatus shown in FIG. 10, the processing unit 1001 may be one or more logic circuits, and the transceiver unit 1002 may be an input/output interface, or may be referred to as a communication interface, an interface circuit, an interface, or the like. Alternatively, the transceiver unit 1002 may be a sending unit and a receiving unit. The sending unit may be an output interface, and the receiving unit may be an input interface. The sending unit and the receiving unit are integrated into one unit, for example, an input/output interface. As shown in FIG. 12, a communication apparatus shown in FIG. 12 includes a logic circuit 1201 and an interface 1202. That is, the foregoing processing unit 1001 may be implemented by using the logic circuit 1201, and the transceiver unit 1002 may be implemented by using the interface 1202. The logic circuit 1201 may be a chip, a processing circuit, an integrated circuit, a system on chip (system on chip, SoC), or the like. The interface 1202 may be a communication interface, an input/output interface, a pin, or the like. For example, FIG. 12 shows an example in which the communication apparatus is a chip. The chip includes the logic circuit 1201 and the interface 1202.

In this embodiment of this application, the logic circuit and the interface may be coupled to each other. A specific manner of connection between the logic circuit and the interface is not limited in embodiments of this application.

For example, when the communication apparatus is configured to perform a method, a function, or a step performed by the transmitter, the logic circuit 1201 is configured to obtain a first bit sequence. The logic circuit 1201 is further configured to perform LDPC encoding on the first bit sequence based on a check matrix, to obtain a second bit sequence. The interface 1202 is configured to output the second bit sequence.

It may be understood that the interface may output the second bit sequence, so that another component in the transmitter processes the second bit sequence. Alternatively, the interface is configured to output a symbol sequence obtained by performing operations such as rate matching, modulation, and frequency conversion on the second bit sequence.

Optionally, the communication apparatus may further include a memory. The memory may be configured to store at least one of the check matrix, a first base matrix, and a second base matrix. Generally, the memory may store the first base matrix.

For example, when the communication apparatus is configured to perform a method, a function, or a step performed by the receiver, the logic circuit 1201 is configured to: obtain a second bit sequence, and perform LDPC decoding on the second bit sequence based on a check matrix, to obtain K information bits.

It may be understood that the interface 1202 may be configured to input a signal such as a modulation symbol transmitted through a channel, and then a logic circuit may process the signal to obtain the second bit sequence. It is clear that the logic circuit that processes the signal may be the same as or different from the logic circuit that performs LDPC decoding. This is not limited in embodiments of this application.

It may be understood that, for descriptions of the first bit sequence, the second bit sequence, the 3C-P-LDPC code, the first base matrix, the second base matrix, the check matrix, and the like, refer to the foregoing method embodiments. Details are not described herein again.

It may be understood that the communication apparatus shown in embodiments of this application may implement the method provided in embodiments of this application in a form of hardware, or may implement the method provided in embodiments of this application in a form of software, or the like. This is not limited in embodiments of this application.

For specific implementation of embodiments shown in FIG. 12, refer to the foregoing embodiments. Details are not described herein again.

An embodiment of this application further provides a wireless communication system. The wireless communication system includes a transmitter and a receiver. The transmitter and the receiver may be configured to perform the methods in any one of the foregoing embodiments. Alternatively, for the transmitter and the receiver, refer to the communication apparatuses shown in FIG. 10 to FIG. 12.

In addition, this application further provides a computer program. The computer program is used for implementing operations and/or processing performed by the transmitter in the methods provided in this application.

This application further provides a computer program. The computer program is used for implementing operations and/or processing performed by the receiver in the methods provided in this application.

This application further provides a computer-readable storage medium. The computer-readable storage medium stores computer code. When the computer code is run on a computer, the computer is enabled to perform operations and/or processing performed by the transmitter in the methods provided in this application.

This application further provides a computer-readable storage medium. The computer-readable storage medium stores computer code. When the computer code is run on a computer, the computer is enabled to perform operations and/or processing performed by the receiver in the methods provided in this application.

This application further provides a computer program product. The computer program product includes computer code or a computer program. When the computer code or the computer program is run on a computer, operations and/or processing performed by the transmitter in the methods provided in this application are/is performed.

This application further provides a computer program product. The computer program product includes computer code or a computer program. When the computer code or the computer program is run on a computer, operations and/or processing performed by the receiver in the methods provided in this application are/is performed.

In several embodiments provided in this application, it should be understood that the disclosed system, apparatus, and method may be implemented in other manners. For example, the described apparatus embodiment is merely an example. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented through some interfaces, indirect couplings or communication connections between the apparatuses or units, or electrical connections, mechanical connections, or connections in other forms.

The units described as separate parts may or may not be physically separate, and parts displayed as units may or may not be physical units, may be located in one position, or may be distributed on a plurality of network units. Some or all of the units may be selected based on an actual requirement to implement the technical effect of the solutions provided in embodiments of this application.

In addition, functional units in embodiments of this application may be integrated into one processing unit, each of the units may exist alone physically, or two or more units may be integrated into one unit. The integrated unit may be implemented in a form of hardware, or may be implemented in a form of a software functional unit.

When the integrated unit is implemented in the form of the software functional unit and sold or used as an independent product, the integrated unit may be stored in a computer-readable storage medium. Based on such an understanding, the technical solutions of this application essentially, or the part contributing to the conventional technologies, or all or some of the technical solutions may be implemented in a form of a software product. The computer software product is stored in a readable storage medium and includes several instructions for instructing a computer device (which may be a personal computer, a server, a network device, or the like) to perform all or some of the steps of the methods described in embodiments of this application. The readable storage medium includes any medium that can store program code, for example, a USB flash drive, a removable hard disk, a read-only memory (read-only memory, ROM), a random access memory (random access memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. An encoding method, wherein the method comprises:

    obtaining a first bit sequence, wherein the first bit sequence comprises K information bits, and K is a positive integer;
    performing low-density parity-check LDPC encoding on the first bit sequence based on a check matrix, to obtain a second bit sequence, wherein the check matrix is obtained based on a first base matrix, the first base matrix corresponds to a second base matrix, the second base matrix comprises the following elements: 0, 1, and 2, an element 1 in a $2^{nd}$ column of a check part in the second base matrix and an element 2 in a $1^{st}$ column of the check part are located in a same row, and a quantity of elements 1 in the $2^{nd}$ column is less than or equal to a quantity of elements 2 in the $1^{st}$ column; and the second bit sequence comprises M check bits, and M is a positive integer; and
    sending the second bit sequence.

2. A decoding method, wherein the method comprises:

    obtaining a second bit sequence, wherein the second bit sequence comprises M check bits; and
    performing low-density parity-check LDPC decoding on the second bit sequence based on a check matrix, to obtain K information bits, wherein the check matrix is obtained based on a first base matrix, the first base matrix corresponds to a second base matrix, the second base matrix comprises the following elements: 0, 1, and 2, an element 1 in a $2^{nd}$ column of a check part in the second base matrix and an element 2 in a $1^{st}$ column of the check part are located in a same row, and a quantity of elements 1 in the $2^{nd}$ column is less than or equal to a quantity of elements 2 in the $1^{st}$ column.

3. The method according to claim 1 or 2, wherein a quantity of rows of the first base matrix is equal to n times a quantity of rows of the second base matrix, and n is an integer greater than or equal to 2.

4. The method according to any one of claims 1 to 3, wherein that the first base matrix corresponds to a second base matrix comprises:
the element 1 in the second base matrix is expanded to an n*n identity matrix or an n*n antisymmetric square matrix, and the element 2 in the second base matrix is expanded to an n*n all-1 matrix.

5. The method according to any one of claims 1 to 4, wherein at least one of the following is determined based on a sparsity of the first bit sequence:
the quantity of rows of the second base matrix, a quantity of columns of the second base matrix, and a quantity of columns of an information part in the check matrix.

6. The method according to any one of claims 1 to 5, wherein the $1^{st}$ column of the check part in the second base matrix is a punctured column.

7. The method according to any one of claims 1 to 6, wherein the second base matrix satisfies at least one of the following:

    the $1^{st}$ column of the check part in the second base matrix is any one of the following: $[1\ 2\ 1\ 2]^T$, $[2\ 1\ 2\ 1]^T$, $[1\ 1\ 1\ 2\ 2]^T$, and $[2\ 1\ 1\ 1\ 2]^T$; and
    a column weight of the $2^{nd}$ column of the check part in the second base matrix is 1.

8. The method according to any one of claims 1 to 7, wherein the sparsity of the first bit sequence is less than or equal to a first threshold.

9. The method according to claim 8, wherein the second base matrix comprises:

$$
\begin{array}{ccccccc}
1 & 0 & x & x & x & x & x \\
1 & 0 & x & x & x & x & x \\
1 & 0 & x & x & x & x & x \\
2 & 0 & x & x & x & x & x \\
2 & 1 & 0 & 0 & 0 & 0 & 0
\end{array}
$$

wherein x represents any one of the following: 0, 1, and 2, the first five columns of the second base matrix are the check part in the second base matrix, and a 6th column and a 7th column of the second base matrix are an information part in the second base matrix; or
the second base matrix comprises:

$$
\begin{array}{ccccccc}
x & x & 1 & 0 & x & x & x \\
x & x & 1 & 0 & x & x & x \\
x & x & 1 & 0 & x & x & x \\
x & x & 2 & 0 & x & x & x \\
0 & 0 & 2 & 1 & 0 & 0 & 0
\end{array}
$$

wherein x represents any one of the following: 0, 1, and 2, the first two columns of the second base matrix are an information part in the second base matrix, and a 3rd column to a 7th column of the second base matrix are the check part in the second base matrix.

10. The method according to claim 9, wherein the second base matrix comprises:

$$
\begin{array}{ccccccc}
1 & 0 & 1 & 1 & 0 & 1 & 0 \\
1 & 0 & 0 & 0 & 0 & 2 & 0 \\
1 & 0 & 2 & 1 & 2 & 0 & 1 \\
2 & 0 & 0 & 0 & 1 & 1 & 1 \\
2 & 1 & 0 & 0 & 0 & 0 & 0.
\end{array}
$$

11. The method according to claim 8, wherein the second base matrix comprises:

$$
\begin{array}{ccccccc}
1 & 0 & x & x & x & x & x \\
2 & 0 & x & x & x & x & x \\
1 & 0 & x & x & x & x & x \\
2 & 1 & x & x & x & x & x
\end{array}
$$

wherein x represents any one of the following: 0, 1, and 2, the first four columns of the second base matrix are the check part in the second base matrix, and a 5th column to a 7th column of the second base matrix are an information part in the second base matrix; or
the second base matrix comprises:

$$
\begin{array}{ccccccc}
x & x & x & 1 & 0 & x & x \\
x & x & x & 2 & 0 & x & x \\
x & x & x & 1 & 0 & x & x \\
x & x & x & 2 & 1 & x & x
\end{array}
$$

wherein x represents any one of the following: 0, 1, and 2, the first three columns of the second base matrix are an information part in the second base matrix, and a $4^{th}$ column to a $7^{th}$ column of the second base matrix are the check part in the second base matrix.

**12.** The method according to claim 11, wherein the second base matrix comprises:

$$
\begin{matrix}
1 & 0 & 0 & 0 & 2 & 2 & 1 \\
2 & 0 & 1 & 2 & 0 & 0 & 0 \\
1 & 0 & 1 & 1 & 2 & 0 & 1 \\
2 & 1 & 0 & 1 & 0 & 0 & 0.
\end{matrix}
$$

**13.** The method according to claim 8, wherein the second base matrix comprises:

$$
\begin{matrix}
1 & 0 & x & x & x & x & x & x & x \\
2 & 0 & x & x & x & x & x & x & x \\
1 & 0 & x & x & x & x & x & x & x \\
2 & 1 & x & x & x & x & x & x & x
\end{matrix}
$$

wherein x represents any one of the following: 0, 1, and 2, the first four columns of the second base matrix are the check part in the second base matrix, and a $5^{th}$ column to a $9^{th}$ column of the second base matrix are an information part in the second base matrix; or
the second base matrix comprises:

$$
\begin{matrix}
x & x & x & x & x & 1 & 0 & x & x \\
x & x & x & x & x & 2 & 0 & x & x \\
x & x & x & x & x & 1 & 0 & x & x \\
x & x & x & x & x & 2 & 1 & x & x
\end{matrix}
$$

wherein x represents any one of the following: 0, 1, and 2, the first five columns of the second base matrix are an information part in the second base matrix, and a $6^{th}$ column to a $9^{th}$ column of the second base matrix are the check part in the second base matrix.

**14.** The method according to claim 13, wherein the second base matrix comprises:

$$
\begin{matrix}
1 & 0 & 1 & 0 & 2 & 2 & 0 & 1 & 0 \\
2 & 0 & 0 & 1 & 1 & 0 & 1 & 0 & 2 \\
1 & 0 & 2 & 1 & 0 & 1 & 1 & 1 & 0 \\
2 & 1 & 0 & 1 & 0 & 0 & 0 & 1 & 0;\ \text{or}
\end{matrix}
$$

the second base matrix comprises:

$$
\begin{matrix}
1 & 0 & 0 & 0 & 0 & 2 & 1 & 1 & 2 \\
2 & 0 & 2 & 1 & 2 & 1 & 1 & 1 & 1 \\
1 & 0 & 1 & 1 & 0 & 2 & 0 & 1 & 2 \\
2 & 1 & 0 & 0 & 0 & 0 & 0 & 0 & 0.
\end{matrix}
$$

**15.** The method according to claim 14, wherein the check matrix comprises:

$$\begin{array}{cccccccccccccccccc}
-1 & 21 & -1 & -1 & -1 & 27 & -1 & -1 & 39 & 15 & 26 & 30 & -1 & -1 & 6 & -1 & -1 & -1 \\
9 & -1 & -1 & -1 & 19 & -1 & -1 & -1 & 32 & 27 & 24 & 40 & -1 & -1 & -1 & 1 & -1 & -1 \\
35 & 38 & -1 & -1 & -1 & -1 & 39 & -1 & -1 & 14 & -1 & -1 & -1 & 16 & -1 & -1 & 20 & 6 \\
39 & 31 & -1 & -1 & -1 & -1 & -1 & 19 & 6 & -1 & -1 & -1 & 18 & -1 & -1 & -1 & 25 & 3 \\
13 & -1 & -1 & -1 & 31 & 26 & 35 & -1 & -1 & -1 & 35 & -1 & 2 & -1 & 23 & -1 & -1 & -1 \\
-1 & 12 & -1 & -1 & 39 & 37 & -1 & 10 & -1 & -1 & -1 & 39 & -1 & 33 & -1 & 27 & -1 & -1 \\
16 & 17 & 29 & -1 & -1 & -1 & -1 & 4 & -1 & -1 & -1 & -1 & -1 & -1 & 3 & -1 & -1 & -1 \\
10 & 38 & -1 & 21 & -1 & -1 & 38 & -1 & -1 & -1 & -1 & -1 & -1 & -1 & -1 & 18 & -1 & -1;
\end{array}$$

or

the check matrix comprises:

$$\begin{array}{cccccccccccccccccc}
-1 & 11 & -1 & -1 & -1 & -1 & -1 & -1 & -1 & -1 & 37 & 37 & -1 & 18 & 0 & -1 & 38 & 15 \\
39 & -1 & -1 & -1 & -1 & -1 & -1 & -1 & -1 & -1 & 1 & 0 & 33 & -1 & -1 & 14 & 4 & 9 \\
11 & 7 & -1 & -1 & 18 & 31 & 3 & -1 & 30 & 13 & 25 & -1 & 30 & -1 & 0 & -1 & -1 & 10 \\
1 & 31 & -1 & -1 & 26 & 22 & -1 & 34 & 5 & 11 & -1 & 13 & -1 & 27 & -1 & 16 & 12 & -1 \\
-1 & 11 & -1 & -1 & -1 & 41 & 40 & -1 & -1 & -1 & 21 & 40 & -1 & -1 & 22 & -1 & 12 & 0 \\
15 & -1 & -1 & -1 & 10 & -1 & -1 & 4 & -1 & -1 & 10 & 4 & -1 & -1 & -1 & 31 & 15 & 28 \\
31 & 29 & 15 & -1 & -1 & -1 & -1 & -1 & -1 & -1 & -1 & -1 & -1 & -1 & -1 & -1 & -1 & -\char`_ \\
1 & 36 & -1 & 18 & -1 & -1 & -1 & -1 & -1 & -1 & -1 & -1 & -1 & -1 & -1 & -1 & -1 & -\char`_
\end{array}$$

wherein -1 represents a Z*Z all-zero matrix, 0 represents a Z*Z identity matrix, a non-zero element represents a Z*Z circulant permutation matrix, Z represents a lifting factor used when the first base matrix is expanded to obtain the check matrix, and Z=42.

16. The method according to any one of claims 1 to 7, wherein when the sparsity of the first bit sequence is greater than the first threshold, the second base matrix is shown as follows:

$$\begin{bmatrix} A & B \\ C & D \end{bmatrix}$$

wherein A represents an information part in the second base matrix, B represents the check part in the second base matrix, C is a matrix determined based on a code rate and the sparsity of the first bit sequence, a $1^{st}$ column in D is a punctured column, and a remaining part other than the $1^{st}$ column in D is obtained based on the identity matrix.

17. The method according to claim 16, wherein the $1^{st}$ column in D is either of the following: $[1\ 2\ 1\ 2\ ...]^{T}$ and $[1\ 1\ 1\ 1\ ...]^{T}$.

18. A communication apparatus, wherein the apparatus comprises:

a processing unit, configured to obtain a first bit sequence, wherein the first bit sequence comprises K information bits, and K is a positive integer, wherein
the processing unit is further configured to perform low-density parity-check LDPC encoding on the first bit sequence based on a check matrix, to obtain a second bit sequence, wherein the check matrix is obtained based on a first base matrix, the first base matrix corresponds to a second base matrix, the second base matrix comprises the following elements: 0, 1, and 2, an element 1 in a $2^{nd}$ column of a check part in the second base matrix and an element 2 in a $1^{st}$ column of the check part are located in a same row, and a quantity of elements 1 in the $2^{nd}$ column is less than or equal to a quantity of elements 2 in the $1^{st}$ column, and the second bit sequence comprises M check bits, and M is a positive integer; and
a transceiver unit, configured to send the second bit sequence.

**19.** A communication apparatus, wherein the apparatus comprises:

a processing unit, configured to obtain a second bit sequence, wherein the second bit sequence comprises M check bits, wherein
the processing unit is further configured to perform low-density parity-check LDPC decoding on the second bit sequence based on a check matrix, to obtain K information bits, wherein the check matrix is obtained based on a first base matrix, the first base matrix corresponds to a second base matrix, the second base matrix comprises the following elements: 0, 1, and 2, an element 1 in a $2^{nd}$ column of a check part in the second base matrix and an element 2 in a $1^{st}$ column of the check part are located in a same row, and a quantity of elements 1 in the $2^{nd}$ column is less than or equal to a quantity of elements 2 in the $1^{st}$ column.

**20.** The apparatus according to claim 18 or 19, wherein a quantity of rows of the first base matrix is equal to n times a quantity of rows of the second base matrix, and n is an integer greater than or equal to 2.

**21.** The apparatus according to any one of claims 18 to 20, wherein that the first base matrix corresponds to a second base matrix comprises:
the element 1 in the second base matrix is expanded to an n*n identity matrix or an n*n antisymmetric square matrix, and the element 2 in the second base matrix is expanded to an n*n all-1 matrix.

**22.** The apparatus according to any one of claims 18 to 21, wherein at least one of the following is determined based on a sparsity of the first bit sequence:
the quantity of rows of the second base matrix, a quantity of columns of the second base matrix, and a quantity of columns of an information part in the check matrix.

**23.** The apparatus according to any one of claims 18 to 22, wherein the $1^{st}$ column of the check part in the second base matrix is a punctured column.

**24.** The apparatus according to any one of claims 18 to 23, wherein the second base matrix satisfies at least one of the following:

the $1^{st}$ column of the check part in the second base matrix is any one of the following: $[1\ 2\ 1\ 2]^T$, $[2\ 1\ 2\ 1]^T$, $[1\ 1\ 1\ 2\ 2]^T$, and $[2\ 1\ 1\ 1\ 2]^T$; and
a column weight of the $2^{nd}$ column of the check part in the second base matrix is 1.

**25.** The apparatus according to any one of claims 18 to 24, wherein the sparsity of the first bit sequence is less than or equal to a first threshold.

**26.** The apparatus according to claim 25, wherein the second base matrix comprises:

$$
\begin{matrix}
1 & 0 & x & x & x & x & x \\
1 & 0 & x & x & x & x & x \\
1 & 0 & x & x & x & x & x \\
2 & 0 & x & x & x & x & x \\
2 & 1 & 0 & 0 & 0 & 0 & 0
\end{matrix}
$$

wherein x represents any one of the following: 0, 1, and 2, the first five columns of the second base matrix are the check part in the second base matrix, and a $6^{th}$ column and a $7^{th}$ column of the second base matrix are an information part in the second base matrix; or
the second base matrix comprises:

$$\begin{array}{ccccccc}
x & x & 1 & 0 & x & x & x \\
x & x & 1 & 0 & x & x & x \\
x & x & 1 & 0 & x & x & x \\
x & x & 2 & 0 & x & x & x \\
0 & 0 & 2 & 1 & 0 & 0 & 0
\end{array}$$

wherein x represents any one of the following: 0, 1, and 2, the first two columns of the second base matrix are an information part in the second base matrix, and a 3<sup>rd</sup> column to a 7<sup>th</sup> column of the second base matrix are the check part in the second base matrix.

27. The apparatus according to claim 26, wherein the second base matrix comprises:

$$\begin{array}{ccccccc}
1 & 0 & 1 & 1 & 0 & 1 & 0 \\
1 & 0 & 0 & 0 & 0 & 2 & 0 \\
1 & 0 & 2 & 1 & 2 & 0 & 1 \\
2 & 0 & 0 & 0 & 1 & 1 & 1 \\
2 & 1 & 0 & 0 & 0 & 0 & 0.
\end{array}$$

28. The apparatus according to claim 25, wherein the second base matrix comprises:

$$\begin{array}{ccccccc}
1 & 0 & x & x & x & x & x \\
2 & 0 & x & x & x & x & x \\
\\
1 & 0 & x & x & x & x & x \\
2 & 1 & x & x & x & x & x
\end{array}$$

wherein x represents any one of the following: 0, 1, and 2, the first four columns of the second base matrix are the check part in the second base matrix, and a 5<sup>th</sup> column to a 7<sup>th</sup> column of the second base matrix are an information part in the second base matrix; or
the second base matrix comprises:

$$\begin{array}{ccccccc}
x & x & x & 1 & 0 & x & x \\
x & x & x & 2 & 0 & x & x \\
x & x & x & 1 & 0 & x & x \\
x & x & x & 2 & 1 & x & x
\end{array}$$

wherein x represents any one of the following: 0, 1, and 2, the first three columns of the second base matrix are an information part in the second base matrix, and a 4<sup>th</sup> column to a 7<sup>th</sup> column of the second base matrix are the check part in the second base matrix.

29. The apparatus according to claim 28, wherein the second base matrix comprises:

$$\begin{array}{ccccccc}
1 & 0 & 0 & 0 & 2 & 2 & 1 \\
2 & 0 & 1 & 2 & 0 & 0 & 0 \\
1 & 0 & 1 & 1 & 2 & 0 & 1 \\
2 & 1 & 0 & 1 & 0 & 0 & 0.
\end{array}$$

30. The apparatus according to claim 25, wherein the second base matrix comprises:

$$
\begin{array}{ccccccccc}
1 & 0 & x & x & x & x & x & x & x \\
2 & 0 & x & x & x & x & x & x & x \\
1 & 0 & x & x & x & x & x & x & x \\
2 & 1 & x & x & x & x & x & x & x
\end{array}
$$

wherein x represents any one of the following: 0, 1, and 2, the first four columns of the second base matrix are the check part in the second base matrix, and a 5$^{th}$ column to a 9$^{th}$ column of the second base matrix are an information part in the second base matrix; or
the second base matrix comprises:

$$
\begin{array}{ccccccccc}
x & x & x & x & x & 1 & 0 & x & x \\
x & x & x & x & x & 2 & 0 & x & x \\
x & x & x & x & x & 1 & 0 & x & x \\
x & x & x & x & x & 2 & 1 & x & x
\end{array}
$$

wherein x represents any one of the following: 0, 1, and 2, the first five columns of the second base matrix are an information part in the second base matrix, and a 6$^{th}$ column to a 9$^{th}$ column of the second base matrix are the check part in the second base matrix.

**31.** The apparatus according to claim 30, wherein the second base matrix comprises:

$$
\begin{array}{ccccccccc}
1 & 0 & 1 & 0 & 2 & 2 & 0 & 1 & 0 \\
2 & 0 & 0 & 1 & 1 & 0 & 1 & 0 & 2 \\
1 & 0 & 2 & 1 & 0 & 1 & 1 & 1 & 0 \\
2 & 1 & 0 & 1 & 0 & 0 & 0 & 1 & 0; \text{ or}
\end{array}
$$

the second base matrix comprises:

$$
\begin{array}{ccccccccc}
1 & 0 & 0 & 0 & 0 & 2 & 1 & 1 & 2 \\
2 & 0 & 2 & 1 & 2 & 1 & 1 & 1 & 1 \\
1 & 0 & 1 & 1 & 0 & 2 & 0 & 1 & 2 \\
2 & 1 & 0 & 0 & 0 & 0 & 0 & 0 & 0.
\end{array}
$$

**32.** The apparatus according to claim 31, wherein the check matrix comprises:

$$
\begin{array}{cccccccccccccccccc}
-1 & 21 & -1 & -1 & -1 & 27 & -1 & -1 & 39 & 15 & 26 & 30 & -1 & -1 & 6 & -1 & -1 & -1 \\
9 & -1 & -1 & -1 & 19 & -1 & -1 & -1 & 32 & 27 & 24 & 40 & -1 & -1 & -1 & 1 & -1 & -1 \\
35 & 38 & -1 & -1 & -1 & -1 & 39 & -1 & -1 & 14 & -1 & -1 & -1 & 16 & -1 & -1 & 20 & 6 \\
39 & 31 & -1 & -1 & -1 & -1 & -1 & 19 & 6 & -1 & -1 & -1 & 18 & -1 & -1 & -1 & 25 & 3 \\
13 & -1 & -1 & -1 & 31 & 26 & 35 & -1 & -1 & -1 & 35 & -1 & 2 & -1 & 23 & -1 & -1 & -1 \\
-1 & 12 & -1 & -1 & 39 & 37 & -1 & 10 & -1 & -1 & -1 & 39 & -1 & 33 & -1 & 27 & -1 & -1 \\
16 & 17 & 29 & -1 & -1 & -1 & -1 & 4 & -1 & -1 & -1 & -1 & -1 & -1 & 3 & -1 & -1 & -1 \\
10 & 38 & -1 & 21 & -1 & -1 & 38 & -1 & -1 & -1 & -1 & -1 & -1 & -1 & -1 & 18 & -1 & -1;
\end{array}
$$

or

the check matrix comprises:

$$\begin{matrix}
-1 & 11 & -1 & -1 & -1 & -1 & -1 & -1 & -1 & -1 & 37 & 37 & -1 & 18 & 0 & -1 & 38 & 15 \\
39 & -1 & -1 & -1 & -1 & -1 & -1 & -1 & -1 & -1 & 1 & 0 & 33 & -1 & -1 & 14 & 4 & 9 \\
11 & 7 & -1 & -1 & 18 & 31 & 3 & -1 & 30 & 13 & 25 & -1 & 30 & -1 & 0 & -1 & -1 & 10 \\
1 & 31 & -1 & -1 & 26 & 22 & -1 & 34 & 5 & 11 & -1 & 13 & -1 & 27 & -1 & 16 & 12 & -1 \\
-1 & 11 & -1 & -1 & -1 & 41 & 40 & -1 & -1 & -1 & 21 & 40 & -1 & -1 & 22 & -1 & 12 & 0 \\
15 & -1 & -1 & -1 & 10 & -1 & -1 & 4 & -1 & -1 & 10 & 4 & -1 & -1 & -1 & 31 & 15 & 28 \\
31 & 29 & 15 & -1 & -1 & -1 & -1 & -1 & -1 & -1 & -1 & -1 & -1 & -1 & -1 & -1 & -1 & -1 \\
1 & 36 & -1 & 18 & -1 & -1 & -1 & -1 & -1 & -1 & -1 & -1 & -1 & -1 & -1 & -1 & -1 & -1
\end{matrix}$$

wherein -1 represents a Z*Z all-zero matrix, 0 represents a Z*Z identity matrix, a non-zero element represents a Z*Z circulant permutation matrix, Z represents a lifting factor used when the first base matrix is expanded to obtain the check matrix, and Z=42.

33. The apparatus according to any one of claims 18 to 24, wherein when the sparsity of the first bit sequence is greater than the first threshold, the second base matrix is shown as follows:

$$\begin{bmatrix} A & B \\ C & D \end{bmatrix}$$

wherein A represents an information part in the second base matrix, B represents the check part in the second base matrix, C is a matrix determined based on a code rate and the sparsity of the first bit sequence, a 1st column in D is a punctured column, and a remaining part other than the 1st column in D is obtained based on the identity matrix.

34. The apparatus according to claim 33, wherein the 1st column in D is either of the following: $[1\,2\,1\,2\,...]^T$ and $[1\,1\,1\,1\,...]^T$.

35. A communication apparatus, comprising a processor, wherein the processor is configured to execute computer instructions, to perform the method according to any one of claims 1 and 3 to 17, or perform the method according to any one of claims 2 to 17.

36. A communication apparatus, comprising a processor and a memory, wherein

the processor is configured to store computer instructions; and
the processor is configured to execute the computer instructions, to perform the method according to any one of claims 1 and 3 to 17, or perform the method according to any one of claims 2 to 17.

37. A communication apparatus, comprising a processor and a transceiver, wherein

the transceiver is configured to receive a signal or send a signal; and
the processor is configured to perform the method according to any one of claims 1 and 3 to 17, or configured to perform the method according to any one of claims 2 to 17.

38. A communication apparatus, comprising a logic circuit and an interface, wherein the logic circuit is coupled to the interface, and
the interface is configured to input to-be-processed data, the logic circuit processes the to-be-processed data according to the method according to any one of claims 1 to 17, to obtain processed data, and the interface is configured to output the processed data.

39. A computer-readable storage medium, wherein the computer-readable storage medium is configured to store instructions, and when the instructions are executed, the method according to any one of claims 1 to 17 is performed.

40. A computer program product comprising instructions, wherein when the instructions are run on a computer, the method according to any one of claims 1 to 17 is performed.

41. A communication system, wherein the communication system comprises a transmitter and a receiver, the transmitter

## EP 4 564 685 A1

is configured to perform the method according to any one of claims 1 and 3 to 17, and the receiver is configured to perform the method according to any one of claims 2 to 17.

FIG. 1

FIG. 2

FIG. 3a

Mutual Information of Combined BSC & Gaussian Densities

FIG. 3b

EP 4 564 685 A1

```
┌─────┐        ┌──────────┐     ┌──────────┐   ┌──────────┐            ┌──────────┐    ┌──────────┐            ┌──────────┐   ┌──────────┐       ┌──────────┐
│  p  │───────▶│Dimensions│     │ Randomly │   │ Are C1 to│    Y       │Differential│  │ Are C1 to│    Y       │  Is a    │   Y   │Output a │
└─────┘        │   of a   │────▶│generate N│──▶│    C4    │───────────▶│ evolution │──▶│    C4    │───────────▶│ maximum  │──────▶│prototype│
               │prototype │     │prototypes│   │satisfied?│            │iteration to│  │satisfied?│            │quantity of│      └──────────┘
┌─────┐        │graph and │     └──────────┘   └──────────┘            │ improve a │   └──────────┘            │iterations │
│  R  │───────▶│S1 structure│                                          │ decoding  │                          │ reached?  │
└─────┘        └──────────┘                                            │ threshold │                          └──────────┘
```

FIG. 4a

FIG. 4b

FIG. 4c

FIG. 4d

$$\begin{bmatrix} 2 & 1 & 0 & 0 & 0 & | & 0 & 0 \\ 1 & 0 & x & x & x & | & x & x \\ 1 & 0 & x & x & x & | & x & x \\ 1 & 0 & x & xx & | & x & x \\ 2 & 0 & x & x & x & | & x & x \end{bmatrix}$$

Check part ⇕ Information part

$$\begin{bmatrix} 2 & 1 & 0 & 0 & 0 & | & 0 & 0 \\ 1 & 0 & 0 & 0 & 2 & | & 1 & 0 \\ 1 & 0 & 1 & 0 & 0 & | & 1 & 1 \\ 1 & 0 & 1 & 1 & 0 & | & 0 & 1 \\ 2 & 0 & 0 & 2 & 1 & | & 0 & 0 \end{bmatrix}$$

Fixed structure

Punctured PC-VN    A degree is 1PC-VN    Check VNs    Information VNs

FIG. 4e

Transmitter

Receiver

501 Obtain a first bit sequence, where the first bit sequence includes K information bits, and K is a positive integer

502 Perform LDPC encoding on the first bit sequence based on a check matrix, to obtain a second bit sequence, where the check matrix is obtained based on a first base matrix, the first base matrix corresponds to a second base matrix, the second bit sequence includes M check bits, and M is a positive integer

503 Second bit sequence

504 Perform LDPC decoding on the second bit sequence based on the check matrix, to obtain the K information bits

FIG. 5

FIG. 6a

Base Group B

| | | | |
|---|---|---|---|
| X | X | X | O |
| X | X | X | O |
| X | X | X | O |
| X | X | X | O |
| X | X | X | O |
| X | X | X | O |
| X | X | X | O |
| O | O | O | 1 |
| 1 | 2 | 1 | 2 |

D1

Thr=-3.7966 dB, Gap=1.5784 dB

Thr=-3.7644 dB, Gap=1.6107 dB

Thr=-3.7600 dB, Gap=1.6151 dB

D2

Thr=-3.9826 dB, Gap=1.3924 dB

Thr=-3.9404 dB, Gap=1.4347 dB

Thr=-3.9255 dB, Gap=1.4496 dB

D3

Thr=-4.0877 dB, Gap=1.2874 dB

Thr=-4.0766 dB, Gap=1.2985 dB

Thr=-4.0763 dB, Gap=1.2988 dB

FIG. 6b

01–th Hb Thr=−4.0954 dB, Gap=1.2797 dB

```
1   0   1   0 | 2   2   0   1   0
2   0   0   1 | 1   0   1   0   2
1   0   2   1 | 0   1   1   1   0
2   1   0   1 | 0   0   0   1   0
```

```
-1  21  -1  -1  -1  27  -1  -1  39  15  26  30  -1  -1   6  -1  -1  -1
 9  -1  -1  -1  19  -1  -1  -1  32  27  24  40  -1  -1  -1   1  -1  -1
35  38  -1  -1  -1  -1  39  -1  -1  14  -1  -1  -1  16  -1  -1  20   6
39  31  -1  -1  -1  -1  -1  19   6  -1  -1  -1  18  -1  -1  -1  25   3
13  -1  -1  -1  31  26  35  -1  -1  -1  35  -1   2  -1  23  -1  -1  -1
-1  12  -1  -1  39  37  -1  10  -1  -1  -1  39  -1  33  -1  27  -1  -1
16  17  29  -1  -1  -1  -1   4  -1  -1  -1  -1  -1  -1   3  -1  -1  -1
10  38  -1  21  -1  -1  38  -1  -1  -1  -1  -1  -1  -1  -1  18  -1  -1
```

FIG. 6c

05–th Hb Thr=–3.9493 dB, Gap=1.4258 dB

```
1   0   0   0   0   2   1   1   2
2   0   2   1   2   1   1   1   1
1   0   1   1   0   2   0   1   2
2   1   0   0   0   0   0   0   0
```

```
-1  11  -1  -1  -1  -1  -1  -1  -1  -1  37  37  -1  18   0  -1  38  15
39  -1  -1  -1  -1  -1  -1  -1  -1  -1   1   0  33  -1  -1  14   4   9
11   7  -1  -1  18  31   3  -1  30  13  25  -1  30  -1   0  -1  -1  10
 1  31  -1  -1  26  22  -1  34   5  11  -1  13  -1  27  -1  16  12  -1
-1  11  -1  -1  -1  41  40  -1  -1  -1  21  40  -1  -1  22  -1  12   0
15  -1  -1  -1  10  -1  -1   4  -1  -1  10   4  -1  -1  -1  31  15  28
31  29  15  -1  -1  -1  -1  -1  -1  -1  -1  -1  -1  -1  -1  -1  -1  -1
 1  36  -1  18  -1  -1  -1  -1  -1  -1  -1  -1  -1  -1  -1  -1  -1  -1
```

FIG. 6d

FIG. 6e

FIG. 6f

Base Group A

| D1 | Thr=−2.1717 dB, Gap=0.6779 dB | Thr=−2.1582 dB, Gap=0.6914 dB | Thr=−2.1309 dB, Gap=0.7187 dB |
| D2 | Thr=−2.2839 dB, Gap=0.5657 dB | Thr=−2.2266 dB, Gap=0.6230 dB | Thr=−2.2175 dB, Gap=0.6321 dB |
| D3 | Thr=−2.3655 dB, Gap=0.4841 dB | Thr=−2.3374 dB, Gap=0.5122 dB | Thr=−2.3288 dB, Gap=0.5208 dB |

FIG. 7a

EP 4 564 685 A1

Base Group B

Thr=−1.8808 dB, Gap=0.9688 dB     Thr=−1.8788 dB, Gap=0.9707 dB     Thr=−1.8489 dB, Gap=1.0007 dB

D1

Thr=−1.9647 dB, Gap=0.8849 dB     Thr=−1.9519 dB, Gap=0.8977 dB     Thr=−1.9371 dB, Gap=0.9125 dB

D2

Thr=−2.0954 dB, Gap=0.7542 dB     Thr=−2.0621 dB, Gap=0.7875 dB     Thr=−2.0489 dB, Gap=0.8006 dB

D3

FIG. 7b

29–th Hb Thr=–2.0681 dB, Gap=0.7815 dB

$$\begin{bmatrix} 1 & 0 & 1 & 2 \\ 2 & 0 & 1 & 0 \\ 1 & 0 & 0 & 1 \\ 2 & 1 & 0 & 1 \end{bmatrix}\quad\begin{matrix} 1 & 0 & 1 \\ 0 & 1 & 1 \\ 2 & 1 & 0 \\ 0 & 0 & 0 \end{matrix}$$

| 46 | –1 | –1 | –1 | –1 | 44 | 52 | 51 | 4 | –1 | –1 | –1 | 49 | –1 |
|----|----|----|----|----|----|----|----|----|----|----|----|----|----|
| –1 | 35 | –1 | –1 | 12 | –1 | 53 | 47 | –1 | 50 | –1 | –1 | –1 | 7 |
| 46 | 46 | –1 | –1 | –1 | 15 | –1 | –1 | –1 | –1 | 17 | –1 | –1 | 4 |
| 41 | 21 | –1 | –1 | 53 | –1 | –1 | –1 | –1 | –1 | –1 | 21 | 7 | –1 |
| –1 | 43 | –1 | –1 | –1 | –1 | –1 | 18 | 39 | 42 | –1 | 26 | –1 | –1 |
| 25 | –1 | –1 | –1 | –1 | –1 | 48 | –1 | 33 | 9 | 9 | –1 | –1 | –1 |
| 45 | 10 | –1 | 40 | –1 | –1 | 52 | –1 | –1 | –1 | –1 | –1 | –1 | –1 |
| 53 | 37 | 43 | –1 | –1 | –1 | –1 | 4 | –1 | –1 | –1 | –1 | –1 | –1 |

FIG. 7c

22–th Hb Thr=–1.7691 dB, Gap=1.0804 dB

$$\begin{bmatrix} 1 & 0 & 1 & 2 \\ 2 & 0 & 1 & 0 \\ 1 & 0 & 0 & 1 \\ 2 & 1 & 0 & 0 \end{bmatrix}\quad\begin{matrix} 1 & 0 & 1 \\ 0 & 2 & 1 \\ 2 & 0 & 1 \\ 0 & 0 & 0 \end{matrix}$$

| 27 | –1 | –1 | –1 | 34 | –1 | 38 | 5 | 41 | –1 | –1 | –1 | –1 | 33 |
|----|----|----|----|----|----|----|----|----|----|----|----|----|----|
| –1 | 14 | –1 | –1 | –1 | 9 | 12 | 0 | –1 | 16 | –1 | –1 | 9 | –1 |
| 2 | 43 | –1 | –1 | –1 | 25 | –1 | –1 | –1 | –1 | 13 | 24 | –1 | 30 |
| 5 | 29 | –1 | –1 | 43 | –1 | –1 | –1 | –1 | –1 | 52 | 8 | 30 | –1 |
| –1 | 5 | –1 | –1 | –1 | –1 | –1 | 10 | 52 | 23 | –1 | –1 | 14 | –1 |
| 7 | –1 | –1 | –1 | –1 | –1 | 15 | –1 | 5 | 9 | –1 | –1 | –1 | 29 |
| 7 | 24 | 14 | –1 | –1 | –1 | –1 | –1 | –1 | –1 | –1 | –1 | –1 | –1 |
| 13 | 15 | –1 | 41 | –1 | –1 | –1 | –1 | –1 | –1 | –1 | –1 | –1 | –1 |

FIG. 7d

FIG. 7e

FIG. 7f

Thr=-0.0868 dB, Gap=0.5694 dB

Thr=-0.1232 dB, Gap=0.5331 dB

Thr=-0.1356 dB, Gap=0.5206 dB

Thr=-0.1026 dB, Gap=0.5536 dB

Thr=-0.1356 dB, Gap=0.5206 dB

Thr=-0.1386 dB, Gap=0.5177 dB

Thr=-0.1232 dB, Gap=0.5331 dB

Thr=-0.1458 dB, Gap=0.5104 dB

Thr=-0.1444 dB, Gap=0.5118 dB

D1

D2

D3

FIG. 8a

24–th Hb Thr=0.1760 dB, Gap=0.8322 dB

```
┌                   ┐
┆ 1  0  1  2  0 ┆ 0  0
┆ 1  0  2  0  0 ┆ 1  0
┆ 1  0  0  1  1 ┆ 0  1
┆ 2  0  0  0  1 ┆ 1  1
┆ 2  1  0  0  0 ┆ 0  0
└                   ┘
```

```
-1  38  -1  -1  -1  11  10   9  -1  -1  -1  -1  -1  -1
18  -1  -1  -1  35  -1   8  33  -1  -1  -1  -1  -1  -1
 0  -1  -1  -1  15  36  -1  -1  -1  -1   4  -1  -1  -1
-1  46  -1  -1  29  17  -1  -1  -1  -1  -1  19  -1  -1
-1  17  -1  -1  -1  -1  -1   3   4  -1  -1  -1  -1  44
 3  -1  -1  -1  -1  -1  11  -1  -1  32  -1  -1  24  -1
31  24  -1  -1  -1  -1  -1  -1  -1   5  -1  16  -1  27
33  55  -1  -1  -1  -1  -1  -1  28  -1  26  -1  22  -1
 7   9  -1  43  -1  -1  -1  -1  -1  -1  -1  -1  -1  -1
49   7  49  -1  -1  -1  -1  -1  -1  -1  -1  -1  -1  -1
```

FIG. 8b

28–th Hb Thr=–0.0614 dB, Gap=0.5948 dB

```
1   0   1   0   0   1   0
1   0   0   1   1   0   1
1   0   1   0   1   1   0
2   0   2   1   0   0   1
2   1   0   0   0   0   0
```

| 41 | –1 | –1 | –1 | 52 | –1 | –1 | –1 | –1 | –1 | –1 | 17 | –1 | –1 |
|----|----|----|----|----|----|----|----|----|----|----|----|----|----|
| –1 | 43 | –1 | –1 | –1 | 46 | –1 | –1 | –1 | –1 | 16 | –1 | –1 | –1 |
| –1 | 49 | –1 | –1 | –1 | –1 | 13 | –1 | 11 | –1 | –1 | –1 | 0 | –1 |
| 37 | –1 | –1 | –1 | –1 | –1 | –1 | 45 | –1 | 32 | –1 | –1 | –1 | 15 |
| 20 | –1 | –1 | –1 | –1 | 32 | –1 | –1 | 14 | –1 | –1 | 29 | –1 | –1 |
| –1 | 40 | –1 | –1 | 38 | –1 | –1 | –1 | –1 | 33 | 30 | –1 | –1 | –1 |
| 43 | 48 | –1 | –1 | 2 | 45 | 47 | –1 | –1 | –1 | –1 | –1 | –1 | 5 |
| 25 | 39 | –1 | –1 | 21 | 44 | –1 | 11 | –1 | –1 | –1 | –1 | 19 | –1 |
| 43 | 39 | –1 | 18 | –1 | –1 | –1 | –1 | –1 | –1 | –1 | –1 | –1 | –1 |
| 32 | 55 | 36 | –1 | –1 | –1 | –1 | –1 | –1 | –1 | –1 | –1 | –1 | –1 |

FIG. 8c

FIG. 8d

FIG. 9a

FIG. 9b

$P_1$=0.3, AWGN

FIG. 9c

1001

Processing unit

1002

Transceiver unit

Communication
apparatus

FIG. 10

110

1110

Transceiver

1120

Processor

1140

1130

Memory

FIG. 11

Chip

1201

Logic circuit

1202

Interface

FIG. 12

## INTERNATIONAL SEARCH REPORT

International application No.

**PCT/CN2022/113749**

### A. CLASSIFICATION OF SUBJECT MATTER

H03M13/11(2006.01)i

According to International Patent Classification (IPC) or to both national classification and IPC

### B. FIELDS SEARCHED

Minimum documentation searched (classification system followed by classification symbols)

H03M

Documentation searched other than minimum documentation to the extent that such documents are included in the fields searched

Electronic data base consulted during the international search (name of data base and, where practicable, search terms used)

CNKI, CNTXT, ENTXT, DWPI, IEEE: 编码, 译码, 解码, 信源信道联合编码, 联合信源信道编码, 低密度奇偶校验, 矩阵, 0, 1, 2, 元素, 行, 列, 第一, 第二, encode, decode, JSCC, joint source-channel coding, low-density parity-check, LDPC, matrix, element, zero, one, two, row, column, first, second

### C. DOCUMENTS CONSIDERED TO BE RELEVANT

| Category* | Citation of document, with indication, where appropriate, of the relevant passages | Relevant to claim No. |
|---|---|---|
| A | CN 109150194 A (HUAWEI TECHNOLOGIES CO., LTD.) 04 January 2019 (2019-01-04) claim 1 | 1-41 |
| A | WO 2017119922 A1 (INTEL IP CORP.) 13 July 2017 (2017-07-13) entire document | 1-41 |
| A | CN 111030783 A (HUAQIAO UNIVERSITY) 17 April 2020 (2020-04-17) entire document | 1-41 |
| A | CN 112583419 A (HUAWEI TECHNOLOGIES CO., LTD.) 30 March 2021 (2021-03-30) entire document | 1-41 |
| A | CN 106341138 A (XIAMEN UNIVERSITY) 18 January 2017 (2017-01-18) entire document | 1-41 |
| A | CN 113078911 A (HUAWEI TECHNOLOGIES CO., LTD.) 06 July 2021 (2021-07-06) entire document | 1-41 |

☐ Further documents are listed in the continuation of Box C.    ☑ See patent family annex.

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **13 March 2023** | **22 March 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| Facsimile No. **(86-10)62019451** | Telephone No. |

Form PCT/ISA/210 (second sheet) (July 2022)

## INTERNATIONAL SEARCH REPORT
### Information on patent family members

International application No.

**PCT/CN2022/113749**

| Patent document cited in search report | | | Publication date (day/month/year) | Patent family member(s) | | | Publication date (day/month/year) |
|---|---|---|---|---|---|---|---|
| CN | 109150194 | A | 04 January 2019 | None | | | |
| WO | 2017119922 | A1 | 13 July 2017 | HK | 1258269 | A1 | 08 November 2019 |
|  |  |  |  | TW | 201725868 | A | 16 July 2017 |
| CN | 111030783 | A | 17 April 2020 | None | | | |
| CN | 112583419 | A | 30 March 2021 | None | | | |
| CN | 106341138 | A | 18 January 2017 | None | | | |
| CN | 113078911 | A | 06 July 2021 | None | | | |

Form PCT/ISA/210 (patent family annex) (July 2022)